# EUROPEAN PATENT APPLICATION

(11) **EP 4 517 869 A1**
(43) Date of publication of application: **05.03.2025**
(21) Application number: 22950713.2
(22) Date of filing: 15.07.2022
(51) Int. Cl.: H01M 4/36, H01M 4/58

(54) **POSITIVE ELECTRODE ACTIVE MATERIAL AND PREPARATION METHOD THEREFOR, POSITIVE ELECTRODE PLATE, SECONDARY BATTERY, BATTERY MODULE, BATTERY PACK AND ELECTRIC DEVICE**

(71) Applicant: Contemporary Amperex Technology (Hong Kong) Limited, Hong Kong (HK)
(72) Inventor: XU, Xiaofu, Ningde, Fujian 352100 (CN); JIANG, Yao, Ningde, Fujian 352100 (CN); LIU, Qian, Ningde, Fujian 352100 (CN); YE, Yonghuang, Ningde, Fujian 352100 (CN)
(74) Representative: Gong, Jinping
(86) International application number: PCT/CN2022/106000
(87) International publication number: WO 2024/011595

(57) **Abstract**

This application provides a positive electrode active material and a preparation method thereof, a positive electrode plate, a secondary battery, a battery module, a battery pack, and an electric apparatus. The positive electrode active material contains a first positive electrode active material and a second positive electrode active material. The first positive electrode active material contains a compound LiNi_{g}Co_{d}MnₑM'_{f}O₂. The second positive electrode active material includes a core, a first coating layer enveloping the core, a second coating layer enveloping the first coating layer, and a third coating layer enveloping the second coating layer. The core contains a compound Li₁₊ₓMn_{1-y}A_{y}P_{1-z}R_{z}O₄, the first coating layer contains a crystalline pyrophosphate, the second coating layer contains a crystalline phosphate, and the third coating layer contains carbon. In this application, the mixed use of the first positive electrode active material and the second positive electrode active material increases cycling capacity retention rate of the secondary battery, prolongs cycle life of the secondary battery, and improves safety of the secondary battery.

## Description

### TECHNICAL FIELD

This application relates to the field of secondary battery technologies, and in particular, to a positive electrode active material and a preparation method thereof, a positive electrode plate, a secondary battery, a battery module, a battery pack, and an electric apparatus.

### BACKGROUND

In recent years, with increasingly wide use of secondary batteries, secondary batteries have been widely used in energy storage power supply systems such as hydroelectric, thermal, wind, and solar power plants, and many other fields including electric tools, electric bicycles, electric motorcycles, electric vehicles, military equipment, and aerospace. Along with the great development of secondary batteries, higher requirements are imposed on their energy density, cycling performance, safety performance, and the like. Lithium manganese phosphate, as an existing positive electrode active material for secondary batteries, is prone to Li/Mn antisite defects and large dissolution amount of manganese during charge and discharge, which affects gram capacity of the secondary batteries and leads to deterioration of the safety performance and cycling performance of the secondary batteries.

### SUMMARY

This application has been made in view of the foregoing issues, with an objective to provide a positive electrode active material, a preparation method of positive electrode active material, a positive electrode plate, a secondary battery, a battery module, a battery pack, and an electric apparatus, so as to solve the problems of low cycling capacity retention rate, short cycle life, and poor safety of a secondary battery prepared using an existing positive electrode active material.

To achieve the above objective, a first aspect of this application provides a positive electrode active material containing a first positive electrode active material and a second positive electrode active material; where
the first positive electrode active material contains a compound LiNi_{g}Co_{d}MnₑM'_{f}O₂, where g is selected from a range of 0.314 to 0.970, d is selected from a range of 0 to 0.320, optionally from a range of 0.047 to 0.320, e is selected from a range of 0.006 to 0.390, a sum of g, d, e, and f is 1 and f is greater than 0, and M' is one or more elements selected from Mn, Al, Mg, Ca, Na, Ti, W, Zr, Sr, Cr, Zn, Ba, B, S, and Y, and optionally, M' is Mg and/or Al; and
the second positive electrode active material includes a core and a shell enveloping the core, the shell including a first coating layer enveloping the core, a second coating layer enveloping the first coating layer, and a third coating layer enveloping the second coating layer; where the core contains a compound Li₁₊ₓMn_{1-y}A_{y}P_{1-z}R_{z}O₄, the first coating layer contains a crystalline pyrophosphate LiₐMP₂O₇ and/or M_{b}(P₂O₇)_{c}, the second coating layer contains a crystalline phosphate XₙPO₄, and the third coating layer contains carbon, where x is selected from a range of -0.100 to 0.100, y is selected from a range of 0.001 to 0.909, optionally from a range of 0.001 to 0.600, z is selected from a range of 0.001 to 0.100, a is greater than 0 and less than or equal to 2, b is greater than 0 and less than or equal to 4, c is greater than 0 and less than or equal to 3, n is greater than 0 and less than or equal to 3, A is one or more elements selected from Zn, Al, Na, K, Mg, Mo, W, Ti, V, Zr, Fe, Ni, Co, Ga, Sn, Sb, Nb, and Ge, optionally one or more elements selected from Fe, V, Ni, and Co, R is one or more elements selected from B (boron), Si, N, and S, optionally one or more elements selected from Si, N, and S, each M in the crystalline pyrophosphates LiₐMP₂O₇ and M_{b}(P₂O₇)_{c} is independently one or more elements selected from Fe, Ni, Mg, Co, Cu, Zn, Ti, Ag, Zr, Nb, and Al, optionally one or more elements selected from Fe, Co, Ti, and Al, and X is one or more elements selected from Li, Fe, Ni, Mg, Co, Cu, Zn, Ti, Ag, Zr, Nb, and Al, optionally one or more elements selected from Li, Fe, Ag, and Al.

Based on this, the applicant has surprisingly found that: with a second positive electrode active material obtained by doping a specific amount of a specific element at both Mn and P sites of the compound LiMnPO₄, and applying three layers of coating on surface of the compound, dissolution amount of manganese can be significantly reduced, the lattice change rate can be decreased, and therefore applying such second positive electrode active material to a secondary battery can significantly improve high-temperature cycling performance, cycling stability, high-temperature storage performance, rate performance, and safety performance of the secondary battery and increase capacity of the secondary battery. However, the second positive electrode active material has only one-dimensional lithium ion transport channels, while the first positive electrode active material is layered transition metal oxide and has two-dimensional lithium ion transport channels. Therefore, in this application, the mixed use of the first positive electrode active material and the second positive electrode active material, with complementarity achieved for the two materials, increases cycling capacity retention rate of the secondary battery, prolongs cycle life of the secondary battery, and improves safety of the secondary battery.

Unless otherwise specified, in the chemical formula Li₁₊ₓMn_{1-y}A_{y}P_{1-z}R_{z}O₄, when A is two or more elements, the foregoing limitation on the value range of y is not only a limitation on the stoichiometric number of each element as A but also a limitation on a sum of stoichiometric numbers of all the elements as A. For example, when A is two or more elements A1, A2, ..., and An, the stoichiometric numbers y1, y2, ..., and yn of all of A1, A2, ..., and An are each required to fall within the value range defined by this application for y, and a sum of y1, y2, ..., and yn are also required to fall within this value range. Similarly, in a case that R is two or more elements, the limitation on the value range of the stoichiometric number of R in this application also has the foregoing meaning. Similarly, in a case that M' in the chemical formula LiNi_{g}Co_{d}MnₑM'_{f}O₂ is two or more elements, the limitation on the value range of the stoichiometric number of M' in this application also has the foregoing meaning.

In this specification, the crystalline means that the crystallinity is above 50%, to be specific, being 50% to 100%. A crystallinity less than 50% is referred to as a glassy state. The crystalline pyrophosphate and crystalline phosphate in this application have a crystallinity of 50% to 100%. The pyrophosphate and phosphate with a certain crystallinity not only help to give full play to the ability of the pyrophosphate coating layer in hindering the manganese dissolution and the ability of the phosphate coating layer in conducting lithium ions, reducing interfacial side reactions, but also enable the pyrophosphate coating layer and the phosphate coating layer to be better lattice matched, such that a tight bond between the coating layers can be achieved.

In any embodiment, mass of the first positive electrode active material is m₁, mass of the second positive electrode active material is m₂, and a value of m₁/(m₁+m₂) is 2% to 55%, optionally 3% to 50%. With the mass percentage of the first positive electrode active material in the two positive electrode active materials within the above range, the stability and safety of the positive electrode active material as a whole can be improved.

In any embodiment, a value of g×m₁/(m₁+m₂) is 0.017 to 0.457, optionally 0.025 to 0.415. This can further improve the stability and safety of the positive electrode active material as a whole.

In any embodiment, the first positive electrode active material is a single crystal or quasi-single crystal material, and a particle size Dᵥ50 of the first positive electrode active material is less than or equal to 5.8 µm, optionally from 2.3 µm to 5.8 µm, and more optionally from 2.3 µm to 4.3 µm.

Making the particle size of the single crystal or quasi-single crystal first positive electrode active material fall within the above range can optimize an electrochemical reaction area, further reduce and suppress the interfacial side reactions on the positive electrode during cycling of the secondary battery, reduce the cycling attenuation rate of the secondary battery, and prolong the cycle life of the secondary battery.

In any embodiment, when the first positive electrode active material is a single crystal or quasi-single crystal material, d is selected from a range of 0.047 to 0.320, optionally from a range of 0.047 to 0.235; and/or
b is greater than 0.314 and less than 0.97, optionally selected from a range of 0.55 to 0.869.

When the first positive electrode active material is a single crystal or quasi-single crystal material, d and b falling within the above ranges is conducive to further improving the conductivity and rate performance of the positive electrode active material, further increasing the cycling capacity retention rate of the secondary battery, and further prolonging the cycle life of the secondary battery.

In any embodiment, the first positive electrode active material is a polycrystal material, and a particle size Dᵥ50 of the first positive electrode active material is 3.0 µm to 13.5 µm, optionally 3.5 µm to 13.5 µm;
a BET specific surface area of the first positive electrode active material is less than or equal to 1.73 m²/g, optionally less than or equal to 1.32 m²/g, and more optionally from 0.28 m²/g to 1.32 m²/g; and/or
a compacted density under pressure of 3T of the first positive electrode active material is greater than or equal to 2.90 g/cm³, optionally greater than or equal to 2.92 g/cm³, and more optionally from 2.92 g/cm³ to 3.31 g/cm³.

Making the particle size, specific surface area, and compacted density of the polycrystal first positive electrode active material fall within the above ranges can further improve the rate performance of the positive electrode active material, further reduce and suppress the interfacial side reactions on the positive electrode during cycling of the secondary battery, reduce the cycling attenuation rate of the secondary battery, and prolong the cycle life of the secondary battery.

In any embodiment, the first positive electrode active material further contains lithium carbonate and/or lithium hydroxide; and
optionally, based on mass of the first positive electrode active material, a mass percentage of the lithium carbonate is less than or equal to 1.05%, optionally less than or equal to 1%, and/or a mass percentage of the lithium hydroxide is less than or equal to 1.02%, optionally less than or equal to 1%.

The residual water molecules brought in by the second positive electrode active material may react with the electrolyte to generate HF, and HF is prone to damage the positive electrode active material itself or the SEI film on the negative electrode plate, which in turn affects service life of the secondary battery. The lithium carbonate and/or lithium hydroxide further contained in the first positive electrode active material of this application can neutralize with HF, reducing or suppressing the damage of HF on the positive electrode active material or the SEI film on the negative electrode plate, thereby further prolonging the cycle life of the secondary battery.

In any embodiment, in the second positive electrode active material, the crystalline pyrophosphate in the first coating layer has an interplanar spacing in a range of 0.293 nm to 0.470 nm, optionally 0.303 nm to 0.462 nm, and an included angle in a range of 18.00° to 32.00°, optionally 19.211° to 30.846°, in the [111] crystal orientation; and/or
the crystalline phosphate in the second coating layer has an interplanar spacing in a range of 0.244 nm to 0.425 nm and an included angle in a range of 20.00° to 37.00°, optionally 20.885° to 36.808°, in the [111] crystal orientation.

Both the first coating layer and the second coating layer in the second positive electrode active material of this application use crystalline substances whose interplanar spacing and included angle range are within the foregoing ranges. In this way, the heterophase structures in the coating layer can be effectively avoided, thereby increasing the gram capacity of the material and improving the cycling performance and rate performance of the secondary battery.

In any embodiment, a ratio of y to 1-y in the core of the second positive electrode active material is 1:10 to 10:1, optionally 1:4 to 1:1. Herein, y denotes the sum of the stoichiometric numbers of elements doping at the Mn site. The energy density, cycling performance, and rate performance of the secondary battery can be further improved when the preceding conditions are met.

In any embodiment, a ratio of z to 1-z in the core of the second positive electrode active material is 1:999 to 1:9, optionally 1:499 to 1:249. Herein, z denotes the sum of the stoichiometric numbers of elements doping at the P site. The energy density, cycling performance, and rate performance of the secondary battery can be further improved when the preceding conditions are met.

In any embodiment, in the second positive electrode active material, carbon in the third coating layer is a mixture of SP2 carbon and SP3 carbon; and
optionally, a molar ratio of SP2 carbon to SP3 carbon is 0.1 to 10, and more optionally 2.0 to 3.0.

In this application, the comprehensive performance of the secondary battery is improved by limiting the molar ratio of SP2 carbon to SP3 carbon to the foregoing range.

In any embodiment, in the second positive electrode active material, based on weight of the core, an application amount of the first coating layer is greater than 0 and less than or equal to 6wt%, optionally greater than 0 and less than or equal to 5.5wt%, and more optionally greater than 0 and less than or equal to 2wt%;
based on the weight of the core, an application amount of the second coating layer is greater than 0 and less than or equal to 6wt%, optionally greater than 0 and less than or equal to 5.5wt%, and more optionally from 2wt% to 4wt%; and/or
based on the weight of the core, an application amount of the third coating layer is greater than 0 and less than or equal to 6wt%, optionally greater than 0 and less than or equal to 5.5wt%, and more optionally greater than 0 and less than or equal to 2wt%.

In the second positive electrode active material having a core-shell structure of this application, the application amounts of the three coating layers are preferably within the foregoing ranges, and therefore the core can be fully enveloped and the kinetic performance and safety performance of the secondary battery can be further improved without reducing the gram capacity of the second positive electrode active material.

In any embodiment, in the second positive electrode active material, thickness of the first coating layer is 1 nm to 10 nm;
thickness of the second coating layer is 2 nm to 15 nm, optionally 2.5 nm to 7.5 nm; and/or
thickness of the third coating layer is 2 nm to 25 nm.

In this application, the thickness of the first coating layer falling within the range of 1 nm to 10 nm can avoid a possible unfavorable effect, caused by excessive thickness, on the kinetic performance of the material; and it can avoid the problem that the migration of the transition metal ions cannot be hindered effectively in a case of an excessively thin coating layer. The thickness of the second coating layer falling within the foregoing range allows the second coating layer to have a stable surface structure and fewer side reactions with the electrolyte, thus more effectively mitigating the interfacial side reactions, further improving the high-temperature performance of the secondary battery. The thickness of the third coating layer falling within the range of 2 nm to 25 nm can further improve the electrical conductivity of the material and improve the compacted density performance of the battery electrode plates prepared using the second positive electrode active material.

In any embodiment, based on weight of the second positive electrode active material, a percentage of element manganese is in a range of 10wt% to 35wt%, optionally in a range of 15wt% to 30wt%, and more optionally in a range of 17wt% to 20wt%;
a percentage of element phosphorus is in a range of 12wt% to 25wt%, optionally in a range of 15wt% to 20wt%; and/or
a weight ratio of element manganese to element phosphorus is in a range of 0.90 to 1.25, optionally 0.95 to 1.20.

In the second positive electrode active material having a core-shell structure of this application, the percentage of element manganese falling within the foregoing range can effectively avoid problems such as deterioration of the stability of the material structure and decrease in density that may be caused by excessively high percentage of element manganese, thereby improving the performance of the secondary battery in terms of cycling, storage, compacted density, and so on; and it can avoid problems such as low voltage plateau that may be caused by excessively low percentage of element manganese, thereby improving the energy density of the secondary battery.

In the second positive electrode active material having a core-shell structure of this application, the percentage of element phosphorus falling within the foregoing range can effectively avoid the following cases: excessively high percentage of element phosphorus may lead to such strong covalency of P-O that the conductivity of small polarons is affected, thus affecting the electrical conductivity of the material; and excessively low percentage of element phosphorus may lead to decreased stability of the lattice structure of the core, pyrophosphate in the first coating layer, and/or phosphate in the second coating layer, thereby affecting the overall stability of the material.

In the second positive electrode active material having a core-shell structure of this application, the weight ratio of element manganese to element phosphorus falling within the foregoing range can effectively avoid the following cases: excessively large weight ratio may lead to an increase in the dissolution of the transition metal, affecting the stability of the material and the cycling and storage performance of the secondary battery; and excessively small weight ratio may lead to a decrease in the discharge voltage plateau of the material, thereby reducing the energy density of the secondary battery.

In any embodiment, a lattice change rate of the second positive electrode active material before and after complete deintercalation or intercalation of lithium is below 4%, optionally below 3.8%, and more optionally from 2.0% to 3.8%.

The second positive electrode active material having a core-shell structure of this application can achieve a lattice change rate below 4% before and after deintercalation or intercalation of lithium. Therefore, the use of the second positive electrode active material can improve the gram capacity and rate performance of the secondary battery.

In any embodiment, a Li/Mn antisite defect concentration of the second positive electrode active material is below 4%, optionally below 2.2%, and more optionally from 1.5% to 2.2%. The Li/Mn antisite defect concentration falling within the foregoing range can prevent Mn²⁺ from hindering the transport of Li⁺ and improve the gram capacity of the second positive electrode active material and rate performance of the secondary battery.

In any embodiment, a compacted density under 3T of the second positive electrode active material is above 2.2 g/cm³, optionally above 2.2 g/cm³ and below 2.8 g/cm³. Higher compacted density of the second positive electrode active material, that is, larger weight of the active substance per unit volume, is more conducive to increasing the volumetric energy density of the secondary battery.

In any embodiment, a surface oxygen valence of the second positive electrode active material is below -1.90, optionally from -1.90 to -1.98. This is because higher valence of oxygen in the compound indicates stronger electron gaining ability, that is, stronger oxidation. Therefore, limiting the surface oxygen valence of the first positive electrode active material within the foregoing range can mitigate the interfacial side reactions between the first positive electrode material and the electrolyte, thereby improving the performance of the cell in terms of cycling, high temperature storage, and the like and suppressing gas production.

A second aspect of this application further provides a preparation method of positive electrode active material including the following steps:
providing a first positive electrode active material and a second positive electrode active material; and
mixing the first positive electrode active material and the second positive electrode active material; where
the first positive electrode active material contains a compound LiNi_{g}Co_{d}MnₑM'_{f}O₂, and the second positive electrode active material includes a core and a shell enveloping the core, the shell including a first coating layer enveloping the core, a second coating layer enveloping the first coating layer, and a third coating layer enveloping the second coating layer; where the core contains a compound Li₁₊ₓMn_{1-y}A_{y}P_{1-z}R_{z}O₄, the first coating layer contains a crystalline pyrophosphate LiₐMP₂O₇ and/or M_{b}(P₂O₇)_{c}, the second coating layer contains a crystalline phosphate XₙPO₄, and the third coating layer contains carbon; and g, d, e, f, x, y, z, a, b, c, n, A, R, M, X, and M' are defined as in the first aspect of this application; and
optionally, the first positive electrode active material further contains lithium carbonate and/or lithium hydroxide.

Based on this, in this application, the mixed use of the first positive electrode active material and the second positive electrode active material, with complementarity achieved for the two materials, increases cycling capacity retention rate of a secondary battery, prolongs cycle life of the secondary battery, and improves safety of the secondary battery.

A third aspect of this application provides a positive electrode plate including a positive electrode current collector and a positive electrode film layer provided on at least one surface of the positive electrode current collector, where the positive electrode film layer includes the positive electrode active material according to the first aspect of this application or a positive electrode active material prepared in the method according to the second aspect of this application; and optionally, based on total weight of the positive electrode film layer, a percentage of the positive electrode active material in the positive electrode film layer is above 10wt%, more optionally from 95wt% to 99.5wt%.

A fourth aspect of this application provides a secondary battery including the positive electrode active material according to the first aspect of this application or a positive electrode active material prepared in the preparation method according to the second aspect of this application or the negative electrode plate according to the third aspect of this application.

A fifth aspect of this application provides a battery module including the secondary battery according to the fourth aspect of this application.

A sixth aspect of this application provides a battery pack including the battery module according to the fifth aspect of this application.

A seventh aspect of this application provides an electric apparatus including at least one of the secondary battery according to the fourth aspect of this application, the battery module according to the fifth aspect of this application, or the battery pack according to the sixth aspect of this application.

### BRIEF DESCRIPTION OF DRAWINGS

FIG. 1 is a schematic diagram of a second positive electrode active material having a core-shell structure according to an embodiment of this application.
FIG. 2 is a schematic diagram of a secondary battery according to an embodiment of this application.
FIG. 3 is an exploded view of the secondary battery according to the embodiment of this application in FIG. 2.
FIG. 4 is a schematic diagram of a battery module according to an embodiment of this application.
FIG. 5 is a schematic diagram of a battery pack according to an embodiment of this application.
FIG. 6 is an exploded view of the battery pack according to the embodiment of this application in FIG. 5.
FIG. 7 is a schematic diagram of an electric apparatus using a secondary battery as a power source according to an embodiment of this application.

### Description of reference signs:

1. battery pack; 2. upper box body; 3. lower box body; 4. battery module; 5. secondary battery; 51. housing; 52. electrode assembly; and 53. top cover assembly.

### DESCRIPTION OF EMBODIMENTS

The following specifically discloses embodiments of the positive electrode active material, preparation method of positive electrode active material, positive electrode plate, secondary battery, battery module, battery pack, and electric apparatus of this application with appropriate reference to the accompanying drawings. However, there may be cases where unnecessary detailed descriptions are omitted. For example, detailed descriptions of well-known matters and repeated descriptions of actually identical structures have been omitted. This is to avoid unnecessarily prolonging the following description, for ease of understanding by persons skilled in the art. In addition, the accompanying drawings and the following descriptions are provided for persons skilled in the art to fully understand this application and are not intended to limit the subject matter recorded in the claims.

"Ranges" disclosed in this application are defined in the form of lower and upper limits. A given range is defined by one lower limit and one upper limit selected, where the selected lower and upper limits define boundaries of that particular range. Ranges defined in this method may or may not include end values, and any combinations may be used, meaning any lower limit may be combined with any upper limit to form a range. For example, if ranges of 60-120 and 80-110 are provided for a specific parameter, it is understood that ranges of 60-110 and 80-120 can also be envisioned. In addition, if minimum values of a range are given as 1 and 2, and maximum values of the range are given as 3, 4, and 5, the following ranges can all be envisioned: 1-3, 1-4, 1-5, 2-3, 2-4, and 2-5. In this application, unless otherwise stated, a value range of "a-b" is a short representation of any combination of real numbers between a and b, where both a and b are real numbers. For example, a value range of "0-5" means that all real numbers in the range of "0-5" are listed herein, and "0-5" is just a short representation of a combination of these values. In addition, a parameter expressed as an integer greater than or equal to 2 is equivalent to disclosure that the parameter is, for example, an integer among 2, 3, 4, 5, 6, 7, 8, 9, 10, 11, 12, and so on.

Unless otherwise specified, all the embodiments and optional embodiments of this application can be combined with each other to form new technical solutions.

Unless otherwise specified, all the technical features and optional technical features of this application can be combined with each other to form new technical solutions.

Unless otherwise specified, all the steps in this application can be performed in the order described or in random order, preferably, in the order described. For example, a method including steps (a) and (b) indicates that the method may include steps (a) and (b) performed in order or may include steps (b) and (a) performed in order. For example, the foregoing method may further include step (c), which indicates that step (c) may be added to the method in any ordinal position, for example, the method may include steps (a), (b), and (c), steps (a), (c), and (b), steps (c), (a), and (b), or the like.

Unless otherwise specified, "include" and "contain" mentioned in this application are inclusive or may be exclusive. For example, the terms "include" and "contain" can mean that other unlisted components may also be included or contained, or only listed components are included or contained.

Unless otherwise specified, in this application, the term "or" is inclusive. For example, the phrase "A or B" means "A, B, or both A and B". More specifically, any one of the following conditions satisfies the condition "A or B": A is true (or present) and B is false (or not present); A is false (or not present) and B is true (or present); or both A and B are true (or present).

Unless otherwise specified, in this application, the median particle size Dᵥ50 is a corresponding particle size when a cumulative volume distribution percentage of the positive electrode active material reaches 50%. In this application, the median particle size Dᵥ50 of the positive electrode active material may be determined in a laser diffraction particle size analyzing method. For example, according to the standard GB/T 19077-2016, a laser particle size analyzer (for example, Malvern Master Size 3000) is used.

Unless otherwise specified, in this application, the term "coating layer" refers to a substance layer enveloping the core, the substance layer can completely or partially envelope the core, and the use of "coating layer" is only for ease of description but not intended to limit the present invention. Similarly, the term "thickness of the coating layer" refers to thickness of the substance layer enveloping the core in a radial direction of the core.

Unless otherwise specified, in this application, the term "source" refers to a compound that is a source of an element. For example, types of "sources" include but are not limited to carbonates, sulfates, nitrates, elementary substances, halides, oxides, and hydroxides.

### [Secondary battery]

Secondary batteries, also referred to as rechargeable batteries or storage batteries, are batteries whose active material can be activated for continuous use through charging after the batteries are discharged.

Generally, a secondary battery includes a positive electrode plate, a negative electrode plate, a separator, and an electrolyte. In a charge and discharge process of the battery, active ions (for example, lithium ions) migrate between the positive electrode plate and the negative electrode plate. The separator is disposed between the positive electrode plate and the negative electrode plate to mainly prevent short circuit between the positive and negative electrodes and allow active ions to pass through. The electrolyte is between the positive electrode plate and the negative electrode plate to mainly conduct active ions.

### [Positive electrode active material]

An embodiment of this application provides a positive electrode active material containing a first positive electrode active material and a second positive electrode active material; where
the first positive electrode active material contains a compound LiNi_{g}Co_{d}MnₑM'_{f}O₂, where g is selected from a range of 0.314 to 0.970, optionally from a range of 0.550 to 0.970, d is selected from a range of 0 to 0.320, optionally from a range of 0.047 to 0.320 or from a range of 0.005 to 0.188, e is selected from a range of 0.006 to 0.390, optionally from a range of 0.006 to 0.249, a sum of g, d, e, and f is 1 and f is greater than 0, and M' is one or more elements selected from Mn, Al, Mg, Ca, Na, Ti, W, Zr, Sr, Cr, Zn, Ba, B, S, and Y, and optionally, M' is Mg and/or Al; and
the second positive electrode active material includes a core and a shell enveloping the core, the shell including a first coating layer enveloping the core, a second coating layer enveloping the first coating layer, and a third coating layer enveloping the second coating layer; where the core contains a compound Li₁₊ₓMn_{1-y}A_{y}P_{1-z}R_{z}O₄, the first coating layer contains a crystalline pyrophosphate LiₐMP₂O₇ and/or M_{b}(P₂O₇)_{c}, the second coating layer contains a crystalline phosphate XₙPO₄, and the third coating layer contains carbon, where x is selected from a range of -0.100 to 0.100, y is selected from a range of 0.001 to 0.909, optionally from a range of 0.001 to 0.600, z is selected from a range of 0.001 to 0.100, a is greater than 0 and less than or equal to 2, b is greater than 0 and less than or equal to 4, optionally selected from a range of 1 to 4, c is greater than 0 and less than or equal to 3, optionally selected from a range of 1 to 3, n is greater than 0 and less than or equal to 3, optionally selected from a range of 1 to 3 (for example, 1, 2, or 3), A is one or more elements selected from Zn, Al, Na, K, Mg, Mo, W, Ti, V, Zr, Fe, Ni, Co, Ga, Sn, Sb, Nb, and Ge, optionally one or more elements from Fe, V, Ni, and Co, R is one or more elements selected from B (boron), Si, N, and S, optionally one or more elements selected from Si, N, and S, each M in the crystalline pyrophosphates LiₐMP₂O₇ and M_{b}(P₂O₇)_{c} is independently one or more elements selected from Fe, Ni, Mg, Co, Cu, Zn, Ti, Ag, Zr, Nb, and Al, optionally one or more elements selected from Fe, Co, Ti, and Al, and more optionally one or more elements selected from Fe, Ti, and Al, and X is one or more elements selected from Li, Fe, Ni, Mg, Co, Cu, Zn, Ti, Ag, Zr, Nb, and Al, optionally one or more elements selected from Li, Fe, Co, Ag, and Al.

The first positive electrode active material is layered transition metal oxide and has two-dimensional lithium ion transport channels, while the second positive electrode active material has only one-dimensional lithium ion transport channels. Therefore, the mixed use of the two materials, with complementarity achieved for the two materials, can improve the overall electrochemical performance. The first positive electrode active material usually has a lower initial coulombic efficiency than the second positive electrode active material, and with the mixed use of the two materials, the secondary battery still contains a relatively large amount of reversible lithium ions in spite of lithium ions consumed in film formation at the negative electrode in the chemical system, thus increasing the cycling capacity retention rate of the secondary battery, prolonging the cycle life of the secondary battery, and improving the safety of the secondary battery.

In addition, although the mechanism is still unclear, the applicant has surprisingly found that the second positive electrode active material of this application is a core-shell structure. Doping element A and element R respectively at the manganese site and phosphorus site of the lithium manganese phosphate core can not only effectively reduce the dissolution amount of manganese, reduce the migration of manganese ions to the negative electrode, reduce the consumption of the electrolyte due to the decomposition of the SEI, and improve the cycling performance and safety performance of the secondary battery, but also promote the adjustment of the Mn-O bond, reduce the migration barrier of lithium ions, promote the migration of lithium ions, and improve the rate performance of the secondary battery. Enveloping the first coating layer including crystalline pyrophosphate on the core can further increase the migration resistance of manganese, reduce the dissolution amount of manganese, decrease the proportion of impurity lithium on the surface, and reduce the contact between the core and the electrolyte, thereby reducing interfacial side reactions, reducing gas produced, and improving high-temperature storage performance, cycling performance, and safety performance of the secondary battery. Further, applying the crystalline phosphate coating layer with excellent ability to conduct lithium ions can effectively reduce the interfacial side reactions on the surface of the second positive electrode active material, thus improving the high-temperature cycling and storage performance of the secondary battery. Still further, applying the carbon layer as the third coating layer can further improve the safety performance and kinetic performance of the secondary battery. Furthermore, element A doping at the manganese site of lithium manganese phosphate in the core helps to reduce the lattice change rate of lithium manganese phosphate in the process of deintercalation or intercalation of lithium, improve the structural stability of the second positive electrode material, significantly reduce the dissolution amount of manganese, and reduce the oxygen activity on the surface of the particles. Element R doping at the phosphorus site also helps to change difficulty in changing the Mn-O bond length, thereby improving the electronic conductivity, reducing the migration barrier of lithium ions, promoting the migration of lithium ions, and improving the rate performance of the secondary battery.

In some embodiments, M' is Mg and/or Al. Doping element Al in the first positive electrode active material can improve the structural stability and thermal stability of the material, thus improving the cycling performance; doping element Mg in the first positive electrode active material leads to increase or decrease in the valence of transition metal ions, resulting in generation of holes or electrons, which alters the band structure of the material, improves the intrinsic electronic conductivity of the material, and improves the cycling performance of the secondary battery; and co-doping of Mg and Al into the lattice of the main material can synergistically stabilize the material structure, improve the degree of mixing of cations in the material, suppress the precipitation of oxygen, and further improve the cycling performance and thermal stability of the secondary battery.

Unless otherwise specified, in the chemical formula Li₁₊ₓMn_{1-y}A_{y}P_{1-z}R_{z}O₄, when A is two or more elements, the foregoing limitation on the value range of y is not only a limitation on the stoichiometric number of each element as A but also a limitation on a sum of stoichiometric numbers of all the elements as A. For example, when A is two or more elements A1, A2, ..., and An, the stoichiometric numbers y1, y2, ..., and yn of all of A1, A2, ..., and An are each required to fall within the value range defined by this application for y, and the sum of y1, y2, ..., and yn are also required to fall within this value range. Similarly, in a case that R is two or more elements, the limitation on the value range of the stoichiometric number of R in this application also has the foregoing meaning. Similarly, in a case that M' in the chemical formula LiNi_{g}Co_{d}MnₑM'_{f}O₂ is two or more elements, the limitation on the value range of the stoichiometric number of M' in this application also has the foregoing meaning.

In some embodiments, in the second positive electrode active material, when A is one, two, three, or four elements selected from Zn, Al, Na, K, Mg, Mo, W, Ti, V, Zr, Fe, Ni, Co, Ga, Sn, Sb, Nb, and Ge, A_{y} is Qₙ₁Dₙ₂Eₙ₃Kₙ₄, where n1+n2+n3+n4=y, n1, n2, n3, and n4 are all positive numbers but are not all zero, and Q, D, E, and K are each independently one selected from Zn, Al, Na, K, Mg, Mo, W, Ti, V, Zr, Fe, Ni, Co, Ga, Sn, Sb, Nb, and Ge, and optionally, at least one of Q, D, E, and K is Fe. Optionally, one of n1, n2, n3, and n4 is zero and the rest are not zero; more optionally, two of n1, n2, n3, and n4 are zero and the rest are not zero; and further optionally, three of n1, n2, n3, and n4 are zero, and the rest is not zero. In the core Li₁₊ₓMn_{1-y}A_{y}P_{1-z}R_{z}O₄, it is advantageous to dope one, two, three, or four of the foregoing elements A at the manganese site, optionally, dope one, two, or three of the foregoing elements A. Furthermore, it is advantageous to dope one or two elements R at the phosphorus site, which facilitates a uniform distribution of the doping elements.

In some embodiments, in the second positive electrode active material, the values of x, y, and z satisfy the condition that the entire core is made electrically neutral.

In some embodiments, in the second positive electrode active material, in the core Li₁₊ₓMn_{1-y}A_{y}P_{1-z}R_{z}O₄, the magnitude of x is influenced by the magnitude of the valences of A and R and the magnitudes of y and z so as to ensure that the entire system is electrically neutral. If the value of x is too small, the lithium content of the entire core system decreases, which affects the gram capacity utilization of the material. The value of y limits the total amount of all doping elements. A too-small value of y, that is, an excessively low doping amount, makes the doping elements useless, and y being more than 0.6 leads to less Mn content in the system and affects the voltage plateau of the material. Element R dopes at the P site. Because the P-O tetrahedron is relatively stable and a too-large value of z affects the stability of the material, the value of z is limited in a range of 0.001 to 0.100.

In addition, the entire core system being electrically neutral can ensure minimized defects and heterophase structures in the second positive electrode active material. If excess of transition metal (for example, manganese) is present in the second positive electrode active material, the excess transition metal is likely to precipitate out as an elementary substance or form heterophase structures inside the lattice due to the inherently stable structure of the material system. Therefore, making the system electrically neutral can minimize such heterophase structures. In addition, guaranteeing the electrical neutrality of the system can also lead to lithium vacancies in the material in some cases, resulting in better kinetic performance of the material.

In some embodiments, in the second positive electrode active material, the values of a, b, and c satisfy the condition that the crystalline pyrophosphate LiₐMP₂O₇ or M_{b}(P₂O₇)_{c} is made electrically neutral.

In some embodiments, the crystalline means that the crystallinity is above 50%, to be specific, being 50% to 100%. A crystallinity less than 50% is referred to as a glassy state. The crystalline pyrophosphate and crystalline phosphate in this application have a crystallinity of 50% to 100%. The pyrophosphate and phosphate with a certain crystallinity not only help to give full play to the ability of the pyrophosphate coating layer in hindering the manganese ion dissolution and the ability of the phosphate coating layer in conducting lithium ions, reducing the interfacial side reactions, but also enable the pyrophosphate coating layer and the phosphate coating layer to be better lattice matched, such that a tighter bond between the coating layers can be achieved.

In some embodiments, the crystallinity of the crystalline pyrophosphate in the first coating layer substance and the crystalline phosphate in the second coating layer substance of the second positive electrode active material can be tested by using conventional technical means in the art, for example, by using density, infrared spectroscopy, differential scanning calorimetry, and nuclear magnetic resonance absorption methods, and also by using, for example, X-ray diffraction.

A specific method of testing the crystallinity of the crystalline pyrophosphate in the first coating layer and the crystalline phosphate in the second coating layer of the second positive electrode active material by using X-ray diffraction may include the following steps:
taking a specific amount of the second positive electrode active material powder, and measuring a total scattering intensity by X-ray, where the total scattering intensity is a sum of scattering intensities of substances in the entire space and is only related to the intensity of the primary rays, the chemical structure of the second positive electrode active material powder, a total number of electrons participating in the diffraction, that is, the mass, but not related to the order state of the sample; and separating crystalline scattering from non-crystalline scattering in the diffractogram, where the crystallinity is a ratio of a scattering intensity of the crystalline part to the total scattering intensity.

It should be noted that the crystallinity of the pyrophosphate and phosphate in the coating layers can be adjusted, for example, by adjusting the process conditions such as sintering temperature and sintering time of the sintering process.

In the second positive electrode active material, metal ions are difficult to migrate in the pyrophosphate, and therefore the pyrophosphate, as the first coating layer, can effectively isolate doping metal ions from the electrolyte. The crystalline pyrophosphate has a stable structure, so application of the crystalline pyrophosphate can effectively suppress the dissolution of transition metals and improve the cycling performance.

In the second positive electrode active material, the bond between the first coating layer and the core is similar to a heterojunction, and the firmness of the bond is limited by the degree of lattice match. When the lattice mismatch is below 5%, the lattice match is better and the two are easily bonded tightly. The tight bond can ensure that the coating layer does not detach from the core in the subsequent cycle process, which is beneficial to guarantee the long-term stability of the material. The degree of bond between the first coating layer and the core is mainly measured by calculating the degree of mismatch between lattice constants of the core and the coating layer. In this application, compared with the core doped with no element, the core doped with elements A and R has an increased match with the first coating layer, and the core can be more tightly bonded to the pyrophosphate coating layer.

In the second positive electrode active material, crystalline phosphate is selected as the second coating layer because it has a relatively high lattice match with the coating substance crystalline pyrophosphate of the first coating layer (the mismatch is only 3%), and in addition, the phosphate itself has better stability than the pyrophosphate. Therefore, using the phosphate for enveloping the pyrophosphate is beneficial to improve the stability of the material. Crystalline phosphate has a stable structure and an excellent ability to conduct lithium ions. Therefore, using crystalline phosphate for enveloping can effectively reduce the interfacial side reactions on the surface of the second positive electrode active material, thereby improving the high-temperature cycling and storage performance of the secondary battery. The lattice match method and the like between the second coating layer and the first coating layer are similar to the bond between the first coating layer and the core. When the lattice mismatch is below 5%, the lattice match is better, and the second coating layer and the first coating layer are easily bonded tightly.

In the second positive electrode active material, the main reason for selecting carbon as the third coating layer is that the carbon layer has good electronic conductivity. An electrochemical reaction occurs when carbon is applied in secondary batteries, which requires the participation of electrons. Therefore, to promote the electron transport between particles and the electron transport at different positions on the particles, carbon with excellent electrical conductivity can be used for enveloping. Carbon enveloping can effectively improve the electrical conductivity and desolvation of the second positive electrode active material.

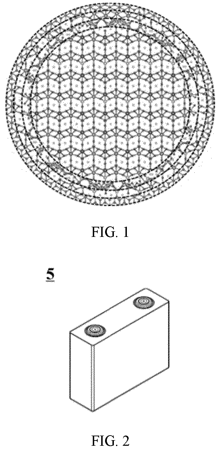

FIG. 1 is a schematic diagram of an ideal second positive electrode active material having a three-layer coating structure. As shown in the figure, the innermost circle schematically represents the core, followed by the first coating layer, the second coating layer, and the third coating layer in turn from the inside to the outside. The diagram represents the ideal state in which each layer implements full enveloping. In practice, each coating layer may implement full or partial enveloping.

In some embodiments, the compound LiNi_{b}Co_{d}MnₑM'_{f}O₂ is made electrically neutral.

In some embodiments, mass of the first positive electrode active material is m₁, mass of the second positive electrode active material is m₂, and a value of m₁/(m₁+m₂) is 2% to 55%, optionally 3% to 50%. With the mass percentage of the first positive electrode active material in the two positive electrode active materials within the above range, the stability and safety of the positive electrode active material as a whole can be improved.

In some embodiments, a value of g×m₁/(m₁+m₂) is 0.017 to 0.457, optionally 0.025 to 0.415. This can further improve the stability and safety of the positive electrode active material as a whole.

In some embodiments, the first positive electrode active material is a single crystal or quasi-single crystal material, and a particle size Dᵥ50 of the first positive electrode active material is less than or equal to 5.8 µm, optionally from 2.3 µm to 5.8 µm, and more optionally from 2.3 µm to 4.3 µm.

Making the particle size of the single crystal or quasi-single crystal first positive electrode active material fall within the above range can optimize an electrochemical reaction area, further reduce and suppress the interfacial side reactions on the positive electrode during cycling of the secondary battery, reduce the cycling attenuation rate of the secondary battery, and prolong the cycle life of the secondary battery.

In some embodiments, when the first positive electrode active material is a single crystal or quasi-single crystal material, d is selected from a range of 0.047 to 0.320, optionally from a range of 0.047 to 0.235; and/or
b is greater than 0.314 and less than 0.97, optionally selected from a range of 0.55 to 0.869.

When the first positive electrode active material is a single crystal or quasi-single crystal material, d and b falling within the above ranges is conducive to further improving the conductivity and rate performance of the positive electrode active material, further increasing the cycling capacity retention rate of the secondary battery, and further prolonging the cycle life of the secondary battery.

In some embodiments, the first positive electrode active material is a polycrystal material, and a particle size Dᵥ50 of the first positive electrode active material is 3.0 µm to 13.5 µm, optionally 3.5 µm to 13.5 µm;
a BET specific surface area of the first positive electrode active material is less than or equal to 1.73 m²/g, optionally less than or equal to 1.32 m²/g, and more optionally from 0.28 m²/g to 1.32 m²/g; and/or
a compacted density under pressure of 3T of the first positive electrode active material is greater than or equal to 2.90 g/cm³, optionally greater than or equal to 2.92 g/cm³, and more optionally from 2.92 g/cm³ to 3.31 g/cm³.

Making the particle size, specific surface area, and compacted density of the polycrystal first positive electrode active material fall within the above ranges can further improve the rate performance of the positive electrode active material, further reduce and suppress the interfacial side reactions on the positive electrode during cycling of the secondary battery, reduce the cycling attenuation rate of the secondary battery, and prolong the cycle life of the secondary battery.

In some embodiments, the first positive electrode active material further contains lithium carbonate and/or lithium hydroxide; and
optionally, based on mass of the first positive electrode active material, a mass percentage of the lithium carbonate is less than or equal to 1.05%, optionally less than or equal to 1%, and/or a mass percentage of the lithium hydroxide is less than or equal to 1.02%, optionally less than or equal to 1%.

The residual water molecules brought in by the second positive electrode active material may react with the electrolyte to generate HF, and HF is prone to damage the positive electrode active material itself or the SEI film on the negative electrode plate, which in turn affects service life of the secondary battery. The lithium carbonate and/or lithium hydroxide further contained in the first positive electrode active material of this application can neutralize with HF, reducing or suppressing the damage of HF on the positive electrode active material or the SEI film on the negative electrode plate, thereby further prolonging the cycle life of the secondary battery.

In some embodiments, in the second positive electrode active material, the crystalline pyrophosphate in the first coating layer has an interplanar spacing in a range of 0.293 nm to 0.470 nm, optionally 0.303 nm to 0.462 nm, and an included angle in a range of 18.00° to 32.00°, optionally 19.211° to 30.846°, in the [111] crystal orientation; and/or
the crystalline phosphate in the second coating layer has an interplanar spacing in a range of 0.244 nm to 0.425 nm and an included angle in a range of 20.00° to 37.00°, optionally 20.885° to 36.808°, in the [111] crystal orientation.

Both the first coating layer and the second coating layer in the second positive electrode active material of this application use crystalline substances whose interplanar spacing and included angle range are within the foregoing ranges. In this way, the heterophase structures in the coating layer can be effectively avoided, thereby increasing the gram capacity of the material and improving the cycling performance and rate performance of the secondary battery. The crystalline pyrophosphate and crystalline phosphate in the coating layers may be characterized by using conventional technical means in the art, or may be characterized, for example, by using transmission electron microscopy (TEM). Under the TEM, the core and the coating layer can be distinguished by measuring the interplanar spacing.

The specific method of measuring the interplanar spacing and included angle of the crystalline pyrophosphate and the crystalline phosphate in the coating layers may include the following steps:
taking a specific amount of enveloped second positive electrode active material sample powder in a test tube, injecting the test tube with a solvent such as alcohol, and stirring and dispersing the mixture thoroughly; taking an appropriate amount of the resulting solution with a clean disposable plastic pipette, and dropping the solution on a 300-mesh copper grid, part of the powder remaining on the copper grid at that point; transferring the copper grid together with the sample to the TEM sample cavity for testing, obtaining an original picture under the TEM test; and saving the original picture.

The original picture obtained in the TEM test is opened in the diffractometer software, Fourier transform is performed to get a diffraction pattern, a distance from a diffraction spot to the center of the diffraction pattern is measured to get the interplanar spacing, and the included angle is calculated according to the Bragg equation.

The range of interplanar spacing of crystalline pyrophosphate differs from that of crystalline phosphate, and it can be directly determined by the values of the interplanar spacings.

In some embodiments, a ratio of y to 1-y in the core of the second positive electrode active material is 1:10 to 10:1, optionally 1:4 to 1:1. Herein, y denotes the sum of the stoichiometric numbers of elements doping at the Mn site. The energy density, cycling performance, and rate performance of the secondary battery can be further improved when the preceding conditions are met.

In some embodiments, a ratio of z to 1-z in the core of the second positive electrode active material is 1:999 to 1:9, optionally 1:499 to 1:249. Herein, z denotes the sum of the stoichiometric numbers of elements doping at the P site. The energy density, cycling performance, and rate performance of the secondary battery can be further improved when the preceding conditions are met.

In some embodiments, in the second positive electrode active material, carbon in the third coating layer is a mixture of SP2 carbon and SP3 carbon; and optionally, a molar ratio of SP2 carbon to SP3 carbon is 0.1 to 10, and more optionally 2.0 to 3.0.

In some embodiments, a molar ratio of SP2 carbon to SP3 carbon may be about 0.1, about 0.2, about 0.3, about 0.4, about 0.5, about 0.6, about 0.7, about 0.8, about 0.9, about 1, about 2, about 3, about 4, about 5, about 6, about 7, about 8, about 9, or about 10, or in any range defined by any of these values.

In this application, being "about" a value indicates a range of ±10% of that value.

By selecting the morphology of carbon in the carbon coating layer, the overall electrical performance of the secondary battery can be improved. Specifically, by using a mixture of SP2 carbon and SP3 carbon and limiting the ratio of SP2 carbon to SP3 carbon to a certain range, the following situations can be avoided: if the carbon in the coating layer is all in the amorphous SP3 morphology, the electrical conductivity is poor; and if the carbon in the coating layer is all in the graphitized SP2 morphology, although the electrical conductivity is good, the quantity of lithium ion pathways is small, which is not conducive to deintercalation or intercalation of lithium. In addition, limiting the molar ratio of SP2 carbon to SP3 carbon to the foregoing range can not only implement good electrical conductivity but also grantee lithium ion pathways, and therefore, is beneficial to the function implementation and cycling performance of the secondary battery.

The mixing ratio of SP2 carbon to SP3 carbon of the third coating layer can be controlled by sintering conditions such as sintering temperature and sintering time. For example, under the condition that sucrose is used as the source of carbon to prepare the third coating layer, the sucrose is deposited on the second coating layer after pyrolysis, and under the action of high temperature, a carbon coating layer with both SP3 carbon and SP2 carbon is produced. The ratio of SP2 carbon to SP3 carbon can be controlled by selecting the pyrolysis and sintering conditions.

The structure and characteristics of the third coating layer carbon can be measured by Raman (Raman) spectroscopy, and the specific measurement method is as follows: splitting the energy spectrum of the Raman test to obtain Id/Ig (where Id is a peak intensity of SP3 carbon and Ig is a peak intensity of SP2 carbon), and then determining the molar ratio therebetween.

In some embodiments, in the second positive electrode active material, based on weight of the core, an application amount of the first coating layer is greater than 0 and less than or equal to 6wt%, optionally greater than 0 and less than or equal to 5.5wt%, and more optionally greater than 0 and less than or equal to 2wt%, for example, 1%;
based on the weight of the core, an application amount of the second coating layer is greater than 0 and less than or equal to 6wt%, optionally greater than 0 and less than or equal to 5.5wt%, and more optionally from 2wt% to 4wt%; and/or
based on the weight of the core, an application amount of the third coating layer is greater than 0 and less than or equal to 6wt%, optionally greater than 0 and less than or equal to 5.5wt%, and more optionally greater than 0 and less than or equal to 2wt%, for example, 1%.

In the second positive electrode active material having a core-shell structure of this application, the application amounts of the three coating layers are preferably within the foregoing ranges, and therefore the core can be fully enveloped and the kinetic performance and safety performance of the secondary battery can be further improved without reducing the gram capacity of the positive electrode active material.

For the first coating layer, limiting an application amount within the foregoing range can avoid the following cases: if the application amount is too small, it means that the thickness of the coating layer is relatively thin and the migration of the transition metal may not be effectively hindered; and if the application amount is too large, it means that the coating layer is too thick, which may affect the migration of the Li⁺, and thus affecting the rate performance of the material.

For the second coating layer, limiting an application amount within the foregoing range can avoid the following cases: if the application amount is too large, the overall platform voltage of the material may be affected; and if the application amount is too small, a sufficient enveloping effect may not be realized.

For the third coating layer, the carbon enveloping mainly promotes the electron transport between the particles. However, because the structure also contains a large amount of amorphous carbon, the density of carbon is low. Therefore, if the application amount is too large, the compacted density of the electrode plate may be affected.

In some embodiments, in the second positive electrode active material, thickness of the first coating layer is 1 nm to 10 nm.

In some embodiments, in the second positive electrode active material, the thickness of the first coating layer may be about 2 nm, about 3 nm, about 4 nm, about 5 nm, about 6 nm, about 7 nm, about 8 nm, about 9 nm, or about 10 nm, or in any range defined by any of these values.

In this application, the thickness of the first coating layer falling within the range of 1 nm to 10 nm can avoid a possible unfavorable effect, caused by excessive thickness, on the kinetic performance of the material; and it can avoid the problem that the migration of the transition metal ions cannot be hindered effectively in a case of an excessively thin coating layer.

In some embodiments, in the second positive electrode active material, thickness of the second coating layer is 2 nm to 15 nm, optionally 2.5 nm to 7.5 nm.

In some embodiments, in the second positive electrode active material, the thickness of the second coating layer may be about 2 nm, about 3 nm, about 4 nm, about 5 nm, about 6 nm, about 7 nm, about 8 nm, about 9 nm, about 10 nm, about 11 nm, about 12 nm, about 13 nm, about 14 nm or about 15 nm, or in any range defined by any of these values.

In this application, the thickness of the second coating layer falling within the foregoing range allows the second coating layer to have a stable surface structure and fewer side reactions with the electrolyte, thus more effectively mitigating the interfacial side reactions, further improving the high-temperature performance of the secondary battery.

In some embodiments, in the second positive electrode active material, thickness of the third coating layer is 2 nm to 25 nm.

In some embodiments, in the second positive electrode active material, the thickness of the third coating layer may be about 2 nm, about 3 nm, about 4 nm, about 5 nm, about 6 nm, about 7 nm, about 8 nm, about 9 nm, about 10 nm, about 11 nm, about 12 nm, about 13 nm, about 14 nm, about 15 nm, about 16 nm, about 17 nm, about 18 nm, about 19 nm, about 20 nm, about 21 nm, about 22 nm, about 23 nm, about 24 nm, or about 25 nm, or in any range defined by any of these values.

In this application, the thickness of the third coating layer falling within the range of 2 nm to 25 nm can further improve the electrical conductivity of the material and improve the compacted density performance of the battery electrode plates prepared using the first positive electrode active material.

The thickness of the coating layer is measured mainly by FIB, and the specific method may include the following steps: randomly selecting a single particle from the second positive electrode active material powder under test, cutting a thin slice with a thickness of about 100 nm from the middle or near the middle of the selected particle, and performing TEM test on the thin slice to measure the thickness of the coating layer at 3 to 5 positions and take an average value.

In some embodiments, in the second positive electrode active material, based on weight of the second positive electrode active material, a percentage of element manganese is in a range of 10wt% to 35wt%, optionally in a range of 15wt% to 30wt%, and more optionally in a range of 17wt% to 20wt%.

In this application, under the condition that only the core of the second positive electrode active material contains manganese, the percentage of manganese may correspond to the percentage of the core.

In the second positive electrode active material having a core-shell structure of this application, the percentage of element manganese falling within the foregoing range can effectively avoid problems such as deterioration of the stability of the material structure and decrease in density that may be caused by excessively high percentage of element manganese, thereby improving the performance of the secondary battery in terms of cycling, storage, compacted density, and so on; and it can avoid problems such as low voltage plateau that may be caused by excessively low percentage of element manganese, thereby improving the energy density of the secondary battery.

In some embodiments, in the second positive electrode active material, based on the weight of the second positive electrode active material, a percentage of element phosphorus is in a range of 12wt% to 25wt%, optionally in a range of 15wt% to 20wt%.

In the second positive electrode active material having a core-shell structure of this application, the percentage of element phosphorus falling within the foregoing range can effectively avoid the following cases: excessively high percentage of element phosphorus may lead to such strong covalency of P-O that the conductivity of small polarons is affected, thus affecting the electrical conductivity of the material; and excessively low percentage of element phosphorus may lead to decreased stability of the lattice structure of the core, pyrophosphate in the first coating layer, and/or phosphate in the second coating layer, thereby affecting the overall stability of the material.

In some embodiments, in the second positive electrode active material, based on the weight of the second positive electrode active material, a weight ratio of element manganese to element phosphorus is in a range of 0.90 to 1.25, optionally 0.95 to 1.20.

In the second positive electrode active material having a core-shell structure of this application, the weight ratio of element manganese to element phosphorus falling within the foregoing range can effectively avoid the following cases: excessively large weight ratio means that element manganese is too much and the dissolution of manganese increases, affecting the stability and gram capacity utilization of the second positive electrode active material, which in turn affects the cycling performance and storage performance of the secondary battery; and excessively small weight ratio means that element phosphorus is too much and a heterogeneous phase is prone to be formed, leading to a decrease in the discharge voltage plateau of the material, thereby reducing the energy density of the secondary battery.

The measurement of element manganese and element phosphorus can be performed by means of conventional technologies in the art. In particular, the following method is used to determine the percentages of element manganese and element phosphorus: dissolving the material in dilute hydrochloric acid (with a concentration of 10% to 30%), measuring the percentage of each element in the solution using ICP, and then performing measurement and conversion for the percentage of element manganese to obtain its weight percentage.

In some embodiments, a lattice change rate of the second positive electrode active material before and after complete deintercalation or intercalation of lithium is below 4%, optionally below 3.8%, and more optionally from 2.0% to 3.8%.

The process of deintercalation or intercalation of lithium in lithium manganese phosphate (LiMnPO₄) is a two-phase reaction. The interfacial stress of the two phases is determined by the magnitude of the lattice change rate before and after deintercalation or intercalation of lithium, where smaller lattice change rate indicates lower interfacial stress and easier Li⁺ transport. Therefore, a decrease in the lattice change rate of the core is conducive to enhancing the Li⁺ transport capacity, thereby improving the rate performance of the secondary battery. The second positive electrode active material having a core-shell structure of this application can allow for a lattice change rate below 4% before and after deintercalation or intercalation of lithium, so the use of the second positive electrode active material can improve the rate performance of the secondary battery. The lattice change rate can be measured by a method known in the art, for example, X-ray diffraction (XRD) pattern.

In some embodiments, a Li/Mn antisite defect concentration of the second positive electrode active material is below 4%, optionally below 2.2%, and more optionally from 1.5% to 2.2%.

The Li/Mn antisite defects of this application mean the interchange of the Li⁺and Mn²⁺ sites in the LiMnPO₄ lattice. Accordingly, the Li/Mn antisite defect concentration refers to a percentage of Li⁺ interchanged with Mn²⁺ in the total amount of Li⁺. In this application, the Li/Mn antisite defect concentration may be tested, for example, according to JIS K 0131-1996.

The second positive electrode active material having a core-shell structure of this application can achieve the foregoing low Li/Mn antisite defect concentration. Although the mechanism has not been understood yet, the inventors of this application speculate that because the Li⁺ and Mn²⁺ sites in the LiMnPO₄ lattice are interchanged and the transport channel of Li⁺ is a one-dimensional channel, Mn²⁺ is difficult to migrate in the channel of Li⁺ and thus hinders the transport of Li⁺. Therefore, the second positive electrode active material having a core-shell structure of this application can prevent Mn²⁺ from hindering the transport of Li⁺ due to the low Li/Mn antisite defect concentration, which is within the foregoing range, and increase the gram capacity utilization and rate performance of the second positive electrode active material.

In some embodiments, a compacted density under 3T of the second positive electrode active material is above 2.2 g/cm³, optionally above 2.2 g/cm³ and below 2.8 g/cm³. Higher compacted density indicates larger weight of the active material per unit volume. Therefore, increasing the compacted density is conducive to increasing the volumetric energy density of the cell. The compacted density can be measured according to GB/T 24533-2009.

In some embodiments, a surface oxygen valence of the second positive electrode active material is below -1.90, optionally from -1.90 to -1.98.

The stable valence of oxygen is originally -2. The valence closer to -2 indicates stronger electron accepting ability, in other words, higher oxidability. Typically, the surface valence of oxygen is below -1.7. In this application, limiting the surface oxygen valence of the first positive electrode active material within the foregoing range can mitigate the interfacial side reactions between the second positive electrode material and the electrolyte, thereby improving the performance of the cell in terms of cycling, high temperature storage, and the like and suppressing gas production.

The surface oxygen valence can be measured by a method known in the art, for example, electron energy loss spectroscopy (EELS).

In some embodiments, the primary particles of the second positive electrode active material have an average particle size in a range of 50 nm to 500 nm, and a median particle size Dᵥ50 in a range of 200 nm to 300 nm. Because the particles are subject to agglomeration, the actual measured size of the secondary particles after agglomeration may be 500 nm to 40000 nm. The size of the particles of the second positive electrode active material affects the processing of the material and the compacted density performance of the electrode plate. Selecting the average particle size of the primary particles within the above range can avoid the following cases: excessively small average particle size of the primary particles of the second positive electrode active material may cause agglomeration of particles, difficulty in dispersion, and the need for a larger amount of binder, resulting in unfavorable brittleness of the electrode plate; and excessively large average particle size of the primary particles of the second positive electrode active material may lead to large gap between particles and decreased compacted density.

Based on the foregoing solution, the lattice change rate and Mn dissolution of the lithium manganese phosphate during deintercalation or intercalation of lithium can be effectively suppressed, thereby improving the high-temperature cycling stability and high-temperature storage performance of the secondary battery.

In this application, the median particle size Dᵥ50 is a corresponding particle size when a cumulative volume distribution percentage of the material reaches 50%. In this application, the median particle size Dᵥ50 of the material may be determined in a laser diffraction particle size analyzing method. For example, according to the standard GB/T 19077-2016, a laser particle size analyzer (for example, Malvern Master Size 3000) is used.

Process control (for example, thoroughly mixing and grinding of the materials of various sources) can ensure that the elements are uniformly distributed in the lattice without aggregation. The positions of the main characteristic peaks in the XRD plots of lithium manganese phosphate doped with element A and element R are consistent with those of undoped LiMnPO₄, indicating that no heterophase structure is introduced in the doping process. Therefore, the improvement on the performance of the core mainly comes from element doping rather than heterophase structures. After the second positive electrode active material is prepared, the inventors of this application cut the middle region of the prepared second positive electrode active material particles by focused ion beam (FIB for short). Tests conducted through transmission electron microscope (TEM for short) and X-ray energy spectrum analysis (EDS for short) show that the elements are uniformly distributed without aggregation.

In some embodiments, in the second positive electrode active material, A is one or more elements selected from Fe, Ti, V, Ni, Co, and Mg, optionally one or more elements from Fe, V, Ni, Co, and Mg, and more optionally one or more elements selected from Fe, V, and Ni. Selecting the doping elements within the foregoing ranges is beneficial to enhance the doping effect, thereby further reducing the lattice change rate, suppressing the dissolution of manganese, and decreasing the consumption of electrolyte and active lithium, and also beneficial to lower the surface oxygen activity and reduce the interfacial side reactions between the first positive electrode active material and the electrolyte, thereby further improving the cycling performance and high-temperature storage performance of the secondary battery.

In some embodiments, in the second positive electrode active material, R is one element selected from B, Si, N, and S, optionally, R is one or more elements selected from Si, N, and S, and more optionally, R is Si. Selecting the doping elements within the foregoing ranges can further improve the rate performance and increase the conductivity of the secondary battery, thereby improving the gram capacity, cycling performance, and high-temperature performance of the secondary battery.

In some embodiments, x in the core of the second positive electrode active material is any value in a range of -0.005 to 0.002, for example, -0.004, -0.003, -0.002, -0.001, 0, 0.001, or 0.002.

In some embodiments, y in the core of the second positive electrode active material may be, for example, 0.001, 0.002, 0.3, 0.35, 0.4, or 0.5.

In some embodiments, z in the core of the second positive electrode active material may be, for example, 0.001, 0.002, 0.003, 0.005, or 0.1.

In some embodiments, in the first coating layer of the second positive electrode active material, each M in the crystalline pyrophosphates LiₐMP₂O₇ and M_{b}(P₂O₇)_{c} is independently one or more elements selected from Fe, Ni, Mg, Co, Cu, Zn, Ti, Ag, Zr, and Al, for example, Fe.

In some embodiments, in the first coating layer of the second positive electrode active material, a is selected from a range of 1 to 2, for example, 2.

In some embodiments, in the first coating layer of the second positive electrode active material, b may be 1, 2, 3, or 4.

In some embodiments, in the first coating layer of the second positive electrode active material, c is selected from a range of 1 to 3.

In some embodiments, in the second coating layer of the second positive electrode active material, X is two elements selected from Li, Fe, Ni, Mg, Co, Cu, Zn, Ti, Ag, Zr, Nb, and Al, for example, Li and Fe, that is, the crystalline phosphate XPO₄ is crystalline LiFePO₄.

### [Preparation method of positive electrode active material]

An embodiment of this application provides a preparation method of positive electrode active material including the following steps:
providing a first positive electrode active material and a second positive electrode active material; and
mixing the first positive electrode active material and the second positive electrode active material; where
the first positive electrode active material contains a compound LiNi_{g}Co_{d}MnₑM'_{f}O₂, and the second positive electrode active material includes a core and a shell enveloping the core, the shell including a first coating layer enveloping the core, a second coating layer enveloping the first coating layer, and a third coating layer enveloping the second coating layer; where the core contains a compound Li₁₊ₓMn_{1-y}A_{y}P_{1-z}R_{z}O₄, the first coating layer contains a crystalline pyrophosphate LiₐMP₂O₇ and/or M_{b}(P₂O₇)_{c}, the second coating layer contains a crystalline phosphate XₙPO₄, and the third coating layer contains carbon; and g, d, e, f, x, y, z, a, b, c, n, A, R, M, X, and M' are defined as in [positive electrode active material]; and
optionally, the first positive electrode active material further contains lithium carbonate and/or lithium hydroxide.

Based on this, in this application, the mixed use of the first positive electrode active material and the second positive electrode active material, with complementarity achieved for the two materials, increases cycling capacity retention rate of a secondary battery, prolongs cycle life of the secondary battery, and improves safety of the secondary battery.

In some embodiments, the first positive electrode active material is prepared by the following steps.

Step (1). ANi salt, a Co salt, a Mn salt, and an alkali react in a solvent, followed by solid-liquid separation, and solid is collected.

Step (2). Mix the solid, a lithium source, and a source of element M, followed by ball milling, sintering, and cooling to obtain the first positive electrode active material.

Optionally, in step (2), the cooled first positive electrode active material is pulverized and sieved, or the cooled first positive electrode active material is pulverized, sintered again, and then crushed and sieved.

In some embodiments, in step (1), the reaction is carried out at a pH of 9 to 13, optionally at a pH of 9 to 12 or 10 to 13.

In some embodiments, in step (1), the reaction temperature is 40°C to 80°C, for example, 50°C, 55°C, or 60°C.

In some embodiments, in step (1), the reaction time is 8 h to 70 h, for example, 20 h, 55 h, 60 h, or 65 h.

In some embodiments, in step (1), the reaction is carried out at a rotation speed of 150 r/min to 1000 r/min, for example, 300 r/min or 500 r/min.

In some embodiments, in step (1), the solid-liquid separation is filtration.

In some embodiments, before step (2), the solid is washed and dried, optionally dried in vacuum at 100°C to 140°C for 12 h to 48 h, for example, dried in vacuum at 120°C for 24 h.

In some embodiments, in step (2), the rotation speed of the ball milling is 200 r/s to 500 r/s, for example, 300 r/s or 500 r/s.

In some embodiments, in step (2), the ball milling is performed for 1 h to 5 h, for example, 2 h, 3 h, or 4 h.

In some embodiments, in step (2), the sintering is performed in an air atmosphere, optionally, in an air atmosphere of 0.1 MPa to 0.4 MPa.

In some embodiments, in step (2), the sintering procedure is as follows: the mixture is heated to 750°C to 950°C at a heating rate of 1°C/min and kept at that temperature for 12 h to 20 h for pre-sintering; optionally, the mixture is cooled down to 600°C at the same rate and kept at that temperature for 8 h for sintering; and after sintering, the mixture is cooled down to 300°C at a rate of 1°C/min.

In some embodiments, in step (2), the procedure for re-sintering is as follows: the material is heated to 400°C at a rate of 20°C/min and kept at that temperature for 20 h for sintering; and after sintering, the material is cooled down to 300°C at a rate of 1°C/min.

In some embodiments, in step (2), a jet pulverizer is used for pulverization; optionally, a rotation speed of the jet pulverizer is 2500 r/min to 3500 r/min, for example, 3000 r/min; and optionally, an airflow rate of the jet pulverizer is 400 m³/h to 600 m³/h, for example, 500 m³/h.

In some embodiments, in step (2), a 450- to 550-mesh (for example, 500-mesh) sieve is used for sieving.

In some embodiments, a preparation method of second positive electrode active material includes the following steps.

Step of providing a core material, a chemical formula of the core being Li₁₊ₓMn_{1-y}A_{y}P_{1-z}R_{z}O₄, where x is any value in a range of -0.100 to 0.100, y is any value in a range of 0.001 to 0.600, z is any value in a range of 0.001 to 0.100, A is one or more elements selected from Zn, Al, Na, K, Mg, Mo, W, Ti, V, Zr, Fe, Ni, Co, Ga, Sn, Sb, Nb, and Ge, optionally one or more elements selected from Fe, V, Ni, and Co, and R is one or more elements selected from B, Si, N, and S, optionally one or more elements selected from Si, N, and S.

Coating step: providing a suspension of LiₐMP₂O₇ and/or M_{b}(P₂O₇)_{c} and a suspension of XₙPO₄, separately; and adding the core material to the suspensions and mixing them, followed by sintering to obtain a first positive electrode active material; where a is greater than 0 and less than or equal to 2, b is selected from a range of 1 to 4, c is selected from a range of 1 to 3, and the values of a, b, and c satisfy the following condition that the crystalline pyrophosphate LiₐMP₂O₇ or M_{b}(P₂O₇)_{c} is electrically neutral; each M is independently one or more elements selected from Fe, Ni, Mg, Co, Cu, Zn, Ti, Ag, Zr, Nb, and Al, optionally one or more elements selected from Fe, Co, Ti, and Al; and X is one or more elements selected from Li, Fe, Ni, Mg, Co, Cu, Zn, Ti, Ag, Zr, Nb, and Al, optionally one or more elements selected from Li, Fe, Ag, and Al.

The first positive electrode active material has a core-shell structure including the core, a first coating layer enveloping the core, a second coating layer enveloping the first coating layer, and a third coating layer enveloping the second coating layer; where the first coating layer includes a crystalline pyrophosphate LiₐMP₂O₇ and/or M_{b}(P₂O₇)_{c}, the second coating layer includes a crystalline phosphate XₙPO₄, and the third coating layer is carbon.

In some embodiments, the step of providing a core material includes the following steps:
step (1): mixing a manganese source, a source of element B, and an acid to obtain a mixture; and
step (2): mixing the mixture with a lithium source, a phosphorus source, a source of element R, and a selectable solvent for sintering under protection of an inert gas to obtain the core material containing Li₁₊ₓMn_{1-y}A_{y}P_{1-z}R_{z}O₄. A, R, x, y, and z are defined as previously described.

The source of the material is not particularly limited in the preparation method in this application, and the source of an element may include one or more of elementary substance, sulfate, halide, nitrate, organic acid salt, oxide, and hydroxide of the element, provided that the source can achieve the objectives of the preparation method in this application.

In some embodiments, in the step of providing a core material, the source of element A is one or more selected from elementary substance, carbonate, sulfate, chloride, nitrate, organic acid salt, oxide, and hydroxide of element A.

In some embodiments, in the step of providing a core material, the source of element R is one or more selected from inorganic acid, sub-acid, organic acid, sulfate, chloride, nitrate, organic acid salt, oxide, and hydroxide of element R.

In some embodiments, in the step of providing a core material, the manganese source may be a manganese-containing substance known in the art that can be used for preparing lithium manganese phosphate. For example, the manganese source may be one or more selected from elemental manganese, manganese dioxide, manganese phosphate, manganese oxalate, and manganese carbonate.

In some embodiments, in the step of providing a core material, the acid may be selected from one or more of organic acids such as hydrochloric acid, sulfuric acid, nitric acid, phosphoric acid, silicic acid, and metasilicic acid, and organic acids such as oxalic acid.

In some embodiments, the acid is a dilute organic acid with a concentration below 60wt%.

In some embodiments, in the step of providing a core material, the lithium source may be a lithium-containing substance known in the art that can be used for preparing lithium manganese phosphate. For example, the lithium source is one or more selected from lithium carbonate, lithium hydroxide, lithium phosphate, and lithium dihydrogen phosphate.

In some embodiments, in the step of providing a core material, the phosphorus source may be a phosphorus-containing substance known in the art that can be used for preparing lithium manganese phosphate. For example, the phosphorus source is one or more selected from diammonium phosphate, ammonium dihydrogen phosphate, ammonium phosphate, and phosphoric acid.

In some embodiments, in the step of providing a core material, after the manganese source, the resource of element A, and the acid react in a solvent to obtain a suspension of manganese salt doped with element A, the suspension is filtered, dried, and sanded to obtain element A-doped manganese salt particles having a particle size of 50 nm to 200 nm.

In some embodiments, in the step of providing a core material, the slurry in step (2) is dried to obtain a powder material, and then the powder material is sintered to obtain a core doped with element A and element R.

In some embodiments, the mixing in step (1) is performed at a temperature of 20°C to 120°C, optionally 40°C to 120°C; and/or
the stirring in step (1) is performed at 400 rpm to 700 rpm for 1 h to 9 h, optionally 3 h to 7 h.

Optionally, the reaction temperature in step (1) may be about 30°C, about 50°C, about 60°C, about 70°C, about 80°C, about 90°C, about 100°C, about 110°C or about 120°C; the stirring in step (1) may be performed for about 2 hours, about 3 hours, about 4 hours, about 5 hours, about 6 hours, about 7 hours, about 8 hours, or about 9 hours; and optionally, the reaction temperature and the stirring time in step (1) may be within any ranges defined by any of these values.

In some embodiments, the mixing in step (2) is performed at a temperature of 20°C to 120°C, optionally 40°C to 120°C, for 1 h to 12 h; optionally, the reaction temperature in step (2) may be about 30°C, about 50°C, about 60°C, about 70°C, about 80°C, about 90°C, about 100°C, about 110°C, or about 120°C; the mixing in step (2) may be performed for about 2 hours, about 3 hours, about 4 hours, about 5 hours, about 6 hours, about 7 hours, about 8 hours, 9 hours, 10 hours, 11 hours, or about 12 hours; and optionally, the reaction temperature and the mixing time in step (2) may be within any ranges defined by any of these values.

With the temperature and time for the preparation of the core particles in the foregoing ranges, the core obtained from the preparation and the second positive electrode active material made therefrom have fewer lattice defects, which is conducive to suppressing manganese dissolution and reducing interfacial side reactions between the positive electrode active material and the electrolyte, thereby improving the cycling performance and safety performance of the secondary battery.

In some embodiments, in the step of providing a core material, in the process of preparing the dilute acid manganese particles doped with element A and element R, the pH of the solution is controlled to be 3.5 to 6; optionally, the pH of the solution is controlled to be 4 to 6; and more optionally, the pH of the solution is controlled to be 4 to 5. It should be noted that in this application, the pH of the obtained mixture may be adjusted by a method commonly used in the art, for example, the addition of an acid or alkali.

In some embodiments, a molar ratio of the manganese salt particles, the lithium source, and the phosphorus source in step (2) is 1:0.5-2.1:0.5-2.1, and optionally, a molar ratio of the manganese salt particles doped with element A, the lithium source, and the phosphorus source is about 1:1:1.

In some embodiments, in the step of providing a core material, the sintering conditions in the process of preparing lithium manganese phosphate doped with element A and element R are as follows: the sintering is performed under an inert gas or a mixture of inert gas and hydrogen at 600°C to 950°C for 4 hours to 10 hours; optionally, the sintering may be performed at about 650°C, about 700°C, about 750°C, about 800°C, about 850°C, or about 900°C for about 2 hours, about 3 hours, about 4 hours, about 5 hours, about 6 hours, about 7 hours, about 8 hours, about 9 hours, or about 10 hours; and optionally, the sintering temperature and sintering time may be within any ranges defined by any of these values. In the process of preparing lithium manganese phosphate doped with element A and element R, if the sintering temperature is too low and the sintering time is too short, the crystallinity of the core of the material will be low, affecting the overall performance; and if the sintering temperature is too high, a heterogeneous phase is prone to appear in the core of the material, affecting the overall performance; and if the sintering time is too long, the particles of the core of the material will grow large, affecting the gram capacity utilization, the compacted density, the rate performance, and the like.

In some embodiments, in the step of providing a core material, the protective atmosphere is a mixture of 70vol% to 90vol% nitrogen and 10vol% to 30vol% hydrogen.

In some embodiments, the coating step includes:
a first coating step: dissolving a source of element M, a phosphorus source, an acid, and an arbitrary lithium source in a solvent to obtain a first coating layer suspension; and thoroughly mixing the core obtained in the core preparation step with the first coating layer suspension obtained in the first coating step, followed by drying and sintering, to obtain the material enveloped with the first coating layer;
a second coating step: dissolving a source of element X, a phosphorus source, and an acid in a solvent to obtain a second coating layer suspension; and thoroughly mixing the material enveloped with the first coating layer obtained in the first coating step with the second coating layer suspension obtained in the second coating step, followed by drying and sintering, to obtain the material enveloped with two coating layers; and
a third coating step: dissolving fully a carbon source in a solvent to obtain a third coating layer solution; and adding the material enveloped with two coating layers obtained in the second coating step to the third coating layer solution, followed by mixing well, drying, and sintering, to obtain the material enveloped with three coating layers, that is, the second positive electrode active material.

In some embodiments, in the coating step, the source of element M is one or more selected from the respective elemental form, carbonate, sulfate, chloride, nitrate, organic acid salt, oxide, and hydroxide of one or more of elements Fe, Ni, Mg, Co, Cu, Zn, Ti, Ag, Zr, Nb, or Al.

In some embodiments, the source of element M' is one or more selected from the respective elemental form, carbonate, sulfate, halide, nitrate, organic acid salt, oxide, and hydroxide of element M'.

In some embodiments, in the coating step, the source of element X is one or more selected from the respective elemental form, carbonate, sulfate, chloride, nitrate, organic acid salt, oxide, and hydroxide of one or more of elements Li, Fe, Ni, Mg, Co, Cu, Zn, Ti, Ag, Zr, Nb or Al.

The amounts of sources of the elements A, R, M, and X added each depend on a target doping amount, and the ratio of amounts of the lithium source, the manganese source, and the phosphorus source conforms to the stoichiometric ratio.

For example, the carbon source is one or more selected from starch, sucrose, glucose, polyvinyl alcohol, polyethylene glycol, and citric acid.

In some embodiments, in the first coating step, while the pH of the solution dissolved with the source of element M, phosphorus source, acid, and arbitrary lithium source is controlled to be 3.5 to 6.5, the solution is stirred and reacted for 1 h to 5 h, heated to a temperature of 50°C to 120°C, kept at that temperature for 2 h to 10 h, and/or, sintered at 650°C to 800°C for 2 hours to 6 hours.

In some embodiments, in the first coating step, the reaction is fully carried out. Optionally, in the first coating step, the reaction is carried out for about 1.5 hours, about 2 hours, about 3 hours, about 4 hours, about 4.5 hours, or about 5 hours. Optionally, in the first coating step, the reaction time of the reaction may be within any range defined by any of these values.

In some embodiments, in the first coating step, the pH of the solution is controlled to be 4 to 6. Optionally, in the first coating step, the solution is heated to about 55°C, about 60°C, about 70°C, about 80°C, about 90°C, about 100°C, about 110°C, or about 120°C, and kept at that temperature for about 2 hours, about 3 hours, about 4 hours, about 5 hours, about 6 hours, about 7 hours, about 8 hours, about 9 hours, or about 10 hours; and optionally, in the first coating step, the heated-to temperature and the keeping time may be within any ranges defined by any of these values.

In some embodiments, in the first coating step, the sintering may be carried out at about 650°C, about 700°C, about 750°C, or about 800°C for about 2 hours, about 3 hours, about 4 hours, about 5 hours, or about 6 hours; and optionally, the sintering temperature and sintering time may be within any ranges defined by any of these values.

In the first coating step, controlling the sintering temperature and time to be within the foregoing ranges can avoid the following cases: in the first coating step, when the sintering temperature is too low and the sintering time is too short, it results in low crystallinity and a higher proportion of amorphous substances in the first coating layer, and this results in a decrease in the effectiveness of suppressing metal dissolution, thereby affecting the cycling performance and high-temperature storage performance of the secondary battery; however, when the sintering temperature is too high, the first coating layer experiences a heterogeneous phase, which also affects its effectiveness in suppressing metal dissolution, thereby affecting the cycling and high-temperature storage performance and the like of the secondary battery; and when the sintering time is too long, the thickness of the first coating layer is increased, affecting the migration of Li+, thereby affecting the gram capacity utilization, rate performance, and the like of the material.

In some embodiments, in the second coating step, after the source of element M, phosphorus source, and acid are dissolved in the solvent, the solution is stirred and reacted for 1 h to 10 h, heated to a temperature of 60°C to 150°C, kept at that temperature for 2 h to 10 h, and/or, sintered at 500°C to 700°C for 6 hours to 10 hours.

Optionally, in the second coating step, the reaction is fully carried out. Optionally, in the second coating step, the reaction is carried out for about 1.5 hours, about 2 hours, about 3 hours, about 4 hours, about 4.5 hours, about 5 hours, about 6 hours, about 7 hours, about 8 hours, about 9 hours, or about 10 hours. Optionally, in the second coating step, the reaction time of the reaction may be within any range defined by any of these values.

Optionally, in the second coating step, the solution is heated to about 65°C, about 70°C, about 80°C, about 90°C, about 100°C, about 110°C, about 120°C, about 130°C, about 140°C, or about 150°C, and kept at that temperature for about 2 hours, about 3 hours, about 4 hours, about 5 hours, about 6 hours, about 7 hours, about 8 hours, about 9 hours, or about 10 hours; and optionally, in the second coating step, the heated-to temperature and the keeping time may be within any ranges defined by any of these values.

In the step of providing a core material, the first coating step, and the second coating step, prior to sintering, that is, during the preparation of the core material in which chemical reactions take place (step (1) and step (2)) and during the preparation of the first coating layer suspension and the second coating layer suspension, selecting appropriate reaction temperatures and reaction times as described above can avoid the following cases: when the reaction temperature is too low, the reaction cannot occur or the reaction rate is slow; when the temperature is too high, the product decomposes or a heterogeneous phase is formed; when the reaction time is too long, the product particle size is large, which may increase the time and difficulty of subsequent processes; and when the reaction time is too short, the reaction is incomplete and less product is obtained.

Optionally, in the second coating step, the sintering may be carried out at about 550°C, about 600°C, or about 700°C for about 6 hours, about 7 hours, about 8 hours, about 9 hours, or about 10 hours; and optionally, the sintering temperature and sintering time may be within any ranges defined by any of these values.

In the second coating step, controlling the sintering temperature and time to be within the foregoing ranges can avoid the following cases: when the sintering temperature is too low and the sintering time is too short, it results in low crystallinity and a higher proportion of amorphous phase in the second coating layer, and this results in a decrease in the performance of reducing reaction activity on the material surface, thereby affecting the cycling and high-temperature storage performance and the like of the secondary battery; however, when the sintering temperature is too high, the second coating layer experiences a heterogeneous phase, which also affects its effectiveness in reducing reaction activity on the material surface, thereby affecting the cycling and high-temperature storage performance and the like of the secondary battery; and when the sintering time is too long, the thickness of the second coating layer is increased, affecting the voltage plateau of the material, thereby resulting in a decrease in the energy density of the material and the like.

In some embodiments, in the third coating step, the sintering is carried out at 700°C to 800°C for 6 hours to 10 hours. Optionally, in the third coating step, the sintering may be carried out at about 700°C, about 750°C, or about 800°C for about 6 hours, about 7 hours, about 8 hours, about 9 hours, or about 10 hours; and optionally, the sintering temperature and sintering time may be within any ranges defined by any of these values.

In the third coating step, controlling the sintering temperature and time to be within the foregoing ranges can avoid the following cases: when the sintering temperature is too low, it leads to a decrease in the graphitization degree of the third coating layer, affecting the electrical conductivity of the third coating layer and thus affecting the gram capacity utilization of the material; when the sintering temperature is too high, it leads to an excessive degree of graphitization of the third coating layer, affecting the Li⁺ transport, thereby affecting the gram capacity utilization and the like of the material; when the sintering time is too short, it results in an excessively thin coating layer, affecting the electrical conductivity of the coating layer and thereby affecting the gram capacity utilization of the material; and when the sintering time is too long, it results in an excessively thick coating layer, thereby affecting the compacted density and the like of the material.

In the first coating step, the second coating step, and the third coating step described above, the drying is all carried out at 100°C to 200°C, optionally at 110°C to 190°C, more optionally at 120°C to 180°C, further more optionally 120°C to 170°C, and most optionally 120°C to 160°C, with a drying time of 3 h to 9 h, optionally 4 h to 8 h, more optionally 5 h to 7 h, and most optionally about 6 h.

### [Positive electrode plate]

A positive electrode plate typically includes a positive electrode current collector and a positive electrode film layer provided on at least one surface of the positive electrode current collector, where the positive electrode film layer includes the foregoing positive electrode active material or a positive electrode active material prepared in the foregoing method.

For example, the positive electrode current collector includes two opposite surfaces in its thickness direction, and the positive electrode film layer is disposed on either or both of the two opposite surfaces of the positive electrode current collector.

In some embodiments, the positive electrode current collector may be a metal foil current collector or a composite current collector. For example, an aluminum foil may be used as the metal foil. The composite current collector may include a polymer material matrix and a metal layer formed on at least one surface of the polymer material matrix. The composite current collector may be formed by forming a metal material (aluminum, aluminum alloy, nickel, nickel alloy, titanium, titanium alloy, silver, silver alloy, or the like) on a polymer material matrix (for example, matrices of polypropylene (PP), polyethylene terephthalate (PET), polybutylene terephthalate (PBT), polystyrene (PS), and polyethylene (PE)).

In some embodiments, the positive electrode film layer further optionally includes a binder. For example, the binder may include at least one of polyvinylidene fluoride (PVDF), polytetrafluoroethylene (PTFE), vinylidene fluoride-tetrafluoroethylene-propylene terpolymer, vinylidene fluoride-hexafluoropropylene-tetrafluoroethylene terpolymer, tetrafluoroethylene-hexafluoropropylene copolymer, and fluorine-containing acrylic resin.

In some embodiments, the positive electrode film layer further optionally includes a conductive agent. For example, the conductive agent may include at least one of superconducting carbon, acetylene black, carbon black, Ketjen black, carbon dots, carbon nanotubes, graphene, and carbon nanofiber.

In some embodiments, the positive electrode plate may be prepared in the following manner: the foregoing constituents used for preparing the positive electrode plate, for example, the positive electrode active material, the conductive agent, the binder, and any other constituent, are dispersed in a solvent (for example, N-methylpyrrolidone) to form a positive electrode slurry; and the positive electrode slurry is applied onto the positive electrode current collector, followed by processes such as drying and cold pressing to obtain the positive electrode plate.

### [Negative electrode plate]

A negative electrode plate includes a negative electrode current collector and a negative electrode film layer disposed on at least one surface of the negative electrode current collector, where the negative electrode film layer includes a negative electrode active material.

For example, the negative electrode current collector includes two opposite surfaces in its thickness direction, and the negative electrode film layer is disposed on either or both of the two opposite surfaces of the negative electrode current collector.

In some embodiments, the negative electrode current collector may be a metal foil current collector or a composite current collector. For example, a copper foil may be used as the metal foil. The composite current collector may include a polymer material matrix and a metal layer formed on at least one surface of the polymer material matrix. The composite current collector may be formed by forming a metal material (copper, copper alloy, nickel, nickel alloy, titanium, titanium alloy, silver, silver alloy, or the like) on a polymer material matrix (for example, matrices of polypropylene (PP), polyethylene terephthalate (PET), polybutylene terephthalate (PBT), polystyrene (PS), and polyethylene (PE)).

In some embodiments, the negative electrode active material may be a well-known negative electrode active material used for batteries in the art. For example, the negative electrode active material may include at least one of the following materials: artificial graphite, natural graphite, soft carbon, hard carbon, a silicon-based material, a tin-based material, lithium titanate, and the like. The silicon-based material may be selected from at least one of elemental silicon, silicon-oxygen compound, silicon-carbon composite, silicon-nitrogen composite, and silicon alloy. The tin-based material may be selected from at least one of elemental tin, tin-oxygen compound, and tin alloy. However, this application is not limited to these materials, but may use other conventional materials that can be used as negative electrode active materials for batteries instead. One of these negative electrode active materials may be used alone, or two or more of them may be used in combination.

In some embodiments, the negative electrode film layer further optionally includes a binder. For example, the binder may be selected from at least one of styrene-butadiene rubber (SBR), polyacrylic acid (PAA), polyacrylic acid sodium (PAAS), polyacrylamide (PAM), polyvinyl alcohol (PVA), sodium alginate (SA), polymethacrylic acid (PMAA), and carboxymethyl chitosan (CMCS).

In some embodiments, the negative electrode film layer further optionally includes a conductive agent. For example, the conductive agent may be selected from at least one of superconducting carbon, acetylene black, carbon black, Ketjen black, carbon dots, carbon nanotubes, graphene, and carbon nanofiber.

In some embodiments, the negative electrode film layer further optionally includes other promoters such as a thickener (for example, sodium carboxymethyl cellulose (CMC-Na)).

In some embodiments, the negative electrode plate may be prepared in the following manner: the constituents used for preparing the negative electrode plate, for example, the negative electrode active material, the conductive agent, the binder, and any other constituent, are dispersed in a solvent (for example, deionized water) to form a negative electrode slurry; and the negative electrode slurry is applied onto the negative electrode current collector, followed by processes such as drying and cold pressing to obtain the negative electrode plate.

### [Electrolyte]

An electrolyte conducts ions between the positive electrode plate and the negative electrode plate. The electrolyte is not specifically limited to any particular type in this application, and may be selected based on needs. For example, the electrolyte may be in a liquid state, a gel state, or an all-solid state.

In some embodiments, the electrolyte is liquid and includes an electrolytic salt and a solvent.

In some embodiments, the electrolytic salt may be selected from at least one of lithium hexafluorophosphate, lithium tetrafluoroborate, lithium perchlorate, lithium hexafluoroborate, lithium bis(fluorosulfonyl)imide, lithium bis-trifluoromethanesulfon imide, lithium trifluoromethanesulfonate, lithium difluorophosphate, lithium difluorooxalatoborate, lithium bisoxalatoborate, lithium difluorobisoxalate phosphate, and lithium tetrafluoro oxalate phosphate.

In some embodiments, the solvent may be selected from at least one of ethylene carbonate, propylene carbonate, ethyl methyl carbonate, diethyl carbonate, dimethyl carbonate, dipropyl carbonate, methyl propyl carbonate, ethyl propyl carbonate, butylene carbonate, fluoroethylene carbonate, methyl formate, methyl acetate, ethyl acetate, propyl acetate, methyl propionate, ethyl propionate, propyl propionate, methyl butyrate, ethyl butyrate, 1,4-butyrolactone, sulfolane, methyl sulfone, methyl ethyl sulfone, and diethyl sulfone.

In some embodiments, the electrolyte further optionally includes an additive. For example, the additive may include a negative electrode film-forming additive and a positive electrode film-forming additive, or may include an additive that can improve some performance of the battery, for example, an additive for improving overcharge performance of the battery and an additive for improving high-temperature performance or low-temperature performance of the battery.

### [Separator]

In some embodiments, the secondary battery further includes a separator. The separator is not limited to any particular type in this application, and may be any well-known porous separator with good chemical stability and mechanical stability.

In some embodiments, a material of the separator may be selected from at least one of glass fiber, non-woven fabric, polyethylene, polypropylene, and polyvinylidene fluoride. The separator may be a single-layer film or a multi-layer composite film, and is not particularly limited. When the separator is a multi-layer composite film, all layers may be made of same or different materials, which is not particularly limited.

In some embodiments, the positive electrode plate, the negative electrode plate, and the separator may be made into an electrode assembly through winding or lamination.

In some embodiments, the secondary battery may include an outer package. The outer package may be used for packaging the electrode assembly and the electrolyte.

In some embodiments, the outer package of the secondary battery may be a hard shell, for example, a hard plastic shell, an aluminum shell, or a steel shell. The outer package of the secondary battery may alternatively be a soft pack, for example, a soft pouch. A material of the soft pack may be plastic. As the plastic, polypropylene, polybutylene terephthalate, polybutylene succinate, and the like may be listed.

The secondary battery is not limited to any specific shape in this application, and the secondary battery may be cylindrical, rectangular, or of any other shapes. For example, FIG. 2 shows a rectangular secondary battery 5 as an example.

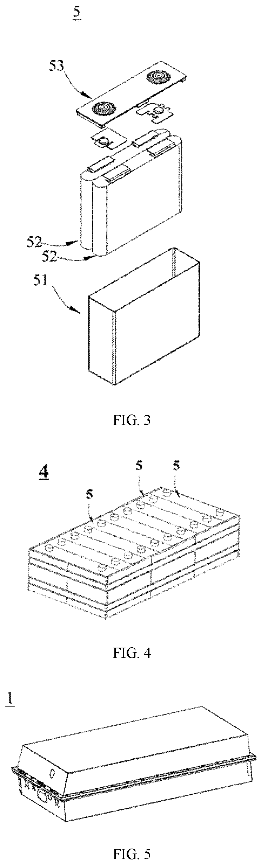

In some embodiments, referring to FIG. 3, the outer package may include a housing 51 and a cover plate 53. The housing 51 may include a base plate and a side plate connected onto the base plate, where the base plate and the side plate enclose an accommodating cavity. The housing 51 has an opening communicating with the accommodating cavity, and the cover plate 53 can cover the opening to close the accommodating cavity. The positive electrode plate, the negative electrode plate, and the separator may be made into an electrode assembly 52 through winding or lamination. The electrode assembly 52 is packaged in the accommodating cavity. The electrolyte infiltrates the electrode assembly 52. The secondary battery 5 may include one or more electrode assemblies 52, and persons skilled in the art may make choices according to actual requirements.

In some embodiments, the secondary battery may be assembled into a battery module, and the battery module may include one or more secondary batteries. The specific quantity may be chosen by persons skilled in the art according to use and capacity of the battery module.

FIG. 4 shows a battery module 4 as an example. Referring to FIG. 4, in the battery module 4, a plurality of secondary batteries 5 may be sequentially arranged along a length direction of the battery module 4. Certainly, the batteries may alternatively be arranged in any other manners. Further, the plurality of secondary batteries 5 may be fixed by fasteners.

Optionally, the battery module 4 may further include an enclosure with an accommodating space, and the plurality of secondary batteries 5 are accommodated in the accommodating space.

In some embodiments, the battery module may be further assembled into a battery pack, and the battery pack may include one or more battery modules. The specific quantity may be chosen by persons skilled in the art according to use and capacity of the battery pack.

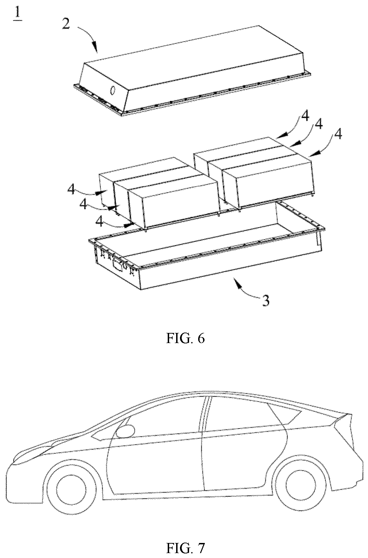

FIG. 5 and FIG. 6 show a battery pack 1 as an example. Referring to FIG. 5 and FIG. 6, the battery pack 1 may include a battery box and a plurality of battery modules 4 arranged in the battery box. The battery box includes an upper box body 2 and a lower box body 3. The upper box body 2 can be engaged with the lower box body 3 to form an enclosed space for accommodating the battery modules 4. The plurality of battery modules 4 may be arranged in the battery box in any manner.

In addition, this application further provides an electric apparatus. The electric apparatus includes at least one of the secondary battery, the battery module, or the battery pack provided in this application. The secondary battery, the battery module, or the battery pack may be used as a power source for the electric apparatus or an energy storage unit of the electric apparatus. The electric apparatus may include a mobile device (for example, a mobile phone or a notebook computer), an electric vehicle (for example, a battery electric vehicle, a hybrid electric vehicle, a plug-in hybrid electric vehicle, an electric bicycle, an electric scooter, an electric golf vehicle, or an electric truck), an electric train, a ship, a satellite system, an energy storage system, or the like, but is not limited thereto.

The secondary battery, the battery module, or the battery pack may be selected for the electric apparatus based on requirements for using the electric apparatus.

FIG. 7 shows an electric apparatus as an example. This electric apparatus is a battery electric vehicle, a hybrid electric vehicle, a plug-in hybrid electric vehicle, or the like. To satisfy requirements of the electric apparatus for high power and high energy density of the secondary battery, a battery pack or a battery module may be used.

### [Examples]

The following describes preparation examples of this application. The preparation examples described below are illustrative and only used for explaining this application, and cannot be construed as limitations on this application. Preparation examples whose technical solutions or conditions are not specified are made in accordance with technical solutions or conditions described in literature in the field or made in accordance with product instructions. The reagents or instruments used are all conventional products that are commercially available if no manufacturer is indicated.

### Preparation of first positive electrode active material

### Preparation example A3: LiNi_{0.55}Co_{0.113}NM_{0.277}Al_{0.04}Mg_{0.02}O₂ (single crystal like)

(1) NiSO₄, CoSO₄, and MnSO₄ were mixed in water at a molar ratio of 0.55:0.113:0.277 to prepare a mixed solution, where the concentration of NiSO₄ in the mixed solution was 2 mol/L. A 5 mol/L NaOH solution was prepared.
(2) 50 L of the mixed solution was added to a reactor. Then, 50 L of the NaOH solution and a proper amount of 0.5 mol/L ammonia solution were added to the reactor. In the reactor, the reaction took place at a pH value of 9.0 to 12.0 and a reaction temperature of 40°C to 80°C. The reaction lasted for 60 h under stirring conditions at a rotation speed of 300 r/min to 1000 r/min. After the reaction was completed, precipitates were filtered out and washed. The precipitates washed were dried in vacuum at 120°C for 24 h to obtain a precursor.
(3) Li₂CO₃, the precursor, Al₂O₃, and MgO were mixed, where a molar ratio of Li₂CO₃ (based on the molar amount of element Li), the precursor (based on the total molar amount of elements Ni, Co, and Mn in the mixed solution), Al₂O₃ (based on the molar amount of element Al), and MgO was 1.05:0.94:0.04:0.02. After mixing, the mixture was placed in a ball mill tank and ball-milled at a rotation speed of 300 r/s for 2 h, and then, the mixture was transferred to a box furnace. In a 0.2 MPa air atmosphere, the mixture was heated to 950°C at a heating rate of 1°C/min and kept at that temperature for 12 h for pre-sintering, and cooled down to 600°C at a rate of 1°C/min and kept at that temperature for 8 h for sintering. After the sintering, the mixture was cooled down to 300°C at a rate of 1°C/min, and further naturally cooled to room temperature. Afterward, the mixture was pulverized by a jet pulverizer at a rotation speed of 3000 r/min and an airflow rate of 500 m³/h for 0.5 h. Then, the mixture was sieved through a 500-mesh sieve to obtain a first positive electrode active material.

### Preparation example A16: LiNi_{0.83}Co_{0.114}Mn_{0.006}Al_{0.04}Mg_{0.01}O₂ (polycrystal)

(1) NiSO₄, CoSO₄, and MnSO₄ were mixed in water at a molar ratio of 0.83:0.114:0.006 to prepare a mixed solution, where the concentration of NiSO₄ in the mixed solution was 2 mol/L. A 6mol/L NaOH solution was prepared.
(2) 50 L of the mixed solution was added to a reactor. Then, 50 L of the NaOH solution and a proper amount of 0.5 mol/L ammonia solution were added to the reactor. In the reactor, the reaction took place at a pH value of 10 to 13 and a reaction temperature of 40°C to 80°C. The reaction lasted for 8 h to 20 h under stirring conditions at a rotation speed of 150 r/min to 300 r/min. After the reaction was completed, precipitates were filtered out and washed. The precipitates washed were dried in vacuum at 120°C for 24 h to obtain a precursor.
(3) LiOH, the precursor, Al₂O₃, and MgO were mixed, where a molar ratio of LiOH, the precursor (based on the total molar amount of elements Ni, Co, and Mn in the mixed solution), Al₂O₃ (based on the molar amount of element Al), and MgO was 1.05:0.95:0.04:0.01. After mixing, the mixture was placed in a ball mill tank and ball-milled at a rotation speed of 500 r/s for 2 h, and then, the mixture was transferred to a box furnace. In a 0.2 MPa air atmosphere, the mixture was heated to 750°C at a heating rate of 20°C/min and kept at that temperature for 20 h for pre-sintering. After sintering, the mixture was cooled down to 300°C at a rate of 1°C/min and further naturally cooled to room temperature. The mixture was crushed for 5 h at a rotation speed of 2000 r/min, and heated to 400 °C at a heating rate of 20°C/min and kept at that temperature for 20 h for sintering. After sintering, the mixture was cooled down to 300°C at a rate of 1°C/min and further naturally cooled to room temperature. Afterward, the mixture was crushed by a jet pulverizer at a rotation speed of 3000 r/min and an airflow rate of 500 m³/h for 0.5 h. Then, the mixture was sieved through a 400-mesh sieve to obtain a first positive electrode active material.

### Preparation examples A1, A2, A4 to A15, and A17 to A22, and comparative preparation example Al

First positive electrode active materials in preparation examples A1, A2, A4 to A11, and A22, and comparative preparation example Al were prepared in the same method as preparation example A3 except for the preparation differences listed in Table 1.

Preparation examples A12 to A15 and A17 to A21 were conducted in the same way as preparation example A16 except for the preparation differences listed in Table 1.

**Table 1 Preparation of first positive electrode active material**

| No. | First positive electrode active material | Crystal type | Raw material in step (1) | Step (2) | Raw material and parameter in step (3) |
|---|---|---|---|---|---|
| Preparation example Al | LiNi_{0.562}CO_{0.115}Mn_{0.283}Al_{0.04}O₂ | Single crystal like | Mixed solution prepared with NiSO₄, CoSO₄, and MnSO₄ at a molar ratio of 0.562:0.115:0.283, the concentration of NiSO₄ being 2 mol/L; and 5 mol/L NaOH solution | Same as preparation example A3 | Li₂CO₃ (based on the molar amount of element Li), the precursor (based on the total molar amount of elements Ni, Co, and Mn in the mixed solution), and Al₂O₃ (based on the molar amount of element aluminum) mixed at a molar ratio of 1.05:0.96:0.04 |
| Preparation example A2 | LiNi_{0.573}CO_{0.118}Mn_{0.289}Mg_{0.02}O₂ | Single crystal like | Mixed solution prepared with NiSO₄, CoSO₄, and MnSO₄ at a molar ratio of 0.573:0.118:0.2893, the concentration of NiSO₄ being 2 mol/L; and 5 mol/L NaOH solution | Same as preparation example A3 | Li₂CO₃ (based on the molar amount of element Li), the precursor (based on the total molar amount of elements Ni, Co, and Mn in the mixed solution), and MgO (based on the molar amount of element Mg) mixed at a molar ratio of 1.05:0.98:0.02 |
| Preparation example A3 | LiNi_{0.55}Co_{0.113}Mn_{0.277}Al_{0.04}Mg_{0.02}O₂ | Single crystal like | Mixed solution prepared with NiSO₄, CoSO₄, and MnSO₄ at a molar ratio of 0.55:0.113:0.277, the concentration of NiSO₄ being 2 mol/L; and 5 mol/L NaOH solution | Same as preparation example A3 | Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 1.05:0.94:0.04:0.02 |
| Preparation example A4 | LiNi_{0.55}Co_{0.047}Mn_{0.343}Al_{0.04}Mg_{0.02}O₂ | Single crystal like | Mixed solution prepared with NiSO₄, CoSO₄, and MnSO₄ at a molar ratio of 0.55:0.047:0.343, the concentration of NiSO₄ being 2 mol/L; and 5 mol/L NaOH solution | Same as preparation example A3 | Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 1.05:0.94:0.04:0.02 |
| Preparation example A5 | LiNi_{0.55}Co_{0.141}Mn_{0.249}Al_{0.04}Mg _{0.02}O₂ | Single crystal like | Mixed solution prepared with NiSO₄, CoSO₄, and MnSO₄ at a molar ratio of 0.55:0.141:0.249, the concentration of NiSO₄ being 2 mol/L; and 5 mol/L NaOH solution | Same as preparation example A3 | Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 1.05:0.94:0.04:0.02 |
| Preparation example A6 | LiNi_{0.55}Co_{0.113}Mn_{0.277}Al_{0.04}Mg_{0.02}O₂ | Single crystal like | Mixed solution prepared with NiSO₄, CoSO₄, and MnSO₄ at a molar ratio of 0.55:0.113:0.277, the concentration of NiSO₄ being 2 mol/L; and 5 mol/L NaOH solution | Same as preparation example A3 except that the pH value in the reactor was 8 to 9 | Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 1.05:0.94:0.04:0.02 |
| Preparation example A7 | LiNi_{0.55}CO_{0.235}Mn_{0.153}Al_{0.04}Mg_{0.02}O₂ | Single crystal like | Mixed solution prepared with NiSO₄, CoSO₄, and MnSO₄ at a molar ratio of 0.55:0.235:0.155, the concentration of NiSO₄ being 2 mol/L; and 5 mol/L NaOH solution | Same as preparation example A3 | Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 1.05:0.94:0.04:0.02 |
| Preparation example A8 | LiNi_{0.55}Mn_{0.39}Al_{0.04}Mg_{0.02}O₂ | Single crystal like | Mixed solution prepared with NiSO₄ and MnSO₄ at a molar ratio of 0.55:0.39, the concentration of NiSO₄ being 2 mol/L; and 5 mol/L NaOH solution | Same as preparation example A3 | Li₂CO₃ (based on the molar amount of element Li), the precursor (based on the total molar amount of elements Ni and Mn in the mixed solution), Al₂O₃ (based on the molar amount of element Al), and MgO mixed at a molar ratio of 1.05:0.94:0.04:0.02 |
| Preparation example A9 | LiNi_{0.314}Co_{0.313}Mn_{0.313}Al_{0.04}Mg_{0.02}O₂ | Single crystal like | Mixed solution prepared with NiSO₄, CoSO₄, and MnSO₄ at a molar ratio of 0.314:0.313:0.313, the concentration of NiSO₄ being 2 mol/L; and 5 mol/L NaOH solution | Same as preparation example A3 | Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 1.05:0.94:0.04:0.02 |
| Preparation example A10 | LiNi_{0.869}Co_{0.048}Mn_{0.033}Al_{0.04}Mg_{0.01}O₂ | Single crystal like | Mixed solution prepared with NiSO₄, CoSO₄, and MnSO₄ at a molar ratio of 0.869:0.048:0.033, the concentration of NiSO₄ being 2 mol/L; and 6 mol/L NaOH solution | Same as preparation example A3 | LiOH, the precursor (based on the total molar amount of elements Ni, Co, and Mn in the mixed solution), Al₂O₃ (based on the molar amount of element Al), and MgO mixed at a molar ratio of 1.05:0.95:0.04:0.01 |
| Preparation example A11 | LiNi_{0.97}Co_{0.005}Mn_{0.01}Al_{0.005}Mg_{0.01}O₂ | Single crystal like | Mixed solution prepared with NiSO₄, CoSO₄, and MnSO₄ at a molar ratio of 0.97:0.005:0.01, the concentration of NiSO₄ being 2 mol/L; and 6 mol/L NaOH solution | Same as preparation example A3 | LiOH, the precursor (based on the total molar amount of elements Ni, Co, and Mn in the mixed solution), Al₂O₃ (based on the molar amount of element aluminum), and MgO mixed at a molar ratio of 1.05:0.985:0.005:0.01 |
| Preparation example A12 | LiNi_{0.34}Co_{0.32}Mn_{0.28}Al_{0.04}Mg_{0.02}O₂ | Polycrystal | Mixed solution prepared with NiSO₄, CoSO₄, and MnSO₄ at a molar ratio of 0.34:0.32:0.28, the concentration of NiSO₄ being 2 mol/L; and 6 mol/L NaOH solution | Same as preparation example A16 except that the pH value in the reactor was 9.5 and that the mixing and reaction lasted for 3 h | Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 1.05:0.94:0.04:0.02; and 10 h of second sintering |
| Preparation example A13 | LiNi_{0.5}CO_{0.282}Mn_{0.158}Al_{0.04}Mg_{0.02}O₂ | Polycrystal | Mixed solution prepared with NiSO₄, CoSO₄, and MnSO₄ at a molar ratio of 0.5:0.282:0.158, the concentration of NiSO₄ being 2 mol/L; and 6 mol/L NaOH solution | Same as preparation example A16 except that the pH value in the reactor was 9 and that the mixing and reaction lasted for 3.5 h | Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 1.05:0.94:0.04:0.02; and 12 h of second sintering |
| Preparation example A14 | LiNi_{0.65}Co_{0.188}Mn_{0.102}Al_{0.04}Mg_{0.02}O₂ | Polycrystal | Mixed solution prepared with NiSO₄, CoSO₄, and MnSO₄ at a molar ratio of 0.65:0.188:0.102, the concentration of NiSO₄ being 2 mol/L; and 6 mol/L NaOH solution | Same as preparation example A16 except that the pH value in the reactor was 9.0 and that the mixing and reaction lasted for 4 h | Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 1.05:0.94:0.04:0.02; and 15 h of second sintering |
| Preparation example A15 | LiNi_{0.65}Co_{0.188}Mn_{0.102}Al_{0.04}Mg_{0.02}O₂ | Polycrystal | Mixed solution prepared with NiSO₄, CoSO₄, and MnSO₄ at a molar ratio of 0.65:0.188:0.102, the concentration of NiSO₄ being 2 mol/L; and 6 mol/L NaOH solution | Same as preparation example A16 | Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 1.05:0.94:0.04:0.02 |
| Preparation example A16 | LiNi_{0.83}Co_{0.114}Mn_{0.006}Al_{0.04}Mg_{0.01}O₂ | Polycrystal | Mixed solution prepared with NiSO₄, CoSO₄, and MnSO₄ at a molar ratio of 0.83:0.114:0.006, the concentration of NiSO₄ being 2 mol/L; and 6 mol/L NaOH solution | Same as preparation example A16 | LiOH, the precursor (based on the total molar amount of elements Ni, Co, and Mn in the mixed solution), Al₂O₃ (based on the molar amount of element Al), and MgO mixed at a molar ratio of 1.05:0.95:0.04:0.01 |
| Preparation example A17 | LiNi_{0.97}Co_{0.005}Mn_{0.01}Al_{0.005}Mg_{0.01}O₂ | Polycrystal | Mixed solution prepared with NiSO₄, CoSO₄, and MnSO₄ at a molar ratio of 0.97:0.005:0.01, the concentration of NiSO₄ being 2 mol/L; and 6 mol/L NaOH solution | Same as preparation example A16 | LiOH, the precursor (based on the total molar amount of elements Ni, Co, and Mn in the mixed solution), Al₂O₃ (based on the molar amount of element Al), and MgO mixed at a molar ratio of 1.05:0.985:0.005:0.01 |
| Preparation example A18 | LiNi_{0.83}Co_{0.114}Mn_{0.006}Al_{0.04}Mg_{0.01}O₂ | Polycrystal | Mixed solution prepared with NiSO₄, CoSO₄, and MnSO₄ at a molar ratio of 0.83:0.114:0.006, the concentration of NiSO₄ being 2 mol/L; and 6 mol/L NaOH solution | Same as preparation example A16 | LiOH, the precursor (based on the total molar amount of elements Ni, Co, and Mn in the mixed solution), Al₂O₃ (based on the molar amount of element Al), and MgO mixed at a molar ratio of 1.05:0.95:0.04:0.01; and 25 h of second sintering |
| Preparation example A19 | LiNi_{0.83}Co_{0.095}Mn_{0.025}Al_{0.04}Mg_{0.01}O₂ | Polycrystal | Mixed solution prepared with NiSO₄, CoSO₄, and MnSO₄ at a molar ratio of 0.83:0.095:0.025, the concentration of NiSO₄ being 2 mol/L; and 6 mol/L NaOH solution | Same as preparation example A16 | LiOH, Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 0.3:0.8:0.95:0.04:0.01 |
| Preparation example A20 | LiNi_{0.83}Co_{0.095}Mn_{0.025}Al_{0.04}Mg_{0.01}O₂ | Polycrystal | Mixed solution prepared with NiSO₄, CoSO₄, and MnSO₄ at a molar ratio of 0.83:0.095:0.025, the concentration of NiSO₄ being 2 mol/L; and 6 mol/L NaOH solution | Same as preparation example A16 | LiOH, Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 0.65:0.45:0.95:0.04:0.01 |
| Preparation example A21 | LiNi₀.₈₃Co_{0.095}Mn_{0.025}Al_{0.04}Mg_{0.01}O₂ | Polycrystal | Mixed solution prepared with NiSO₄, CoSO₄, and MnSO₄ at a molar ratio of 0.83:0.095:0.025, the concentration of NiSO₄ being 2 mol/L; and 6 mol/L NaOH solution | Same as preparation example A16 | LiOH, Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 0.6:0.6:0.95:0.04:0.01 |
| Preparation example A22 | LiNi_{0.869}Co_{0.048}Mn_{0.033}Al_{0.04}Mg_{0.01}O₂ | Single crystal like | Mixed solution prepared with NiSO₄, CoSO₄, and MnSO₄ at a molar ratio of 0.869:0.048:0.033, the concentration of NiSO₄ being 2 mol/L; and 6 mol/L NaOH solution | Same as preparation example A3 | LiOH, Li₂CO₃ (based on the molar amount of element Li), the precursor (based on the total molar amount of elements Ni, Co, and Mn in the mixed solution), Al₂O₃ (based on the molar amount of element Al), and MgO mixed at a molar ratio of 0.6:0.6:0.95:0.04:0.01 |
| Comparative preparation example Al | LiNi_{0.585}Co_{0.12}Mn_{0.295}O₂ | Single crystal like | Mixed solution prepared with NiSO₄, CoSO₄, and MnSO₄ mixed at a molar ratio of 0.585:0.12:0.295, the concentration of NiSO₄ being 2 mol/L; and 5mol/L NaOH solution | Same as preparation example A3 | Li₂CO₃ (based on the molar amount of element Li) and the precursor (based on the total molar amount of elements Ni, Co, and Mn in the mixed solution) mixed at a molar ratio of 1.05:1 |

### Preparation of second positive electrode active material

### Preparation example B1

### Step S1: Preparation of manganese oxalate co-doped with Fe, Co, V, and S

689.6 g of manganese carbonate, 455.27 g of ferrous carbonate, 4.65 g of cobalt sulfate, and 4.87 g of vanadium dichloride were added into a mixer and thoroughly mixed for 6 h. The resulting mixture was transferred into a reactor, 5 L of deionized water and 1260.6 g of oxalic acid dihydrate were added into the reactor, the reactor was heated to 80°C, and the mixture was thoroughly stirred at 500 rpm for 6 h to uniformity until the reaction was terminated without bubbles to obtain a manganese oxalate suspension co-doped with Fe, Co, and V. Then the suspension was filtered, dried at 120°C, and then sanded to obtain manganese oxalate particles with a particle size of 100 nm.

### Step S2: Preparation of core Li_{0.997}Mn_{0.60}Fe_{0.393}V_{0.004}Co_{0.003}P_{0.997}S_{0.003}O₄

1793.1 g of manganese oxalate prepared in (1), 368.3 g of lithium carbonate, 1146.6 g of ammonium dihydrogen phosphate, and 4.9 g of dilute sulfuric acid were added into 20 L of deionized water, and the mixture was thoroughly stirred, mixed to uniformity and reacted at 80°C for 10 h to obtain a slurry. The slurry was transferred to a spray drying device for spray drying and granulation at 250°C to obtain a powder material. The powder material was sintered in a roller kiln for 4 h at 700°C in a protective atmosphere (90% nitrogen and 10% hydrogen) to obtain the core material. The element percentages of the core material were determined using inductively coupled plasma atomic emission spectroscopy (ICP), and the chemical formula of the obtained core was as shown above.

### Step S3: Preparation of first coating layer suspension

Preparation of Li₂FeP₂O₇ solution: 7.4 g of lithium carbonate, 11.6 g of ferrous carbonate, 23.0 g of ammonium dihydrogen phosphate, and 12.6 g of oxalic acid dihydrate were dissolved in 500 mL of deionized water, during which a pH value was controlled to be 5; the mixture was stirred and reacted at room temperature for 2 h to obtain a solution; and then the solution was heated to 80°C and kept at that temperature for 4 h to obtain a first coating layer suspension.

### Step S4: Application of first coating layer

1571.9 g of doped lithium manganese phosphate core material obtained in step S2 was added into the first coating layer suspension (containing 15.7 g of coating substance) obtained in step S3, and the mixture was thoroughly mixed and stirred for 6 h. After mixed to uniformity, the mixture was transferred to an oven for drying at 120°C for 6 h, and then sintered at 650°C for 6 h to obtain a pyrophosphate-coated material.

### Step S5: Preparation of second coating layer suspension

3.7 g of lithium carbonate, 11.6 g of ferrous carbonate, 11.5 g of ammonium dihydrogen phosphate, and 12.6 g of oxalic acid dihydrate were dissolved in 1500 mL of deionized water; the mixture was stirred and reacted for 6 h to obtain a solution; and then the solution was heated to 120°C and kept at that temperature for 6 h to obtain a second coating layer suspension.

### Step S6: Application of second coating layer

1586.8 g of the pyrophosphate-coated material obtained in step S4 was added into the second coating layer suspension (containing 47.1 g of coating substance) obtained in step S5, and the mixture was thoroughly mixed and stirred for 6 h. After mixed to uniformity, the mixture was transferred to an oven for drying at 120°C for 6 h, and then sintered at 700°C for 8 h to obtain a material with two coating layers.

### Step S7: Preparation of third coating layer aqueous solution

37.3 g of sucrose was dissolved in 500 g of deionized water, and then the mixture was stirred and fully dissolved to obtain an aqueous solution of sucrose.

### Step S8: Application of third coating layer

1633.9 g of the material with two coating layers obtained in step S6 was added into the sucrose solution obtained in step S7, and the mixture was stirred and mixed for 6 h. After mixed to uniformity, the mixture was transferred to an oven for drying at 150°C for 6 h, and then sintered at 700°C for 10 h to obtain a material with three coating layers.

### Preparation examples B2 to B52 and comparative preparation examples B1 to B17

Positive electrode active materials in preparation examples B2 to B52 and comparative preparation examples B1 to B17 were prepared in the same method as preparation example B1 except for the differences in the preparation of the positive electrode active materials listed in Tables 2 to 7.

In comparative preparation examples B1 and B2, B4 to B10, and B12, the first layer was not applied, and therefore there were no steps S3 and S4; and in comparative preparation examples B1 to B11, the second layer was not applied, and therefore there were no steps S5 and S6.

**Table 2 Preparation of manganese oxalate co-doped with Fe, Co, V, and S and preparation of core (steps S1 and S2)**

| No. | Chemical formula of core* | Raw materials used in step S1 | Raw materials used in step S2 |
|---|---|---|---|
| Comparative preparation example B1 and comparative preparation example B13 | LiMnPO₄ | Manganese carbonate, 1149.3 g; water, 5 L; oxalic acid dihydrate, 1260.6 g; | Manganese oxalate dihydrate (in terms of C₂O₄Mn·2H₂O) obtained in step S1, 1789.6 g; lithium carbonate, 369.4 g; ammonium dihydrogen phosphate, 1150.1 g; water, 20 L |
| Comparative preparation example B2 | LiMn_{0.60}Fe_{0.40}PO₄ | Manganese carbonate, 689.6 g; ferrous carbonate, 463.4 g; water, 5 L; oxalic acid dihydrate, 1260.6 g; | Ferromanganese oxalate dihydrate (in terms of C₂O₄Mn_{0.60}Fe_{0.40}·2H₂O) obtained in step S1, 1793.2 g; lithium carbonate, 369.4 g; ammonium dihydrogen phosphate 1150.1 g; water, 20 L |
| Comparative preparation example B3 | LiMn_{0.80}Fe_{0.20}PO₄ | Manganese carbonate, 919.4 g; ferrous carbonate, 231.7 g; water, 5 L; oxalic acid dihydrate, 1260.6 g; | Ferromanganese oxalate dihydrate (in terms of C₂O₄Mn_{0.80}Fe_{0.20}·2H₂O) obtained in step S1, 1791.4 g; lithium carbonate, 369.4 g; ammonium dihydrogen phosphate 1150.1 g; water, 20 L |
| Comparative preparation example B4 | LiMn_{0.70}Fe_{0.295}V_{0.005}PO₄ | Manganese carbonate, 804.5 g; ferrous carbonate, 341.8 g; vanadium dichloride, 6.1 g; water, 5 L; oxalic acid dihydrate, 1260.6 g; | Ferromanganese vanadium oxalate dihydrate (in terms of C₂O₄Mn_{0.70}Fe_{0.295}V_{0.005}·2H₂O) obtained in step S1, 1792.0 g; lithium carbonate, 369.4 g; ammonium dihydrogen phosphate, 1150.1 g; water, 20 L |
| Comparative preparation example B5 and comparative preparation example B15 | LiMn_{0.60}Fe_{0.395}Mg_{0.005}PO₄ | Manganese carbonate, 689.6 g; ferrous carbonate, 457.6 g; magnesium carbonate, 4.2 g; water, 5 L; oxalic acid dihydrate, 1260.6 g; | Ferromanganese magnesium oxalate dihydrate (in terms of C₂O₄Mn_{0.60}Fe_{0.395}Mg_{0.005}·2H₂O) obtained in step S1, 1791.6 g; lithium carbonate, 369.4 g; ammonium dihydrogen phosphate, 1150.1 g; water, 20 L |
| Comparative preparation example B6 | LiMn_{0.60}Fe_{0.35}Ni_{0.05}PO₄ | Manganese carbonate, 689.6 g; ferrous carbonate, 405.4 g; nickel carbonate, 59.3 g; water, 5 L; oxalic acid dihydrate, 1260.6 g; | Ferromanganese nickel oxalate dihydrate (in terms of C₂O₄Mn_{0.60}Fe_{0.35}Ni_{0.05}·2H₂O) obtained in step S1, 1794.6 g; lithium carbonate, 369.4 g; ammonium dihydrogen phosphate, 1150.1 g; water, 20 L |
| Comparative preparation example B7 and comparative preparation example B9 | LiMn_{0.60}Fe_{0.395}V_{0.002}Ni_{0.003}PO₄ | Manganese carbonate, 689.6 g; ferrous carbonate, 457.6 g; vanadium dichloride, 2.4 g; nickel carbonate, 3.6 g; water, 5 L; oxalic acid dihydrate, 1260.6 g; | Ferromanganese vanadium nickel oxalate dihydrate (in terms of C₂O₄Mn_{0.60}Fe_{0.395}V_{0.002}Ni_{0.003}·2H₂O) obtained in step S1, 1793.2 g; lithium carbonate, 369.4 g; ammonium dihydrogen phosphate, 1150.1 g; water, 20 L |
| Comparative preparation example B8 | LiMn_{0.60}Fe_{0.395}V_{0.002}Mg_{0.003}PO₄ | Manganese carbonate, 689.6 g; ferrous carbonate, 457.6 g; vanadium dichloride, 2.4 g; magnesium carbonate, 2.53 g; water, 5 L; oxalic acid dihydrate, 1260.6 g; | Ferromanganese vanadium manganese oxalate dihydrate (in terms of C₂O₄Mn_{0.60}Fe_{0.395}V_{0.002}Mg_{0.003}·2H₂O) obtained in step S1, 1792.1 g; lithium carbonate, 369.4 g; ammonium dihydrogen phosphate, 1150.1 g; water, 20 L |
| Comparative preparation examples B10 to B12, comparative preparation examples B16 and B17, and preparation examples B1 to B10, B30 to B42, and B48 to B52 | Li_{0.997}Mn_{0.60}Fe_{0.393}V_{0.004}Co_{0.003}P_{0.997}S_{0.003}O₄ | Manganese carbonate, 689.6 g; ferrous carbonate, 455.3 g; cobalt sulfate, 4.7 g; vanadium dichloride, 4.9 g; water, 5 L; oxalic acid dihydrate, 1260.6 g; | Ferromanganese vanadium cobalt oxalate dihydrate (in terms of C₂O₄Mn_{0.60}Fe_{0.393}V_{0.004}Co_{0.003}·2H₂O) obtained in step S1, 1793.1 g; lithium carbonate, 368.3 g; ammonium dihydrogen phosphate, 1146.6 g; dilute sulfuric acid, 4.9 g; water, 20 L |
| Comparative preparation example B14 | Li_{1.2}MnP_{0.8}Si_{0.2}O₄ | Manganese carbonate, 1149.3 g; water, 5 L; oxalic acid dihydrate, 1260.6 g; | Manganese oxalate dihydrate (in terms of C₂O₄Mn·2H₂O) obtained in step S1, 1789.6 g; lithium carbonate, 443.3 g; ammonium dihydrogen phosphate, 920.1 g; metasilicic acid, 156.2 g; water, 20 L |
| Preparation example B11 | Li_{1.001}Mn_{0.60}Fe_{0.393}V_{0.004}Co_{0.003}P_{0.999}Si_{0.001}O₄ | Manganese carbonate, 689.6 g; ferrous carbonate, 455.3 g; cobalt sulfate, 4.7 g; vanadium dichloride, 4.9 g; water, 5 L; oxalic acid dihydrate, 1260.6 g; | Ferromanganese vanadium cobalt oxalate dihydrate (in terms of C₂O₄Mn_{0.60}Fe_{0.393}V_{0.004}Co_{0.003}·2H₂O) obtained in step S1, 1793.1 g; lithium carbonate, 369.8 g; ammonium dihydrogen phosphate, 1148.9 g; metasilicic acid, 0.8 g; water, 20 L |
| Preparation example B12 | LiMn_{0.60}Fe_{0.393}V_{0.004}Co_{0.003}P_{0.998}N_{0.002}O₄ | Manganese carbonate, 689.6 g; ferrous carbonate, 455.3 g; cobalt sulfate, 4.7 g; vanadium dichloride, 4.9 g; water, 5 L; oxalic acid dihydrate, 1260.6 g; | Ferromanganese vanadium cobalt oxalate dihydrate (in terms of C₂O₄Mn_{0.60}Fe_{0.393}V_{0.004}Co_{0.003}·2H₂O) obtained in step S1, 1793.1 g; lithium carbonate, 369.4 g; ammonium dihydrogen phosphate, 1147.8 g; dilute nitric acid, 2.7 g; water, 20 L |
| Preparation example B13 | Li_{0.995}Mn_{0.65}Fe_{0.341}V_{0.004}Co_{0.005}P_{0.995}S_{0.005}O₄ | Manganese carbonate, 747.1 g; ferrous carbonate, 395.1 g; cobalt sulfate, 7.8 g; vanadium dichloride, 4.9 g; water, 5 L; oxalic acid dihydrate, 1260.6 g; | Ferromanganese vanadium cobalt oxalate dihydrate (in terms of C₂O₄Mn_{0.63}Fe_{0.341}V_{0.004}Co_{0.005}·2H₂O) obtained in step S1, 1792.7 g; lithium carbonate, 367.6 g; ammonium dihydrogen phosphate, 1144.3 g; dilute sulfuric acid, 8.2 g; water, 20 L |
| Preparation example B14 | Li_{1.002}Mn_{0.70}Fe_{0.293}V_{0.004}Co_{0.003}P_{0.998}Si_{0.002}O₄ | Manganese carbonate, 804.6 g; ferrous carbonate, 339.5 g; cobalt sulfate, 4.7 g; vanadium dichloride, 4.9 g; water, 5 L; oxalic acid dihydrate, 1260.6 g; | Ferromanganese vanadium cobalt oxalate dihydrate (in terms of C₂O₄Mn_{0.70}Fe_{0.203}V_{0.004}Co_{0.003}·2H₂O) obtained in step S1, 1792.2 g; lithium carbonate, 370.2 g; 1147.8; metasilicic acid, 1.6 g; water, 20 L |
| Preparation examples B15 and B17 | LiMn_{0.60}Fe_{0.393}V_{0.004}Co_{0.003}P_{0.999}N_{0.001}O₄ | Manganese carbonate, 689.6 g; ferrous carbonate, 455.3 g; cobalt sulfate, 4.7 g; vanadium dichloride, 4.9 g; water, 5 L; oxalic acid dihydrate, 1260.6 g; | Ferromanganese vanadium cobalt oxalate dihydrate (in terms of C₂O₄Mn_{0.60}Fe_{0.393}V_{0.004}Co_{0.003}·2H₂O) obtained in step S1, 1793.1 g; lithium carbonate, 369.4 g; ammonium dihydrogen phosphate, 1148.9 g; dilute nitric acid, 1.4 g; water, 20 L |
| Preparation example B16 | Li_{0.997}Mn_{0.60}Fe_{0.393}V_{0.004}Co_{0.003}P_{0.997}S_{0.003}O₄ | Manganese carbonate, 689.6 g; ferrous carbonate, 455.3 g; cobalt sulfate, 4.7 g; vanadium dichloride, 4.9 g; water, 5 L; oxalic acid dihydrate, 1260.6 g; | Ferromanganese vanadium cobalt oxalate dihydrate (in terms of C₂O₄Mn_{0.60}Fe_{0.393}V_{0.004}Co_{0.003}·2H₂O) obtained in step S1, 1793.1 g; lithium carbonate, 368.7 g; ammonium dihydrogen phosphate, 1146.6 g; dilute sulfuric acid, 4.9 g; water, 20 L |
| Preparation example B18 | LiMn_{0.60}Fe_{0.393}V_{0.004}Mg_{0.003}P_{0.995}N_{0.005}O₄ | Manganese carbonate, 689.6 g; ferrous carbonate, 455.3 g; magnesium carbonate, 2.5 g; vanadium dichloride, 4.9 g; water, 5 L; oxalic acid dihydrate, 1260.6 g; | Ferromanganese vanadium magnesium oxalate dihydrate (in terms of C₂O₄Mn_{0.60}Fe_{0.393}V_{0.004}Mg_{0.003}·2H₂O) obtained in step S1, 1791.1 g; lithium carbonate, 369.4 g; ammonium dihydrogen phosphate, 1144.3 g; dilute nitric acid, 7.0 g; water, 20 L; |
| Preparation example B19 | Li_{0.999}Mn_{0.60}Fe_{0.393}V_{0.004}Mg_{0.003}P_{0.999}S_{0.001}O₄ | Manganese carbonate, 689.6 g; ferrous carbonate, 455.3 g; magnesium carbonate, 2.5 g; vanadium dichloride, 4.9 g; water, 5 L; oxalic acid dihydrate, 1260.6 g; | Ferromanganese vanadium magnesium oxalate dihydrate (in terms of C₂O₄Mn_{0.60}Fe_{0.393}V_{0.004}Mg_{0.003}·2H₂O) obtained in step S1, 1791.1 g; lithium carbonate, 369.0 g; ammonium dihydrogen phosphate, 1148.9 g; dilute sulfuric acid, 1.6 g; water, 20 L |
| Preparation example B20 | Li_{0.998}Mn_{0.60}Fe_{0.393}V_{0.004}Ni_{0.003}P_{0.998}S_{0.002}O₄ | Manganese carbonate, 689.6 g; ferrous carbonate, 455.3 g; nickel carbonate, 3.6 g; vanadium dichloride, 4.9 g; water, 5 L; oxalic acid dihydrate, 1260.6 g; | Ferromanganese vanadium nickel oxalate dihydrate (in terms of C₂O₄Mn_{0.60}Fe_{0.393}V_{0.004}Ni_{0.003}·2H₂O) obtained in step S1, 1792.2 g; lithium carbonate, 368.7 g; ammonium dihydrogen phosphate, 1147.8 g; dilute sulfuric acid, 3.2 g; water, 20 L; |
| Preparation examples B21 to B24 | Li_{1.001}Mn_{0.60}Fe_{0.393}V_{0.004}Ni_{0.003}P_{0.999}Si_{0.001}O₄ | Manganese carbonate, 689.6 g; ferrous carbonate, 455.3 g; nickel carbonate, 3.6 g; vanadium dichloride, 4.9 g; water, 5 L; oxalic acid dihydrate, 1260.6 g; | Ferromanganese vanadium nickel oxalate dihydrate (in terms of C₂O₄Mn_{0.60}Fe_{0.393}V_{0.004}Ni_{0.003}·2H₂O) obtained in step S1, 1793.1 g; lithium carbonate, 369.8 g; ammonium dihydrogen phosphate, 1148.9 g; metasilicic acid, 0.8 g; water, 20 L; |
| Preparation example B25 | Li_{1.001}Mn_{0.50}Fe_{0.493}V_{0.004}Ni_{0.003}P_{0.999}Si_{0.001}O₄ | Manganese carbonate, 574.7 g; ferrous carbonate, 571.2 g; nickel carbonate, 3.6 g; vanadium dichloride, 4.9 g; water, 5 L; oxalic acid dihydrate, 1260.6 g; | Ferromanganese vanadium nickel oxalate dihydrate (in terms of C₂O₄Mn_{0.50}Fe_{0.493}V_{0.004}Ni_{0.003}·2H₂O) obtained in step S1, 1794.0 g; lithium carbonate, 369.8 g; ammonium dihydrogen phosphate, 1148.9 g; metasilicic acid, 0.8 g; water, 20 L; |
| Preparation example B26 | Li_{1.001}Mn_{0.999}Fe_{0.001}P_{0.999}Si_{0.001}O₄ | Manganese carbonate, 1148.2 g; ferrous carbonate, 1.2 g; water, 5 L; oxalic acid dihydrate, 1260.6 g; | Ferromanganese oxalate dihydrate (in terms of C₂O₄Mn_{0.999}Fe_{0.001}·2H₂O) obtained in step S1, 1789.6 g; lithium carbonate, 369.8 g; ammonium dihydrogen phosphate 1148.9 g; metasilicic acid, 0.8 g; water, 20 L; |
| Preparation example B27 | LiMn_{0.60}Fe_{0.393}V_{0.004}Ni_{0.003}P_{0.9}N_{0.100}O₄ | Manganese carbonate, 689.6 g; ferrous carbonate, 455.3 g; nickel carbonate, 3.6 g; vanadium dichloride, 4.9 g; water, 5 L; oxalic acid dihydrate, 1260.6 g; | Ferromanganese vanadium nickel oxalate dihydrate (in terms of C₂O₄Mn_{0.60}Fe_{0.393}V_{0.004}Ni_{0.003}·2H₂O) obtained in step S1, 1793.1 g; lithium carbonate, 369.4 g; ammonium dihydrogen phosphate, 1035.1 g; dilute nitric acid, 140.0 g; water, 20 L; |
| Preparation example B28 | Li_{1.001}Mn_{0.40}Fe_{0.593}V_{0.004}Ni_{0.003}P_{0.999}Si_{0.001}O₄ | Manganese carbonate, 459.7 g; ferrous carbonate, 686.9 g; vanadium dichloride, 4.8 g; nickel carbonate, 3.6 g; water, 5 L; oxalic acid dihydrate, 1260.6 g; | Ferromanganese vanadium nickel oxalate dihydrate (in terms of C₂O₄Mn_{0.40}Fe_{0.593}V_{0.004}Ni_{0.003}·2H₂O) obtained in step S1, 1794.9 g; lithium carbonate, 369.8 g; ammonium dihydrogen phosphate, 1148.9 g; metasilicic acid, 0.8 g; water, 20 L; |
| Preparation example B29 | Li_{1.001}Mn_{0.40}Fe_{0.393}V_{0.204}Ni_{0.003}P_{0.999}Si_{0.001}O₄ | Manganese carbonate, 459.7 g; ferrous carbonate, 455.2 g; vanadium dichloride, 248.6 g; nickel carbonate, 3.6 g; water, 5 L; oxalic acid dihydrate, 1260.6 g; | Ferromanganese vanadium nickel oxalate dihydrate (in terms of C₂O₄Mn_{0.40}Fe_{0.393}V_{0.20}Ni_{0.003}·2H₂O) obtained in step S1, 1785.1 g; lithium carbonate, 369.8 g; ammonium dihydrogen phosphate, 1148.9 g; metasilicic acid, 0.8 g; water, 20 L; |
| Preparation example B43 | Li_{0.900}Mn_{0.40}Fe_{0.393}V_{0.204}Ni_{0.003}P_{0.900}S_{0.100}O₄ | Manganese carbonate, 459.7 g; ferrous carbonate, 455.2 g; vanadium dichloride, 248.6 g; nickel carbonate, 3.6 g; water, 5 L; oxalic acid dihydrate, 1260.6 g; | Ferromanganese vanadium nickel oxalate dihydrate (in terms of C₂O₄Mn_{0.40}Fe_{0.393}V_{0.20}Ni_{0.003}·2H₂O) obtained in step S1, 1785.1 g; lithium carbonate, 332.5 g; ammonium dihydrogen phosphate, 1035.0 g; dilute sulfuric acid, 160 g; water, 20 L; |
| Preparation example B44 | Li_{1.100}Mn_{0.40}Fe_{0.393}V_{0.204}Ni_{0.003}P_{0.900}Si_{0.100}O | Manganese carbonate, 459.7 g; ferrous carbonate, 455.2 g; vanadium dichloride, 248.6 g; nickel carbonate, 3.6 g; water, 5 L; oxalic acid dihydrate, 1260.6 g; | Ferromanganese vanadium nickel oxalate dihydrate (in terms of C₂O₄Mn_{0.40}Fe_{0.393}V_{0.20}Ni_{0.003}·2H₂O) obtained in step S1, 1785.1 g; lithium carbonate, 406.4 g; ammonium dihydrogen phosphate, 1035.0 g; metasilicic acid, 80 g; water, 20 L; |
| Preparation example B45 | Li_{1.001}Mn_{0.909}Fe_{0.091}P_{0.999}Si_{0.001}O₄ | Manganese carbonate, 1044.8 g; ferrous carbonate, 109.2 g; water, 5 L; oxalic acid dihydrate, 1260.6 g; | Ferromanganese oxalate dihydrate (in terms of C₂O₄Mn_{0.909}Fe_{0.091}·2H₂O) obtained in step S1, 1790.7 g; lithium carbonate, 369.8 g; ammonium dihydrogen phosphate 1148.9 g; metasilicic acid, 0.8 g; water, 20 L; |
| Preparation example B46 | LiMn_{0.091}Fe_{0.909}P_{0.995}N_{0.005}O₄ | Manganese carbonate, 104.5 g; ferrous carbonate, 1052.8 g; water, 5 L; oxalic acid dihydrate, 1260.6 g; | Ferromanganese oxalate dihydrate (in terms of C₂O₄Mn_{0.909}Fe_{0.091}·2H₂O) obtained in step S1, 1793.4 g; lithium carbonate, 371.3 g; ammonium dihydrogen phosphate 1138.5 g; dilute nitric acid, 5.25 g; water, 20 L; |
| Preparation example B47 | LiMn_{0.80}Fe_{0.193}V_{0.004}Co_{0.003}P_{0.999}N_{0.001}O₄ | Manganese carbonate, 919.5 g; ferrous carbonate, 223.6 g; cobalt sulfate, 4.7 g; vanadium dichloride, 4.9 g; water, 5 L; oxalic acid dihydrate, 1260.6 g; | Ferromanganese vanadium cobalt oxalate dihydrate (in terms of C₂O₄Mn_{0.80}Fe_{0.193}V_{0.004}Co_{0.003}·2H₂O) obtained in step S1, 1791.6 g; lithium carbonate, 369.4 g; ammonium dihydrogen phosphate, 1148.9 g; dilute nitric acid, 1.4 g; water, 20 L |

| | | | |
|---|---|---|---|
| *For details of the test method, refer to the "material performance test" part below. | | | |

**Table 3 Preparation of first coating layer suspension (Step S3)**

| No. | Coating substance of first coating layer* | Preparation of first coating layer suspension** |
|---|---|---|
| Comparative preparation examples B3 and B16 | Amorphous Li₂FeP₂O₇ | 7.4 g of lithium carbonate; 11.6 g of ferrous carbonate; 23.0 g of ammonium dihydrogen phosphate; 12.6 g of oxalic acid dihydrate; with a pH value controlled to be 5 |
| Comparative preparation examples B11, B13 to B15, and B17, and preparation examples B1 to B14, B19, B21 to B29, and B43 to B52 | Crystalline Li₂FeP₂O₇ | 7.4 g of lithium carbonate; 11.6 g of ferrous carbonate; 23.0 g of ammonium dihydrogen phosphate; 12.6 g of oxalic acid dihydrate; with a pH value controlled to be 5 |
| Preparation examples B15 and B16 | Crystalline Al₄(P₂O₇)₃ | 53.3 g of aluminum chloride; 34.5 g of ammonium dihydrogen phosphate; 18.9 g of oxalic acid dihydrate; with a pH value controlled to be 4 |
| Preparation examples B17, B18, and B20 | Crystalline Li₂NiP₂O₇ | 7.4 g of lithium carbonate; 11.9 g of nickel carbonate; 23.0 g of ammonium dihydrogen phosphate; 12.6 g of oxalic acid dihydrate; with a pH value controlled to be 5 |

| | | |
|---|---|---|
| *For details of the test method, refer to the "material performance test" part below. **When the mass of the coating substance of the first coating layer increases or decreases, the masses of the raw materials used in the first coating layer suspension increase or decrease by the same multiple. | | |

**Table 4 Application of first coating layer (Step S4)**

| No. | Coating substance of first coating layer and amount thereof* (based on weight of core) | Amount of core added in step S4 | Step S4: Application of first coating layer | | | | |
|---|---|---|---|---|---|---|---|
| | | | Amount of corresponding coating substance in first coating layer suspension | Mixing time (h) | Drying temperature (°C) | Sintering temperature (°C) | Sintering time (h) |
| Comparative preparation example B3 | 2% amorphous | 1570.4 g | 31.4 g | 6 | 120 | 500 | 4 |
| | Li₂FeP₂O₇ | | | | | | |
| Comparative preparation example B11 | 1% crystalline | 1571.1 g | 15.7 g | 6 | 120 | 650 | 6 |
| | Li₂FeP₂O₇ | | | | | | |
| Comparative preparation example B13 | 2% crystalline | 1568.5 g | 31.4 g | 6 | 120 | 650 | 6 |
| | Li₂FeP₂O₇ | | | | | | |
| Comparative preparation example B14 | 2% crystalline | 1562.8 g | 31.2 g | 6 | 120 | 650 | 6 |
| | Li₂FeP₂O₇ | | | | | | |
| Comparative preparation example B15 | 2% crystalline | 1570.6 g | 31.4 g | 6 | 120 | 650 | 6 |
| | Li₂FeP₂O₇ | | | | | | |
| Comparative preparation example B16 | 2% amorphous | 1571.1 g | 31.4 g | 6 | 120 | 500 | 4 |
| | Li₂FeP₂O₇ | | | | | | |
| Comparative preparation example B17 | 2% crystalline | 1571.1 g | 31.4 g | 6 | 120 | 650 | 6 |
| | Li₂FeP₂O₇ | | | | | | |
| Comparative preparation examples B1 to B4 and B8 to B10, and preparation examples B45 to B47 and B49 to B52 | 1% Li₂FeP₂O₇ | 1571.9 g | 15.7 g | 6 | 120 | 650 | 6 |
| Preparation example B5 | 2% Li₂FeP₂O₇ | 1571.9 g | 31.4 g | 6 | 120 | 650 | 6 |
| Preparation example B6 | 3% Li₂FeP₂O₇ | 1571.1 g | 47.1 g | 6 | 120 | 650 | 6 |
| Preparation example B7 | 5% Li₂FeP₂O₇ | 1571.9 g | 78.6 g | 6 | 120 | 650 | 6 |
| Preparation example B11 | 1% Li₂FeP₂O₇ | 1572.1 g | 15.7 g | 6 | 120 | 650 | 6 |
| Preparation example B12 | 1% Li₂FeP₂O₇ | 1571.7 g | 15.7 g | 6 | 120 | 650 | 6 |
| Preparation example B13 | 2% Li₂FeP₂O₇ | 1571.4 g | 31.4 g | 6 | 120 | 650 | 6 |
| Preparation example B14 | 2.5% Li₂FeP₂O₇ | 1571.9 g | 39.3 g | 6 | 120 | 650 | 6 |
| Preparation example B15 | 2% Al₄(P₂O₇)₃ | 1571.9 g | 31.4 g | 6 | 120 | 680 | 8 |
| Preparation example B16 | 3% Al₄(P₂O₇)₃ | 1571.9 g | 47.2 g | 6 | 120 | 680 | 8 |
| Preparation example B17 | 1.5% Li₂NiP₂O₇ | 1571.9 g | 23.6 g | 6 | 120 | 630 | 6 |
| Preparation example B18 | 1% Li₂NiP₂O₇ | 1570.1 g | 15.7 g | 6 | 120 | 630 | 6 |
| Preparation example B19 | 2% Li₂FeP₂O₇ | 1571.0 g | 31.4 g | 6 | 120 | 650 | 6 |
| Preparation example B20 | 1% Li₂NiP₂O₇ | 1571.9 g | 15.7 g | 6 | 120 | 630 | 6 |
| Preparation examples B21, B23, and B24 | 2% Li₂FeP₂O₇ | 1572.1 g | 31.4 g | 6 | 120 | 650 | 6 |
| Preparation example B22 | 5.50% Li₂FeP₂O₇ | 1572.1 g | 86.5 g | 6 | 120 | 650 | 6 |
| Preparation example B25 | 1% Li₂FeP₂O₇ | 1573.0 g | 15.7 g | 6 | 120 | 650 | 6 |
| Preparation example B26 | 1% Li₂FeP₂O₇ | 1568.6 g | 15.7 g | 6 | 120 | 650 | 6 |
| Preparation example B27 | 1% Li₂FeP₂O₇ | 1569.2 g | 15.7 g | 6 | 120 | 650 | 6 |
| Preparation example B28 | 2% crystalline | 1573.9 g | 31.4 g | 6 | 120 | 650 | 6 |
| | Li₂FeP₂O₇ | | | | | | |
| Preparation example B29 | 2% crystalline | 1564.1 g | 31.2 g | 6 | 120 | 650 | 6 |
| | Li₂FeP₂O₇ | | | | | | |
| Preparation example B43 | 1% crystalline | 1558.2 g | 15.6 g | 6 | 120 | 650 | 6 |
| | Li₂FeP₂O₇ | | | | | | |
| Preparation example B44 | 1% crystalline | 1568.1 g | 15.7 g | 6 | 120 | 650 | 6 |
| | Li₂FeP₂O₇ | | | | | | |
| Preparation example B48 | 6% crystalline | 1571.9 g | 94.3 g | 6 | 120 | 650 | 6 |
| | Li₂FeP₂O₇ | | | | | | |

| | | | | | | | |
|---|---|---|---|---|---|---|---|
| *For details of the test method, refer to the "material performance test" part below. | | | | | | | |

**Table 5 Preparation of second coating layer suspension (Step S5)**

| No. | Substance of second coating layer* | Step S5: Preparation of second coating layer suspension** |
|---|---|---|
| Comparative preparation example B12 and preparation examples B1 to B14, B18 and B19, B25 to B27, and B43 to B52 | Crystalline LiFePO₄ | 3.7 g of lithium carbonate; 11.6 g of ferrous carbonate; 11.5 g of ammonium dihydrogen phosphate; 12.6 g of oxalic acid dihydrate |
| Comparative preparation examples B13 to B16 and preparation examples B15, B17, B20, B21 to B24, B28, and B29 | Crystalline LiCoPO₄ | 3.7 g of lithium carbonate; 15.5 g of cobalt sulfate; 11.5 g of ammonium dihydrogen phosphate; 12.6 g of oxalic acid dihydrate |
| Comparative preparation example B17 | Amorphous LiCoPO₄ | 3.7 g of lithium carbonate; 15.5 g of cobalt sulfate; 11.5 g of ammonium dihydrogen phosphate; 12.6 g of oxalic acid dihydrate |
| Preparation example B16 | Crystalline LiNiPO₄ | 3.7 g of lithium carbonate; 11.9 g of nickel carbonate; 11.5 g of ammonium dihydrogen phosphate; 12.6 g of oxalic acid dihydrate |

| | | |
|---|---|---|
| *For details of the test method, refer to the "material performance test" part below. * *When the mass of the coating substance of the second coating layer increases or decreases, the masses of the raw materials used in the second coating layer suspension increase or decrease by the same multiple. | | |

**Table 6 Application of second coating layer (Step S6)**

| No. | Substance of second coating layer and amount thereof (based on weight of core)* | Amount of pyrophosphate-coated material added in step S6 (amount of core added in case of comparative example 12) (g) | Step S6: Application of second coating layer | | | | |
|---|---|---|---|---|---|---|---|
| | | | Amount of corresponding coating substance in second coating layer suspension (g) | Mixing time (h) | Drying temperature (°C) | Sintering temperature (°C) | Sintering time (h) |
| Comparative preparation example B12 | 3% LiFePO₄ | 1571.1 | 47.1 | 6 | 120 | 700 | 8 |
| Comparative preparation example B13 | 4% LiCoPO₄ | 1599.9 | 62.7 | 6 | 120 | 750 | 8 |
| Comparative preparation example B14 | 4% LiCoPO₄ | 1594.0 | 62.5 | 6 | 120 | 750 | 8 |
| Comparative preparation example B15 | 4% LiCoPO₄ | 1602.0 | 62.8 | 6 | 120 | 750 | 8 |
| Comparative preparation example B16 | 4% LiCoPO₄ | 1602.5 | 62.8 | 6 | 120 | 750 | 8 |
| Comparative preparation example B17 | 4% amorphous LiCoPO₄ | 1602.5 | 62.8 | 6 | 120 | 650 | 8 |
| Preparation examples B1 to B4, B45 to B48, and B50 to B52 | 3% LiFePO₄ | 1586.8 | 47.1 | 6 | 120 | 700 | 8 |
| Preparation example B5 | 3% LiFePO₄ | 1602.5 | 47.1 | 6 | 120 | 700 | 8 |
| Preparation example B6 | 3% LiFePO₄ | 1618.2 | 47.1 | 6 | 120 | 700 | 8 |
| Preparation example B7 | 3% LiFePO₄ | 1649.6 | 47.1 | 6 | 120 | 700 | 8 |
| Preparation example B8 | 1% LiFePO₄ | 1586.8 | 15.7 | 6 | 120 | 700 | 8 |
| Preparation example B9 | 4% LiFePO₄ | 1586.8 | 62.8 | 6 | 120 | 700 | 8 |
| Preparation example B10 | 5% LiFePO₄ | 1586.8 | 78.6 | 6 | 120 | 700 | 8 |
| Preparation example B11 | 2.50% LiFePO₄ | 1587.8 | 39.3 | 6 | 120 | 700 | 8 |
| Preparation example B12 | 3% LiFePO₄ | 1587.4 | 47.2 | 6 | 120 | 700 | 8 |
| Preparation example B13 | 2% LiFePO₄ | 1602.8 | 31.4 | 6 | 120 | 700 | 8 |
| Preparation example B14 | 3.50% LiFePO₄ | 1610.5 | *55.0* | 6 | 120 | 700 | 8 |
| Preparation example B15 | 2.5% LiCoPO₄ | 1603.3 | 39.3 | 6 | 120 | 750 | 8 |
| Preparation example B16 | 3% LiNiPO₄ | 1619.0 | 47.2 | 6 | 120 | 680 | 8 |
| Preparation example B17 | 2.5% LiCoPO₄ | 1595.5 | 39.3 | 6 | 120 | 750 | 8 |
| Preparation example B18 | 3% LiFePO₄ | 1585.9 | 47.1 | 6 | 120 | 700 | 8 |
| Preparation example B19 | 4% LiFePO₄ | 1602.4 | 62.8 | 6 | 120 | 700 | 8 |
| Preparation example B20 | 3% LiCoPO₄ | 1587.7 | 47.2 | 6 | 120 | 750 | 8 |
| Preparation example B21 | 4% LiCoPO₄ | 1603.5 | 62.9 | 6 | 120 | 750 | 8 |
| Preparation example B22 | 4% LiCoPO₄ | 1658.6 | 62.9 | 6 | 120 | 750 | 8 |
| Preparation example B23 | 5.50% LiCoPO₄ | 1603.5 | 86.5 | 6 | 120 | 750 | 8 |
| Preparation example B24 | 4% LiCoPO₄ | 1603.5 | 62.9 | 6 | 120 | 750 | 8 |
| Preparation example B25 | 3% LiFePO₄ | 1588.7 | 47.2 | 6 | 120 | 700 | 8 |
| Preparation example B26 | 3% LiFePO₄ | 1584.3 | 47.1 | 6 | 120 | 700 | 8 |
| Preparation example B27 | 3% LiFePO₄ | 1584.9 | 47.1 | 6 | 120 | 700 | 8 |
| Preparation example B28 | 4% LiCoPO₄ | 1605.4 | 63.0 | 6 | 120 | 750 | 8 |
| Preparation example B29 | 4% LiCoPO₄ | 1605.4 | 63.0 | 6 | 120 | 750 | 8 |
| Preparation example B43 | 3% LiFePO₄ | 1573.8 | 47.1 | 6 | 120 | 700 | 8 |
| Preparation example B44 | 3% LiFePO₄ | 1583.8 | 47.1 | 6 | 120 | 700 | 8 |
| Preparation example B49 | 6% LiFePO₄ | 1586.8 | 94.2 | 6 | 120 | 700 | 8 |

| | | | | | | | |
|---|---|---|---|---|---|---|---|
| *For details of the test method, refer to the "material performance test" part below. | | | | | | | |

**Table 7 Application of third coating layer (Step S8)**

| No. | Third coating layer* | Molar ratio of SP2 to SP3* | Amount of two-layer-coated material added in step S8 (amount of core added in case of comparative examples 1 and 2, and 4 to 10 and amount of first-layer-coated material added in case of comparative example 11) (g) | Step S8: Application of third coating layer | | | | |
|---|---|---|---|---|---|---|---|---|
| | | | | Amount of sucrose (g) | Mixing time (h) | Drying temperature (°C) | Sintering temperature (°C) | Sintering time (h) |
| Comparative preparation example B1 | 1% carbon | 2.5 | 1568.5 | 37.3 | 6 | 150 | 650 | 8 |
| Comparative preparation example B2 | 2% carbon | 2.8 | 1572.2 | 74.7 | 6 | 150 | 680 | 8 |
| Comparative preparation example B3 | 2% carbon | 2.7 | 1601.8 | 74.6 | 6 | 150 | 680 | 7 |
| Comparative preparation example B4 | 1% carbon | 2.4 | 1571.0 | 37.3 | 6 | 150 | 630 | 8 |
| Comparative preparation example B5 | 1.5% carbon | 2.6 | 1570.6 | 56.0 | 6 | 150 | 650 | 7 |
| Comparative preparation example B6 | 2.5% carbon | 2.8 | 1573.6 | 93.4 | 6 | 150 | 680 | 8 |
| Comparative preparation example B7 | 1% carbon | 2.7 | 1572.2 | 37.3 | 6 | 150 | 680 | 7 |
| Comparative preparation example B8 | 1.5% carbon | 2.9 | 1571.1 | 56.0 | 6 | 150 | 680 | 10 |
| Comparative preparation example B9 | 1% carbon | 2.2 | 1572.2 | 37.3 | 6 | 150 | 600 | 8 |
| Comparative preparation example B10 | 1% carbon | 2.4 | 1571.1 | 37.3 | 6 | 150 | 630 | 8 |
| Comparative preparation example B11 | 1% carbon | 2.3 | 1586.8 | 37.3 | 6 | 150 | 620 | 8 |
| Comparative preparation example B12 | 1% carbon | 2.1 | 1618.2 | 37.3 | 6 | 150 | 600 | 6 |
| Comparative preparation example B13 | 1% carbon | 2 | 1662.6 | 37.3 | 6 | 120 | 600 | 6 |
| Comparative preparation example B14 | 1% carbon | 1.8 | 1656.5 | 37.1 | 6 | 120 | 600 | 6 |
| Comparative preparation example B15 | 1% carbon | 1.7 | 1664.8 | 37.3 | 6 | 100 | 600 | 6 |
| Comparative preparation example B16 | 1% carbon | 3.1 | 1665.4 | 37.3 | 6 | 150 | 700 | 10 |
| Comparative preparation example B17 | 1% carbon | 3.5 | 1665.4 | 37.3 | 6 | 150 | 750 | 10 |
| Preparation examples B1 and B45 to B49 | 1% carbon | 2.2 | 1633.9 | 37.3 | 6 | 150 | 700 | 10 |
| Preparation example B2 | 3% carbon | 2.3 | 1633.9 | 111.9 | 6 | 150 | 600 | 9 |
| Preparation example B3 | 4% carbon | 2.1 | 1633.9 | 149.2 | 6 | 150 | 600 | 6 |
| Preparation example B4 | 5% carbon | 2.4 | 1633.9 | 186.5 | 6 | 150 | 630 | 8 |
| Preparation example B5 | 1% carbon | 2.5 | 1649.6 | 37.3 | 6 | 150 | 650 | 8 |
| Preparation example B6 | 1% carbon | 2.5 | 1665.3 | 37.3 | 6 | 150 | 650 | 8 |
| Preparation example B7 | 1% carbon | 2.4 | 1696.7 | 37.3 | 6 | 150 | 630 | 8 |
| Preparation example B8 | 1% carbon | 2.3 | 1602.5 | 37.3 | 6 | 150 | 600 | 9 |
| Preparation example B9 | 1% carbon | 2.2 | 1649.6 | 37.3 | 6 | 150 | 600 | 8 |
| Preparation example B10 | 1% carbon | 2.2 | 1665.3 | 37.3 | 6 | 150 | 600 | 9 |
| Preparation example B11 | 1.5% carbon | 2.3 | 1629.0 | 56.1 | 6 | 150 | 600 | 9 |
| Preparation example B12 | 2% carbon | 2.4 | 1634.6 | 74.7 | 6 | 150 | 630 | 8 |
| Preparation example B13 | 2% carbon | 2.5 | 1634.2 | 74.6 | 6 | 150 | 650 | 8 |
| Preparation example B14 | 2.5% carbon | 2.7 | 1665.5 | 93.3 | 6 | 150 | 680 | 7 |
| Preparation example B15 | 2% carbon | 2.8 | 1642.6 | 74.7 | 6 | 150 | 680 | 8 |
| Preparation example B16 | 1% carbon | 2.7 | 1666.2 | 37.3 | 6 | 150 | 680 | 7 |
| Preparation example B17 | 1.5% carbon | 2.3 | 1634.8 | 56.0 | 6 | 150 | 600 | 9 |
| Preparation example B18 | 1% carbon | 2.6 | 1633.0 | 37.3 | 6 | 150 | 650 | 7 |
| Preparation example B19 | 1.5% carbon | 2.4 | 1665.2 | 56.0 | 6 | 150 | 630 | 8 |
| Preparation example B20 | 1.5% carbon | 2.2 | 1634.8 | 56.0 | 6 | 150 | 600 | 9 |
| Preparation example B21 | 1% carbon | 2.2 | 1666.4 | 37.3 | 6 | 150 | 600 | 9 |
| Preparation example B22 | 1% carbon | 2.3 | 1721.4 | 37.3 | 6 | 150 | 600 | 9 |
| Preparation example B23 | 1% carbon | 2.4 | 1690.0 | 37.3 | 6 | 150 | 630 | 8 |
| Preparation example B24 | 5.5% carbon | 2.6 | 1666.4 | 205.4 | 6 | 150 | 650 | 7 |
| Preparation example B25 | 1% carbon | 2.4 | 1635.9 | 37.4 | 6 | 150 | 630 | 8 |
| Preparation example B26 | 1% carbon | 2.3 | 1631.3 | 37.3 | 6 | 150 | 600 | 9 |
| Preparation example B27 | 1.5% carbon | 2.1 | 1631.9 | 55.9 | 6 | 150 | 600 | 6 |
| Preparation example B28 | 1% carbon | 0.07 | 1668.3 | 37.4 | 6 | 80 | 600 | 6 |
| Preparation example B29 | 1% carbon | 13 | 1668.3 | 37.4 | 6 | 150 | 850 | 10 |
| Preparation example B43 | 1% carbon | 2.2 | 1620.5 | 37.3 | 6 | 150 | 700 | 10 |
| Preparation example B44 | 1% carbon | 2.2 | 1630.8 | 37.3 | 6 | 150 | 700 | 10 |
| Preparation example B50 | 1% carbon | 0.1 | 1633.9 | 37.3 | 6 | 85 | 600 | 6 |
| Preparation example B51 | 1% carbon | 10 | 1633.9 | 37.3 | 6 | 150 | 800 | 9 |
| Preparation example B52 | 6% carbon | 2.5 | 1633.9 | 223.8 | 6 | 150 | 640 | 8 |

| | | | | | | | | |
|---|---|---|---|---|---|---|---|---|
| *For details of the test method, refer to the "material performance test" part below. | | | | | | | | |

### Preparation examples B30 to B42

Positive electrode active materials in preparation examples B30 to B42 were prepared in the same method as preparation example B1 except for the differences in the preparation of the positive electrode active materials listed in Tables 8 and 9.

**Table 8 Examination of first coating layer substance (preparation examples B30 to B36)**

| No. | Coating substance of first coating layer | Preparation of coating layer suspension |
|---|---|---|
| Preparation example B30 | Li₂MgP₂O₇ | 7.4 g of lithium carbonate, 8.4 g of ferrous carbonate, 23.0 g of ammonium dihydrogen phosphate, and 12.6 g of oxalic acid dihydrate were dissolved in 500 mL of deionized water, during which a pH value was controlled to be 5; the mixture was stirred for 2 h for sufficient reaction to obtain a solution; and then the solution was heated to 80°C and kept at that temperature for 4 h to obtain a suspension |
| Preparation example B31 | Li₂CoP₂O₇ | 7.4 g of lithium carbonate, 15.5 g of cobalt sulfate, 23.0 g of ammonium dihydrogen phosphate, and 12.6 g of oxalic acid dihydrate were dissolved in 500 mL of deionized water, during which a pH value was controlled to be 5; the mixture was stirred for 2 h for sufficient reaction to obtain a solution; and then the solution was heated to 80°C and kept at that temperature for 4 h to obtain a suspension |
| Preparation example B32 | Li₂CuP₂O₇ | 7.4 g of lithium carbonate, 16.0 g of cobalt sulfate, 23.0 g of ammonium dihydrogen phosphate, and 12.6 g of oxalic acid dihydrate were dissolved in 500 mL of deionized water, during which a pH value was controlled to be 5; the mixture was stirred for 2 h for sufficient reaction to obtain a solution; and then the solution was heated to 80°C and kept at that temperature for 4 h to obtain a suspension |
| Preparation example B33 | Li₂ZnP₂O₇ | 7.4 g of lithium carbonate, 12.5 g of zinc carbonate, 23.0 g of ammonium dihydrogen phosphate, and 12.6 g of oxalic acid dihydrate were dissolved in 500 mL of deionized water, during which a pH value was controlled to be 5; the mixture was stirred for 2 h for sufficient reaction to obtain a solution; and then the solution was heated to 80°C and kept at that temperature for 4 h to obtain a suspension |
| Preparation example B34 | TiP₂O₇ | 24.0 g of titanium sulfate, 23.0 g of ammonium dihydrogen phosphate, and 12.6 g of oxalic acid dihydrate were dissolved in 500 mL of deionized water, during which a pH value was controlled to be 5; the mixture was stirred for 2 h for sufficient reaction to obtain a solution; and then the solution was heated to 80°C and kept at that temperature for 4 h to obtain a suspension |
| Preparation example B35 | Ag₄P₂O₇ | 67.9 g of silver nitrate, 23.0 g of ammonium dihydrogen phosphate, and 25.2 g of oxalic acid dihydrate were dissolved in 500 mL of deionized water, during which a pH value was controlled to be 5; the mixture was stirred for 2 h for sufficient reaction to obtain a solution; and then the solution was heated to 80°C and kept at that temperature for 4 h to obtain a suspension |
| Preparation example B36 | ZrP₂O₇ | 56.6 g of zirconium sulfate, 23.0 g of ammonium dihydrogen phosphate, and 25.2 g of oxalic acid dihydrate were dissolved in 500 mL of deionized water, during which a pH value was controlled to be 5; the mixture was stirred for 2 h for sufficient reaction to obtain a solution; and then the solution was heated to 80°C and kept at that temperature for 4 h to obtain a suspension |

**Table 9 Examination of second coating layer substance (preparation examples B37 to B42)**

| No. | Crystalline substance of second coating layer | Preparation of coating layer suspension |
|---|---|---|
| Preparation example B37 | CU₃(PO₄)₂ | 48.0 g of cobalt sulfate, 23.0 g of ammonium dihydrogen phosphate, and 37.8 g of oxalic acid dihydrate were dissolved in 1500 mL of deionized water; the mixture was stirred for 6 h for sufficient reaction to obtain a solution; and then the solution was heated to 120°C and kept at that temperature for 6 h to obtain a suspension |
| Preparation example B38 | Zn₃(PO₄)₂ | 37.6 g of zinc carbonate, 23.0 g of ammonium dihydrogen phosphate, and 37.8 g of oxalic acid dihydrate were dissolved in 1500 mL of deionized water; the mixture was stirred for 6 h for sufficient reaction to obtain a solution; and then the solution was heated to 120°C and kept at that temperature for 6 h to obtain a suspension |
| Preparation example B39 | Ti₃(PO₄)₄ | 72.0 g of titanium sulfate, 46.0 g of ammonium dihydrogen phosphate, and 75.6 g of oxalic acid dihydrate were dissolved in 1500 mL of deionized water; the mixture was stirred for 6 h for sufficient reaction to obtain a solution; and then the solution was heated to 120°C and kept at that temperature for 6 h to obtain a suspension |
| Preparation example B40 | Ag₃PO₄ | 50.9 g of silver nitrate, 11.5 g of ammonium dihydrogen phosphate, and 18.9 g of oxalic acid dihydrate were dissolved in 1500 mL of deionized water; the mixture was stirred for 6 h for sufficient reaction to obtain a solution; and then the solution was heated to 120°C and kept at that temperature for 6 h to obtain a suspension |
| Preparation example B41 | Zr₃(PO₄)₄ | 85.0 g of zirconium sulfate, 46.0 g of ammonium dihydrogen phosphate, and 37.8 g of oxalic acid dihydrate were dissolved in 1500 mL of deionized water; the mixture was stirred for 6 h for sufficient reaction to obtain a solution; and then the solution was heated to 120°C and kept at that temperature for 6 h to obtain a suspension |
| Preparation example B42 | AlPO₄ | 13.3 g of aluminum chloride, 11.5 g of ammonium dihydrogen phosphate, and 18.9 g of oxalic acid dihydrate were dissolved in 1500 mL of deionized water; the mixture was stirred for 6 h for sufficient reaction to obtain a solution; and then the solution was heated to 120°C and kept at that temperature for 6 h to obtain a suspension |

### Preparation of mixed positive electrode active material

### Examples 1 to 49 and comparative example 1

The first positive electrode active material and the second positive electrode material were mixed and blended in a mixing tank. The mass of the first positive electrode material was m₁, the mass of the second positive electrode material was m₂, and the mass of the mixed positive electrode active material was m₁+m₂.

Parameters of the examples and comparative examples are given in Table 10.

**Table 10 Parameters of examples 1 to 49 and comparative example 1**

| No. | First positive electrode active material | Second positive electrode active material | Value of g | m₁/(m₁+m ₂) | g×m₁/(m₁+m ₂) |
|---|---|---|---|---|---|
| Example 1 | Preparation example A1 | Preparation example B25 | 0.562 | 45% | 0.253 |
| Example 2 | Preparation example A2 | Preparation example B25 | 0.573 | 45% | 0.258 |
| Example 3 | Preparation example A3 | Preparation example B25 | 0.550 | 45% | 0.248 |
| Example 4 | Preparation example A4 | Preparation example B25 | 0.550 | 45% | 0.247 |
| Example 5 | Preparation example A5 | Preparation example B25 | 0.550 | 45% | 0.247 |
| Example 6 | Preparation example A6 | Preparation example B25 | 0.550 | 45% | 0.247 |
| Example 7 | Preparation example A7 | Preparation example B25 | 0.550 | 45% | 0.247 |
| Example 8 | Preparation example A8 | Preparation example B25 | 0.550 | 45% | 0.247 |
| Example 9 | Preparation example A9 | Preparation example B25 | 0.314 | 45% | 0.141 |
| Example 10 | Preparation example A10 | Preparation example B25 | 0.869 | 45% | 0.391 |
| Example 11 | Preparation example A11 | Preparation example B25 | 0.970 | 45% | 0.437 |
| Example 12 | Preparation example A12 | Preparation example B25 | 0.340 | 45% | 0.153 |
| Example 13 | Preparation example A13 | Preparation example B25 | 0.500 | 45% | 0.225 |
| Example 14 | Preparation example A14 | Preparation example B25 | 0.650 | 45% | 0.293 |
| Example 15 | Preparation example A15 | Preparation example B25 | 0.650 | 45% | 0.293 |
| Example 16 | Preparation example A16 | Preparation example B25 | 0.830 | 45% | 0.374 |
| Example 17 | Preparation example A17 | Preparation example B25 | 0.970 | 45% | 0.437 |
| Example 18 | Preparation example A18 | Preparation example B25 | 0.830 | 45% | 0.374 |
| Example 19 | Preparation example A19 | Preparation example B25 | 0.830 | 45% | 0.374 |
| Example 20 | Preparation example A20 | Preparation example B25 | 0.830 | 45% | 0.374 |
| Example 21 | Preparation example A21 | Preparation example B25 | 0.830 | 45% | 0.374 |
| Example 22 | Preparation example A22 | Preparation example B25 | 0.869 | 45% | 0.391 |
| Example 23 | Preparation example A16 | Preparation example B25 | 0.830 | 3% | 0.025 |
| Example 24 | Preparation example A16 | Preparation example B25 | 0.830 | 5% | 0.042 |
| Example 25 | Preparation example A16 | Preparation example B25 | 0.830 | 10% | 0.083 |
| Example 26 | Preparation example A16 | Preparation example B25 | 0.830 | 30% | 0.249 |
| Example 27 | Preparation example A16 | Preparation example B25 | 0.830 | 50% | 0.415 |
| Example 28 | Preparation example A16 | Preparation example B25 | 0.830 | 2% | 0.017 |
| Example 29 | Preparation example A16 | Preparation example B25 | 0.830 | 55% | 0.457 |
| Example 30 | Preparation example A15 | Preparation example B26 | 0.650 | 45% | 0.293 |
| Example 31 | Preparation example A15 | Preparation example B27 | 0.650 | 45% | 0.293 |
| Example 32 | Preparation example A15 | Preparation example B28 | 0.650 | 45% | 0.293 |
| Example 33 | Preparation example A15 | Preparation example B15 | 0.650 | 45% | 0.293 |
| Example 34 | Preparation example A15 | Preparation example B34 | 0.650 | 45% | 0.293 |
| Example 35 | Preparation example A15 | Preparation example B4 | 0.650 | 45% | 0.293 |
| Example 36 | Preparation example A15 | Preparation example B7 | 0.650 | 45% | 0.293 |
| Example 37 | Preparation example A15 | Preparation example B8 | 0.650 | 45% | 0.293 |
| Example 38 | Preparation example A15 | Preparation example B31 | 0.650 | 45% | 0.293 |
| Example 39 | Preparation example A15 | Preparation example B40 | 0.650 | 45% | 0.293 |
| Example 40 | Preparation example A15 | Preparation example B42 | 0.650 | 45% | 0.293 |
| Example 41 | Preparation example A15 | Preparation example BIII-13 | 0.650 | 45% | 0.293 |
| Example 42 | Preparation example A15 | Preparation example BIII-16 | 0.650 | 45% | 0.293 |
| Example 43 | Preparation example A15 | Preparation example B43 | 0.650 | 45% | 0.293 |
| Example 44 | Preparation example A15 | Preparation example B44 | 0.650 | 45% | 0.293 |
| Example 45 | Preparation example A15 | Preparation example B45 | 0.650 | 45% | 0.293 |
| Example 46 | Preparation example A15 | Preparation example B46 | 0.650 | 45% | 0.293 |
| Example 47 | Preparation example A15 | Preparation example B47 | 0.650 | 45% | 0.293 |
| Example 48 | Preparation example A15 | Preparation example B48 | 0.650 | 45% | 0.293 |
| Example 49 | Preparation example A15 | Preparation example B52 | 0.650 | 45% | 0.293 |
| Comparative example 1 | Comparative preparation example A1 | Preparation example B25 | 0.585 | 45% | 0.263 |

### Preparation of full battery

The positive electrode active material, a conductive agent acetylene black, and a binder polyvinylidene difluoride (PVDF) at a weight ratio of 92:2.5:5.5 were mixed to uniformity in an N-methylpyrrolidone solvent system, and then the mixture was applied onto an aluminum foil, followed by drying and cold pressing to obtain a positive electrode plate. The application amount was 0.4 g/cm² and the compacted density was 2.4 g/cm³.

A negative electrode active material artificial graphite, hard carbon, a conductive agent acetylene black, a binder styrene-butadiene rubber (SBR), and a thickener sodium carboxymethyl cellulose (CMC) at a weight ratio of 90:5:2:2:1 were mixed to uniformity in deionized water, and then the mixture was applied onto a copper foil, followed by drying and cold pressing to obtain a negative electrode plate. The application amount was 0.2 g/cm² and the compacted density was 1.7 g/cm³.

With a polyethylene (PE) porous polymeric film as a separator, the positive electrode plate, the separator, and the negative electrode plate were stacked in sequence, so that the separator was sandwiched between the positive and negative electrodes for separation, and the stack was wound to obtain a jelly roll. The jelly roll was placed in an outer package, the electrolyte the same as the electrolyte used for preparing the button cell was injected, and the outer package was sealed to obtain a full battery (also referred to as a "full cell" hereinafter).

### Preparation of button battery

The positive electrode active material, polyvinylidene fluoride (PVDF), and acetylene black at a weight ratio of 90:5:5 were added to N-methylpyrrolidone (NMP), and stirred in a drying room to prepare a slurry. The slurry was applied onto an aluminum foil, followed by drying and cold pressing to obtain a positive electrode plate. The application amount was 0.2 g/cm² and the compacted density was 2.0 g/cm³.

A lithium sheet used as the negative electrode, a solution containing ethylene carbonate (EC), diethyl carbonate (DEC), and dimethyl carbonate (DMC) at a volume ratio of 1:1:1 and 1 mol/L LiPF₆ used as the electrolyte, and the prepared positive electrode plate were assembled together in a button cell box to form a button battery (also referred to as a "button cell" hereinafter).

The foregoing positive electrode active material may be the first positive electrode active material, the second positive electrode active material, or a mixed positive electrode active material.

### Material performance test

### 1. Determination of chemical formula of positive electrode active material

An aberration corrected scanning transmission electron microscope (ACSTEM) was used for high spatial resolution characterization of the internal microstructure and surface structure of the positive electrode active material, and the chemical formula of the core and the compositions of the three coating layers of the positive electrode active material were obtained in combination with three-dimensional reconstruction techniques.

### 2. Test method for lattice change rate

At a constant temperature of 25°C, the positive electrode active material samples were placed in an XRD instrument (model: Bruker D8 Discover), and the samples were tested at 1°/min. The test data were organized and analyzed, and the lattice constants a0, b0, c0, and v0 (where a0, b0, and c0 represented the lengths of faces of the unit cell, and v0 was the volume of the unit cell, which could be obtained directly from XRD refinement results) at that point were calculated with reference to the standard PDF card.

The positive electrode active material was prepared into a button cell according to "Preparation of button battery", and the button cell was charged at a small rate of 0.05C until the current was reduced to 0.01C. The positive electrode plate was then taken out from the button cell and placed in DMC for 8 hours, then dried, and scraped for powder, and particles with a particle size less than 500 nm were sifted out from the powder. Samples were taken and subjected to test in the same way as the fresh samples to calculate their lattice constant v1, and (v0-v1)/v0×100% was taken as their lattice change rates before and after complete deintercalation or intercalation of lithium to be listed in the table.

### 3. Test method for Li/Mn antisite defect concentration

The XRD results tested in "test method for lattice change rate" were compared with the standard PDF (Powder Diffraction File) cards of crystals to obtain the Li/Mn antisite defect concentration. Specifically, the XRD results tested in "test method for lattice change rate" were imported into the general structural analysis system (GSAS) software to automatically derive the refinement results, which contained the occupancy of the different atoms, and then the Li/Mn antisite defect concentration was obtained by reading the refinement results.

### 4. Test method for surface oxygen valence

5 g of the positive electrode active material sample was taken for preparation of a button cell according to "Preparation of button battery" as described above. The button cell was charged at a small rate of 0.05C until the current was reduced to 0.01C. The positive electrode plate was then taken out from the button cell and placed in DMC for 8 hours, then dried, and scraped for powder, and particles with a particle size less than 500 nm were sifted out from the powder. The obtained particles were measured using electron energy loss spectroscopy (EELS; the model of the instrument used was Talos F200S) to obtain energy loss near edge structures (ELNES) that reflected the density of states and energy level distribution of elements. Based on the density of states and energy level distribution, the number of occupying electrons was calculated by integrating the data of the valence band density of states to deduce the valence state of surface oxygen after charging.

### 5. Test method for compacted density

5 g of the positive electrode active material powder was taken and put in a special mold for compaction (CARVER mold, model 13 mm, USA), and then the mold was put on a compacted density instrument. A pressure of 3T was applied, the thickness of the powder under the pressure (the thickness after pressure relief) was read on the device, and the compacted density was calculated using p=m/v.

### 6. Test method for dissolution amount of Mn (and Fe doping at Mn site) after cycling

The positive electrode active material sample was prepared into a full battery according to "Preparation of full battery" as described above.

The full battery cycled at 45°C until the capacity faded to 80% was discharged to a cut-off voltage of 2.0 V at 0.1C. The battery was then disassembled, the negative electrode plate was taken out, and 30 discs with a unit area (1540.25 mm²) were randomly taken on the negative electrode plate and tested using Agilent ICP-OES730 for inductively coupled plasma atomic emission spectroscopy (ICP). The amounts of Fe (if the Mn site of the positive electrode active material was doped with Fe) and Mn were calculated from the ICP results, so as to calculate the dissolution amount of Mn (and Fe doped at the Mn site) after cycling. The test standard was in accordance with EPA-6010D-2014.

### 7. Test method for initial gram capacity of button battery

The button battery was charged to 4.3 V at 0.1C under a voltage of 2.5 V to 4.3 V, then constant-voltage charged at 4.3 V to a current less than or equal to 0.05 mA, left standing for 5 min, and then discharged to 2.0 V at 0.1C, and a discharge capacity at that point was an initial gram capacity and recorded as D0.

### 8. Test method for 3C constant current charge ratio

At a constant temperature of 25°C, new full batteries were left standing for 5 min, and then discharged to 2.5 V at 1/3C. The full batteries were left standing for 5 min, charged to 4.3 V at 1/3C, and then constant-voltage charged at 4.3 V to a current less than or equal to 0.05 mA. The full batteries were left standing for 5 min, and a charge capacity at that point was recorded as C0. The full batteries were discharged to 2.5 V at 1/3C, left standing for 5 min, then charged to 4.3 V at 3C, and left standing for 5 min, and a charge capacity at that point was recorded as C1. The 3C constant current charge ratio was C1/C0×100%.

Higher 3C constant current charge ratio indicates better rate performance of the battery.

### 9. Test for cycling performance of full battery at 45°C

At a constant temperature of 45°C, the full batteries were charged to 4.3 V at 1C under a voltage of 2.5 V to 4.3 V, and then constant-voltage charged at 4.3 V to a current less than or equal to 0.05 mA. The full batteries were left standing for 5 min and then discharged to 2.5 V at 1C, and a discharge capacity at that point was recorded as D0. The charge and discharge cycle was repeated until the discharge capacity was reduced to 80% of D0. The number of cycles the battery had undergone at that point was recorded.

### 10. Swelling test for full battery at 60°C

The full batteries at 100% state of charge (SOC) were stored at 60°C. The open circuit voltage (OCV) and alternating current internal resistance (IMP) of the cells were measured before, during, and after storage to monitor the SOCs, and the volumes of the cells were measured. The full batteries were taken out after every 48 h of storage and left standing for 1 h. Then the open circuit voltage (OCV) and internal resistance (IMP) were tested, and the cell volumes were tested in a drainage method after the batteries were cooled to room temperature. In the drainage method, first a scale that automatically performed unit conversion on dial data was used for separately measuring a gravity of the cell, denoted as F₁, then the cell was completely placed into deionized water (density given to be 1 g/cm³), and the gravity of the cell at that time point was measured as F₂. The buoyant force experienced by the cell, denoted as F_{buoyant}, was calculated as F₁-F₂. Then, according to Archimedes' principle, F_{buoyan}t= ρ × g × V_{displaced}, the volume V of the cell could be calculated as V=(F₁-F₂)/(ρ × g).

It can be learned from the OCV and IMP test results that the batteries of the examples always maintained an SOC of above 99% throughout the storage test.

After 30 days of storage, the cell volume was measured and the percentage increases in the cell volume after storage relative to the cell volume before storage was calculated.

In addition, the remaining capacity of the cell was measured. The full battery was charged to 4.3 V at 1C under a voltage of 2.5 V to 4.3 V, then charged at constant voltage of 4.3 V to a current less than or equal to 0.05 mA. The full battery was left standing for 5 min. The charge capacity at that point was recorded as the remaining capacity of the cell.

### 11. Test method for specific surface area (BET)

The specific surface area of the positive electrode active material was tested using a specific surface area and pore size analyzer, TRISTAR II 3020 (manufactured by Micromeritics Instrument Corporation, USA) in accordance with GB/T 19587-2004. Prior to the test, the positive electrode active material was dried at 200°C in a vacuum oven for at least 2 h, and the sample was required to be heavier than 20 g.

### 12. Particle size Dᵥ50 test

The particle size Dᵥ50 of the positive electrode active material was determined using a laser diffraction particle size analyzer, Mastersizer 3000 (manufactured by Malvern Panalytical) in accordance with GB/T19077-2016. Deionized water was used as the solvent, and the positive electrode active material was subjected to ultrasonic treatment for 5 min before the test.

### 13. ICP test (inductively coupled plasma optical emission spectroscopy)

The element percentage was determined using an iCAP 7400 inductively coupled plasma emission spectrometer in accordance with EPA 6010D-2014. The solvent used was aqua regia.

Calculation formula for element percentage in powder: element percentage (wt%)=100%×element mass/sample mass.

Calculation formula for element percentage in electrode plate: element percentage (wt%)=100%×element mass/(sample mass-current collector mass).

### 14. Test for percentage of Li₂CO₃ and LiOH (free lithium potentiometric titration test)

The testing was conducted using a 905 potentiometric titrator in accordance with GB/T 9736-2008. After sampling, the sample was immediately vacuum-sealed in an aluminum-plastic film bag. The minimum sample weight for a single test was greater than or equal to 30 g.

### 15. Crystal type test

Unless otherwise specified, in this application, terms such as "single crystal/single crystal like particle" "quasi-single crystal particle" "single crystal particle", "single crystal material particle" or similar expressions have substantially the similar meaning, referring to an individual particle (namely, primary particle) and/or agglomerated particle. The agglomerated particle is a particle formed by aggregating no more than 100 (particularly about 5 to 50) primary particles with an average particle size of 50 nm to 10,000 nm.

Unless otherwise specified, in this application, terms such as "secondary particle" and "polycrystalline material particle" generally have the similar meaning, referring to a particle formed by agglomerating more than 100 primary particles with an average particle size of 50 nm to 800 nm.

The positive electrode active material was tested using a scanning electron microscope. The sample and magnification were adjusted to have more than 10 agglomerated particles in the field of view. The number of primary particles composing each agglomerated particle was measured, and the size in the length direction of the primary particle was measured using a ruler and recorded as the particle size. The particle sizes of the primary particles in each agglomerated particle were sorted in a descending order, and the largest 1/10 and the smallest 1/10 of the particle size data were removed. The remaining particle size data were averaged to obtain the average particle size of the primary particles in the agglomerated particle. If the number and average particle size of the primary particles in more than 50% (including 50%) of the agglomerated particles meet the definition of "polycrystalline material particle" described above, the positive electrode active material was determined to be a polycrystalline material. Otherwise, it was determined to be a single crystal or single crystal-like material.

### 16. Hot box safety test

The test was conducted in accordance with the "Heating" chapter of GB 38031-2020 for safety test, and the upper boundary was explored. The following are the optimized test conditions.

### (1) Preparation

Test conditions: An explosion-proof drying oven that can be heated and has a line connector was prepared. The cell for test was a fresh jelly roll (cycling count ≤ 10), with temperature sensing wires attached around the cell and poles for temperature monitoring. Temperature recording equipment was also prepared.

Cell treatment before test: The cell was subjected to constant current and constant voltage charge at a rate of 0.33C to charge the cell to the nominal voltage (for example, the voltage is 4.3 V in the present invention).

(2) Test process: The sample was placed in a high-temperature box. The temperature of the box was increased from room temperature to 100°C at a rate of 5°C/min and maintained at that temperature for 2 h. Then, heating was conducted at a temperate rise rate of 5°C/min and maintained at a corresponding temperature after each 5°C rise for 30 min until the cell experienced runaway (the runaway criteria: the voltage decreased by 50% or more within 1 min and the temperature of the cell increased by 50% or more within 1 min) or reached 200°C.

(3) Data processing: Based on the above conditions, the runaway point was determined, and the corresponding temperature and time were recorded as "time@temperature," for example, 21 min@150°C.

### (4) Result benchmarking

A test sample that lasted for a longer time during the test had higher safety. The test sample that lasted for a longer time might be the sample having the same runaway point temperature but a longer time, the sample having the same runaway point time but a higher temperature, and the sample having different runaway point temperatures and times but a higher temperature.

**Table 11 Performance test result of first positive electrode active material**

| No. | First positive electrode active material | g+d+e+f | Mass percentage of Li₂CO₃ | Mass percentage of LiOH | Crystal type | Particle size Dᵥ50 (µm) | Specific surface area (m²/g) | Compacted density @3T (g/cm³) | Cycles at 80% capacity retentio n rate at 45°C | Hot box test |
|---|---|---|---|---|---|---|---|---|---|---|
| Preparation example Al | LiNi_{0.562}Co_{0.115}Mn_{0.283}Al_{0. 04}O₂ | 1 | 0.05% | 0.07% | Single crystal like | 4.1 | 0.68 | 3.18 | 1380 | 25 min @165° C |
| Preparation example A2 | LiNi_{0.573}Co_{0.118}Mn₀₂₈₈Mg_{0 .02}O₂ | 1 | 0.05% | 0.07% | Single crystal like | 4.2 | 0.67 | 3.19 | 1320 | 20 min @162° C |
| Preparation example A3 | LiNi_{0.55}Co_{0.113}Mn_{0.277}Al_{0.0 4}Mg_{0.02}O₂ | 1 | 0.05% | 0.07% | Single crystal like | 4.1 | 0.68 | 3.18 | 1530 | 18 min @165° C |
| Preparation example A4 | LiNi_{0.55}Co_{0.047}Mn_{0.343}Al_{0.0 4}Mg_{0.02}O₂ | 1 | 0.05% | 0.07% | Single crystal like | 3.8 | 0.85 | 3.14 | 1350 | 28 min @166° C |
| Preparation example A5 | LiNi_{0.55}Co_{0.141}Mn_{0.249}Al_{0.0 4}Mg_{0.02}O₂ | 1 | 0.09% | 0.08% | Single crystal like | 2.3 | 1.13 | 3.11 | 1120 | 27 min @162° C |
| Preparation example A6 | LiNi_{0.55}CO_{0.113}Mn_{0.277}Al_{0.0 4}Mg_{0.02}O₂ | 1 | 0.05% | 0.06% | Single crystal like | 5.8 | 0.45 | 3.40 | 1623 | 15 min @167° C |
| Preparation example A7 | LiNi_{0.55}Co_{0.235}Mn_{0.155}Al_{0.0 4}Mg_{0.02}O₂ | 1 | 0.05% | 0.04% | Single crystal like | 4.3 | 0.58 | 3.25 | 1581 | 15 min @167° C |
| Preparation example A8 | LiNi_{0.55}Mn_{0.39}Al_{0.04}Mg_{0.02} O₂ | 1 | 0.07% | 0.04% | Single crystal like | 4.5 | 0.82 | 3.15 | 928 | 18 min @172° C |
| Preparation example A9 | LiNi_{0.314}Co_{0.313}Mn_{0.313}Al_{0. 04}Mg_{0.02}O₂ | 1 | 0.05% | 0.06% | Single crystal like | 4.4 | *0.55* | 3.29 | 1591 | 30 min @175° C |
| Preparation example A10 | LiNi_{0.869}Co_{0.048}Mn_{0.033}Al_{0. 04}Mg_{0.01}O₂ | 1 | 0.22% | 0.25% | Single crystal like | 3.7 | 0.79 | 3.24 | 1153 | 25 min @132° C |
| Preparation example All | LiNi_{0.97}Co_{0.005}Mn_{0.11}Al_{0.00 5}Mg_{0.01}O₂ | 1 | 0.19% | 0.31% | Single crystal like | 3.5 | 1.15 | 3.30 | 755 | 24 min @120° C |
| Preparation example A12 | LiNi_{0.34}Co_{0.32}Mn_{0.28}Al_{0.04} Mg_{0.02}O₂ | 1 | 0.30% | 0.05% | Polycrystal | 3 | 1.73 | 2.90 | 917 | 10 min @178° C |
| Preparation example A13 | LiNi_{0.5}Co_{0.282}Mn_{0.158}Al_{0.04} Mg_{0.02}O₂ | 1 | 0.33% | 0.07% | Polycrystal | 3.5 | 1.32 | 2.92 | 982 | 13 min @180° C |
| Preparation example A14 | LiNi_{0.65}Co_{0.188}Mn_{0.102}Al_{0.0 4}Mg_{0.02}O₂ | 1 | 0.35% | 0.15% | Polycrystal | 4.3 | 1.25 | 3.01 | 1039 | 15 min @155° C |
| Preparation example A15 | LiNi_{0.65}Co_{0.188}Mn₀₁₀₂Al_{0.0 4}Mg_{0.02}O₂ | 1 | 0.33% | 0.14% | Polycrystal | 7.5 | 0.33 | 3.27 | 1247 | 22 min @159° C |
| Preparation example A16 | LiNi_{0.83}Co_{0.114}Mn_{0.006}Al_{0.0 4}Mg_{0.01}O₂ | 1 | 0.08% | 0.38% | Polycrystal | 9.2 | 0.42 | 3.26 | 974 | 21 min @130° C |
| Preparation example A17 | LiNi_{0.97}Co_{0.005}Mn_{0.01}Al_{0.00 5}Mg_{0.01}O₂ | 1 | 0.32% | 0.46% | Polycrystal | 7.3 | 0.38 | 3.23 | 712 | 11 min @122° C |
| Preparation example A18 | LiNi_{0.83}Co_{0.114}Mn_{0.006}Al_{0.0 4}Mg_{0.01}O₂ | 1 | 0.09% | 0.40% | Polycrystal | 13.5 | 0.28 | 3.31 | 995 | 25 min @135° C |
| Preparation example A19 | LiNi_{0.83}Co_{0.095}Mn_{0.025}Al_{0.0 4}Mg_{0.01}O₂ | 1 | 0.20% | 0.70% | Polycrystal | 9.3 | 0.41 | 3.25 | 837 | 18 min @130° C |
| Preparation example A20 | LiNi_{0.83}Co_{0.095}Mn_{0.025}Al_{0.0 4}Mg_{0.01}O₂ | 1 | 0.70% | 0.50% | Polycrystal | 9.2 | 0.42 | 3.26 | 638 | 15 min @130° C |
| Preparation example A21 | LiNi_{0.83}Co_{0.095}Mn_{0.025}Al_{0.0 4}Mg_{0.01}O₂ | 1 | 1.00% | 1.00% | Polycrystal | 9.1 | 0.43 | 3.27 | 510 | 22 min @130° C |
| Preparation example A22 | LiNi_{0.869}Co_{0.048}Mn_{0.033}Al_{0. 04}Mg_{0.01}O₂ | 1 | 1.05% | 1.02% | Single crystal like | 3.5 | 0.83 | 3.11 | 929 | 25 min @131° C |
| Comparative preparation example A1 | LiNi_{0.585}Co_{0.12}Mn_{0.295}O₂ | - | 0.05% | 0.07% | Single crystal like | 4.20 | 0.66 | 3.19 | 735 | 18 min @165° C |

**Table 12 Performance of second positive electrode active material powder and battery performance in preparation examples B1 to B29, B43 to B48, and B52, and comparative preparation examples B1 to B17**

| No. | Performance of positive electrode active material powder | | | | | | Battery performance | | |
|---|---|---|---|---|---|---|---|---|---|
| | Lattice change rate (%) | Li/Mn antisite defect concentration (%) | Compacted density (g/cm³) | Surface oxygen valence | 3C constant current charge ratio (%) | Dissolution amounts of Mn and Fe after cycling (ppm) | **Button** cell capacity at 0.1C (mAh/g) | Cell swelling rate after 30 days of storage at 60°C (%) | Cycles at 80% capacity retention rate at 45°C |
| Comparative preparation example B1 | 11.4 | 5.2 | 1.5 | -1.55 | 50.1 | 2060 | 125.6 | 48.6 | 185 |
| Comparative preparation example B2 | 10.6 | 3.3 | 1.67 | -1.51 | 54.9 | 1810 | 126.4 | 47.3 | 243 |
| Comparative preparation example B3 | 10.8 | 3.4 | 1.64 | -1.64 | 52.1 | 1728 | 144.7 | 41.9 | 378 |
| Comparative preparation example B4 | 4.3 | 2.8 | 1.69 | -1.82 | 56.3 | 1096 | 151.2 | 8.4 | *551* |
| Comparative preparation example B5 | 2.8 | 2.5 | 1.65 | -1.85 | 58.2 | 31 | 148.4 | 7.5 | 668 |
| Comparative preparation example B6 | 3.4 | 2.4 | 1.61 | -1.86 | 58.4 | 64 | 149.6 | 8.6 | 673 |
| Comparative preparation example B7 | 4.5 | 2.4 | 1.73 | -1.83 | 59.2 | 85 | 148.6 | 8.3 | 669 |
| Comparative preparation example B8 | 2.3 | 2.4 | 1.68 | -1.89 | 59.3 | 30 | 152.3 | 7.3 | 653 |
| Comparative preparation example B9 | 2.3 | 2.4 | 1.75 | -1.89 | 59.8 | 30 | 152.3 | 7.3 | 672 |
| Comparative preparation example B10 | 2.3 | 2.2 | 1.81 | -1.9 | 64.1 | 28 | 154.2 | 7.2 | 685 |
| Comparative preparation example B11 | 2.3 | 2.2 | 1.92 | -1.92 | 65.4 | 12 | 154.3 | 5.4 | 985 |
| Comparative preparation example B12 | 2.3 | 2.1 | 1.95 | -1.95 | 65.5 | 18 | 154.6 | 4.2 | 795 |
| Comparative preparation example B13 | 11.4 | 5.2 | 1.63 | -1.96 | 52.4 | 56 | 130.2 | 5.4 | 562 |
| Comparative preparation example B14 | 8.1 | 3.8 | 1.76 | -1.96 | 58.3 | 41 | 135.1 | 5.1 | 631 |
| Comparative preparation example B15 | 2 | 1.8 | 2.13 | -1.96 | 61.3 | 8 | 154.3 | 3.7 | 1126 |
| Comparative preparation example B16 | 2 | 1.9 | 1.95 | -1.96 | 60.5 | 18 | 152.7 | 4.5 | 1019 |
| Comparative preparation example B17 | 2 | 1.9 | 1.9 | -1.89 | 60.4 | 24 | 152.4 | 5.1 | 897 |
| Preparation example B1 | 2.5 | 1.8 | 2.35 | -1.93 | 70.3 | 7 | 157.2 | 4.2 | 1128 |
| Preparation example B2 | 2.5 | 1.8 | 2.24 | -1.94 | 70.2 | 6 | 156.3 | 3.7 | 1253 |
| Preparation example B3 | 2.5 | 1.8 | 2.22 | -1.94 | 70.1 | 5 | 155.4 | 3.4 | 1374 |
| Preparation example B4 | 2.5 | 1.8 | 2.21 | -1.95 | 70.2 | 3 | 153.7 | 2.9 | 1406 |
| Preparation example B5 | 2.5 | 1.8 | 2.33 | -1.93 | 70.1 | 5 | 156.7 | 3.1 | 1501 |
| Preparation example B6 | 2.5 | 1.8 | 2.31 | -1.93 | 69.7 | 4 | 156.2 | 2.8 | 1576 |
| Preparation example B7 | 2.5 | 1.8 | 2.28 | -1.93 | 68.4 | 3 | 155.8 | 2.5 | 1647 |
| Preparation example B8 | 2.5 | 1.8 | 2.29 | -1.93 | 69.1 | 9 | 156.4 | 3.4 | 1058 |
| Preparation example B9 | 2.5 | 1.8 | 2.46 | -1.98 | 73.4 | 6 | 157.6 | 2.9 | 1286 |
| Preparation example B10 | 2.5 | 1.8 | 2.49 | -1.98 | 75.4 | 5 | 157.8 | 2.5 | 1486 |
| Preparation example B11 | 2.6 | 1.9 | 2.38 | -1.97 | 72.4 | 6 | 157.3 | 3.5 | 1026 |
| Preparation example B12 | 2.4 | 1.8 | 2.41 | -1.97 | 74.5 | 4 | 156.3 | 2.5 | 1136 |
| Preparation example B13 | 2.7 | 1.9 | 2.42 | -1.97 | 75.3 | 5 | 156.6 | 3.5 | 1207 |
| Preparation example B14 | 2.8 | 1.9 | 2.45 | -1.97 | 76.5 | 3 | 153.8 | 3.7 | 1308 |
| Preparation example B15 | 2.2 | 1.9 | 2.46 | -1.97 | 74.3 | 3 | 153.8 | 3.7 | 1109 |
| Preparation example B16 | 2.1 | 1.9 | 2.47 | -1.98 | 73.1 | 5 | 154.2 | 3.8 | 1132 |
| Preparation example B17 | 2.5 | 1.7 | 2.41 | -1.98 | 75.3 | 4 | 155.4 | 4.5 | 1258 |
| Preparation example B18 | 2.3 | 1.6 | 2.42 | -1.97 | 76.1 | 4 | 154.3 | 4.7 | 1378 |
| Preparation example B19 | 2.2 | 1.7 | 2.43 | -1.97 | 76.8 | 4 | 154.3 | 4.7 | 1328 |
| Preparation example B20 | 2.6 | 1.8 | 2.42 | -1.94 | 75.4 | 4 | 153.9 | 3.3 | 1458 |
| Preparation example B21 | 2.4 | 1.7 | 2.41 | -1.97 | 76.1 | 4 | 154.5 | 3.5 | 1327 |
| Preparation example B22 | 2.4 | 1.8 | 2.32 | -1.95 | 72.1 | 2 | 152.1 | 2.7 | 1556 |
| Preparation example B23 | 2.3 | 1.7 | 2.46 | -1.96 | 76.4 | 3 | 151.4 | 2.4 | 1645 |
| Preparation example B24 | 2.2 | 1.8 | 2.47 | -1.95 | 76.3 | 3 | 152.1 | 2.5 | 1548 |
| Preparation example B25 | 2.1 | 1.7 | 2.49 | -1.98 | 78.4 | 3 | 158.6 | 2.9 | 1538 |
| Preparation example B26 | 3.6 | 2.5 | 2.21 | -1.97 | 56.4 | 8 | 152.3 | 4.8 | 1017 |
| Preparation example B27 | 2.8 | 2.1 | 2.24 | -1.98 | 74.3 | 6 | 155.4 | 3.8 | 1126 |
| Preparation example B28 | 2.5 | 1.9 | 1.95 | -1.94 | 54.7 | 9 | 154.9 | 6.4 | 986 |
| Preparation example B29 | 2.4 | 1.8 | 1.98 | -1.95 | 68.4 | 7 | 155.6 | 4.5 | 1047 |
| Preparation example B43 | 2.4 | 2.3 | 2.25 | -1.95 | 76.3 | 15 | 139.86 | 3.4 | 1068 |
| Preparation example B44 | 4.6 | 2 | 2.33 | -1.85 | 75.2 | 85 | 156.8 | 8 | 651 |
| Preparation example B45 | 5.3 | 2.8 | 2.31 | -1.72 | 72.1 | 133 | 137.2 | 9.3 | 627 |
| Preparation example B46 | 2.1 | 0.4 | 2.45 | -1.99 | 78.3 | 5 | 159 | 1632 | 1632 |
| Preparation example B47 | 3 | 2 | 2.45 | -1.97 | 74.2 | 12 | 150.3 | 4.5 | 1107 |
| Preparation example B48 | 2.5 | 1.8 | 2.25 | -1.93 | 67.4 | 3 | 154.2 | 2.2 | 1691 |
| Preparation example B52 | 2.5 | 1.8 | 2.2 | -0.194 | 70.3 | 3 | 152.6 | 2.6 | 1468 |

As can be seen in Table 12, compared with the comparative examples, the preparation examples of this application achieve smaller lattice change rate, smaller Li/Mn antisite defect concentration, greater compacted density, surface oxygen valence closer to -2 valence, less dissolving-out Mn and Fe after cycling, and better battery performance, for example, better high-temperature storage performance, and high-temperature cycling performance.

**Table 13 Thickness of each layer and weight ratio of element manganese to element phosphorus, for the second positive electrode active materials prepared in preparation examples B1 to B14 and comparative examples B3, B4, and B12**

| No. | Core | First coating layer | Second coating layer | Third coating layer | Thickness of first coating layer (nm) | Thickness of second coating layer (nm) | Thickness of third coating layer (nm) | Percentage of element Mn (wt%) | Weight ratio of element Mn to element P |
|---|---|---|---|---|---|---|---|---|---|
| Comparative preparation example B3 | LiMn_{0.80}Fe_{0.20}PO₄ | 2% amorphous Li₂FeP₂O₇ | - | 2% carbon | 4 | - | 10 | 26.1 | 1.383 |
| Comparative preparation example B4 | LiMn_{0.70}Fe_{0.295}V_{0.005}PO₄ | - | - | 1% carbon | - | - | 5 | 24.3 | 1.241 |
| Comparative preparation example B12 | Li_{0.999}Mn_{0.60}Fe_{0.393}V_{0.004}Co_{0.00 3}P_{0.999}S_{0.001}O₄ | - | 3% crystalline LiFePO₄ | 1% carbon | - | 7.5 | 5 | 19.6 | 1.034 |
| Preparation example B1 | Li_{0.997}Mn_{0.60}Fe_{0.393}V_{0.004}Co_{0.00 3}P_{0.997}S_{0.003}O₄ | 1% Li₂FeP₂O₇ | 3% LiFePO₄ | 1% carbon | 2 | 7.5 | 5 | 19.0 | 1.023 |
| Preparation example B2 | Li_{0.997}Mn_{0.60}Fe_{0.393}V_{0.004}Co_{0.00 3}P_{0.997}S_{0.003}O₄ | 1% Li₂FeP₂O₇ | 3% LiFePO₄ | 3% carbon | 2 | 7.5 | 15 | 18.3 | 1.023 |
| Preparation example B3 | Li_{0.997}Mn_{0.60}Fe_{0.393}V_{0.004}Co_{0.00 3}P_{0.997}S_{0.003}O₄ | 1% Li₂FeP₂O₇ | 3% LiFePO₄ | 4% carbon | 2 | 7.5 | 20 | 18.0 | 1.023 |
| Preparation example B4 | Li_{0.997}Mn_{0.60}Fe_{0.393}V_{0.004}Co_{0.00 3}P_{0.997}S_{0.003}O₄ | 1% Li₂FeP₂O₇ | 3% LiFePO₄ | 5% carbon | 2 | 7.5 | 25 | 17.9 | 1.023 |
| Preparation example B5 | Li_{0.997}Mn_{0.60}Fe_{0.393}V_{0.004}Co_{0.00 3}P_{0.997}S_{0.003}O₄ | 2% Li₂FeP₂O₇ | 3% LiFePO₄ | 1% carbon | 4 | 7.5 | 5 | 18.7 | 1.011 |
| Preparation example B6 | Li_{0.997}Mn_{0.60}Fe_{0.393}V_{0.004}Co_{0.00 3}P_{0.997}S_{0.003}O₄ | 3% Li₂FeP₂O₇ | 3% LiFePO₄ | 1% carbon | 6 | 7.5 | 5 | 18.3 | 0.999 |
| Preparation example B7 | Li_{0.997}Mn_{0.60}Fe_{0.393}V_{0.004}Co_{0.00 3}P_{0.997}S_{0.003}O₄ | 5% Li₂FeP₂O₇ | 3% LiFePO₄ | 1% carbon | 10 | 7.5 | 5 | 17.6 | 0.975 |
| Preparation example B8 | Li_{0.997}Mn_{0.60}Fe_{0.393}V_{0.004}Co_{0.00 3}P_{0.997}S_{0.003}O₄ | 1% Li₂FeP₂O₇ | 1% LiFePO₄ | 1% carbon | 2 | 2.5 | 5 | 19.8 | 1.043 |
| Preparation example B9 | Li_{0.997}Mn_{0.60}Fe_{0.393}V_{0.004}Co_{0.00 3}P_{0.997}S_{0.003}O₄ | 1% Li₂FeP₂O₇ | 4% LiFePO₄ | 1% carbon | 2 | 10 | 5 | 18.7 | 1.014 |
| Preparation example B10 | Li_{0.997}Mn_{0.60}Fe_{0.393}V_{0.004}Co_{0.00 3}P_{0.997}S_{0.003}O₄ | 1% Li₂FeP₂O₇ | 5% LiFePO₄ | 1% carbon | 2 | 12.5 | 5 | 18.4 | 1.004 |
| Preparation example B11 | Li_{1.001}Mn_{0.60}Fe_{0.393}V_{0.004}Co_{0.00 3}P_{0.999}Si_{0.001}O₄ | 1% Li₂FeP₂O₇ | 2.50% LiFePO₄ | 1.5% carbon | 2 | 6.3 | 7.5 | 19.0 | 1.026 |
| Preparation example B13 | Li_{0.995}Mn_{0.65}Fe_{0.341}V_{0.}004COO. 00 ₅P_{0.995}S_{0.005}O₄ | 2% Li₂FeP₂O₇ | 2% LiFePO₄ | 2% carbon | 4 | 5 | 10 | 18.7 | 1.108 |
| Preparation example B14 | Li_{1.002}Mn_{0.70}Fe_{0.293}V_{0.004}Co_{0.00 3}P_{0.998}Si_{0.002}O₄ | 2.5% Li₂FeP₂O₇ | 3.50% LiFePO₄ | 2.5% carbon | 5 | 8.8 | 12.5 | 17.8 | 1.166 |

As can be seen from Table 13, by doping the manganese and phosphorus sites of lithium manganese iron phosphate (containing 35% manganese and about 20% phosphorus) and applying three layers of coating, the proportion of element manganese and the weight ratio of element manganese to element phosphorus in the positive electrode active material are significantly reduced; furthermore, comparing preparation examples B1 to B14 with comparative preparation examples B3, B4, and B12, it can be learned from Table 13 that the decrease of elements manganese and phosphorus in the positive electrode active material leads to the decrease of the dissolution amounts of manganese and iron and suppresses the improvement of the battery performance of the secondary batteries prepared therefrom.

**Table 14 Performance of second positive electrode active material powder and battery performance in preparation examples B30 to B42**

| Preparation example No. | Performance of positive electrode active material powder | | | | | | Battery performance | | |
|---|---|---|---|---|---|---|---|---|---|
| | Lattice change rate (%) | Li/Mn antisite defect concentration (%) | Compacted density (g/cm³) | Surface oxygen valence | 3C constant current charge ratio (%) | Dissolution amounts of Mn and Fe after cycling (ppm) | Button battery capacity at 0.1C | Cell swelling rate after 30 days of storage at 60°C (%) | Cycles at 80% capacity retention rate at 45°C |
| Preparation example B1 | 2.5 | 1.8 | 2.35 | -1.93 | 70.3 | 7 | 157.2 | 4.2 | 1128 |
| Preparation example B30 | 2.4 | 1.9 | 2.36 | -1.97 | 68.7 | 15 | 156.2 | 4.8 | 1018 |
| Preparation example B31 | 2.5 | 1.7 | 2.36 | -1.96 | 70.1 | 12 | 155.6 | 4.6 | 1087 |
| Preparation example B32 | 2.5 | 1.7 | 2.38 | -1.97 | 69.1 | 14 | 155.9 | 4.3 | 1054 |
| Preparation example B33 | 2.6 | 1.8 | 2.39 | -1.98 | 69.4 | 23 | 156.2 | 5.3 | 997 |
| Preparation example B34 | 2.6 | 1.9 | 2.34 | -1.96 | 71.3 | 16 | 156.4 | 4.6 | 1004 |
| Preparation example B35 | 2.4 | 1.7 | 2.36 | -1.94 | 70.9 | 11 | 157.5 | 5.1 | 1102 |
| Preparation example B36 | 2.5 | 1.9 | 2.33 | -1.92 | 71.6 | 14 | 155.8 | 5.4 | 1024 |
| Preparation example B37 | 2.5 | 1.7 | 2.34 | -1.92 | 68.4 | 18 | 156.1 | 4.9 | 1054 |
| Preparation example B38 | 2.4 | 1.9 | 2.33 | -1.95 | 67.5 | 27 | 154.7 | 5.9 | 954 |
| Preparation example B39 | 2.2 | 1.8 | 2.36 | -1.94 | 69.4 | 24 | 156.4 | 5.7 | 1017 |
| Preparation example B40 | 2.4 | 1.9 | 2.37 | -1.91 | 71.6 | 31 | 155.8 | 5.3 | 991 |
| Preparation example B41 | 2.6 | 1.9 | 2.38 | -1.94 | 70.8 | 27 | 154.8 | 5.1 | 975 |
| Preparation example B42 | 2.4 | 1.9 | 2.36 | -1.92 | 71.5 | 15 | 156.8 | 4.2 | 1154 |

As can be seen from Table 14, the use of the first coating layer and the second coating layer containing other elements within the scope of this application has also obtained positive electrode active materials with good performance and achieved good battery performance results.

**Table 15 Interplanar spacings and included angles of first coating layer and second coating layer in second positive electrode active material**

| No. | Interplanar spacing of first coating layer substance | Included angle of first coating layer substance in [111] crystal orientation | Interplanar spacing of second coating layer substance | Included angle of second coating layer substance in [111] crystal orientation |
|---|---|---|---|---|
| Preparation example B1 | 0.303 | 29.496 | 0.348 | 25.562 |
| Preparation example B30 | 0.451 | 19.668 | 0.348 | 25.562 |
| Preparation example B31 | 0.297 | 30.846 | 0.348 | 25.562 |
| Preparation example B32 | 0.457 | 19.456 | 0.348 | 25.562 |
| Preparation example B33 | 0.437 | 20.257 | 0.348 | 25.562 |
| Preparation example B34 | 0.462 | 19.211 | 0.348 | 25.562 |
| Preparation example B35 | 0.450 | 19.735 | 0.348 | 25.562 |
| Preparation example B36 | 0.372 | 23.893 | 0.348 | 25.562 |
| Preparation example B37 | 0.303 | 29.496 | 0.374 | 23.789 |
| Preparation example B38 | 0.303 | 29.496 | 0.360 | 24.710 |
| Preparation example B39 | 0.303 | 29.496 | 0.350 | 25.428 |
| Preparation example B40 | 0.303 | 29.496 | 0.425 | 20.885 |
| Preparation example B41 | 0.303 | 29.496 | 0.356 | 24.993 |
| Preparation example B42 | 0.303 | 29.496 | 0.244 | 36.808 |

As can be seen from Table 15, the interplanar spacings and included angles of the first coating layer and second coating layer in this application are within the ranges given in this application.

### Examination of influence of sintering method of coating layer on performance of second positive electrode active material

The battery preparation in the preparation examples and comparative preparation examples in Table 16 is the same as that in preparation example B1 except for the differences in method parameters used in the following table. The results are given in Table 16.

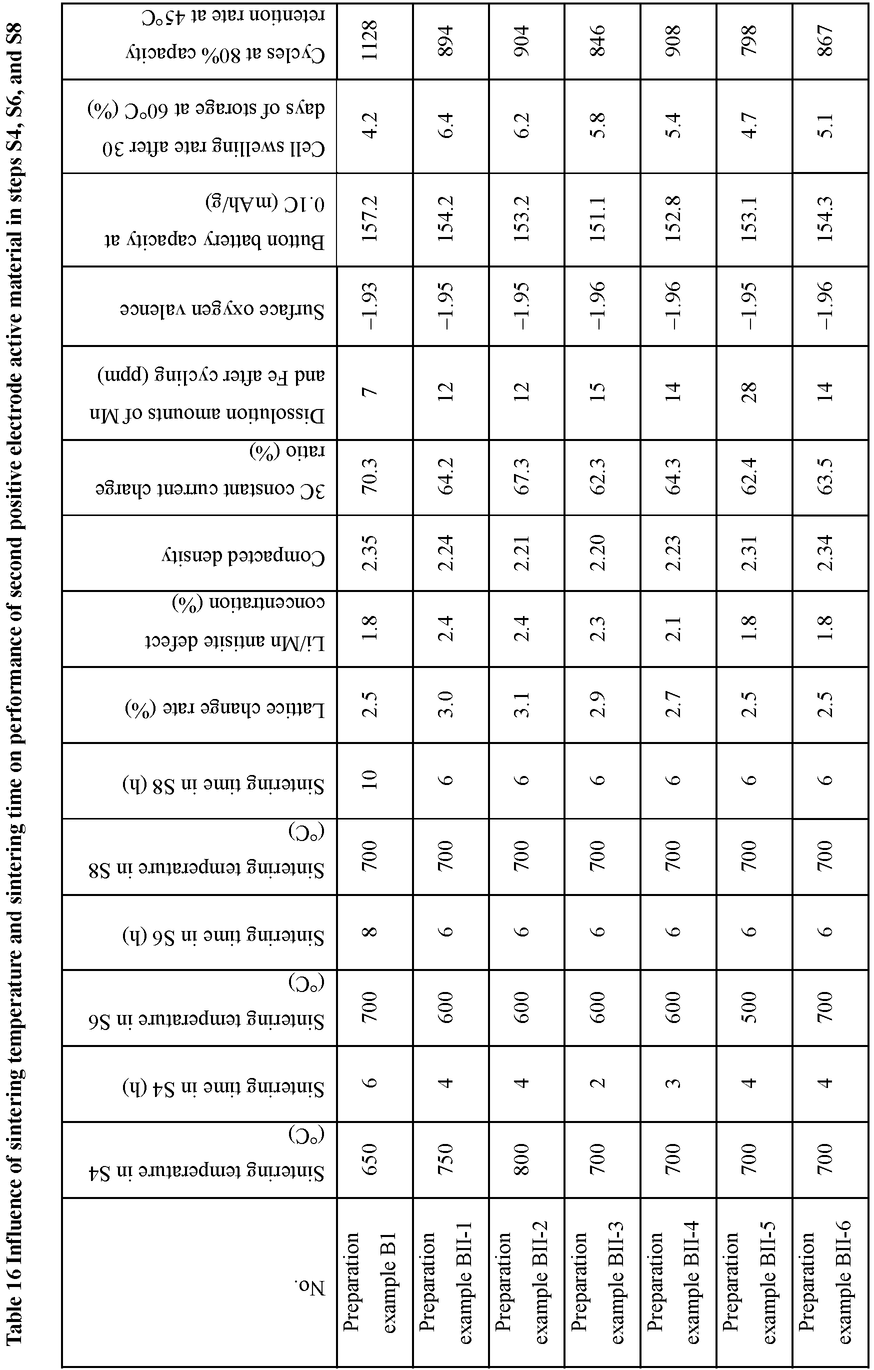

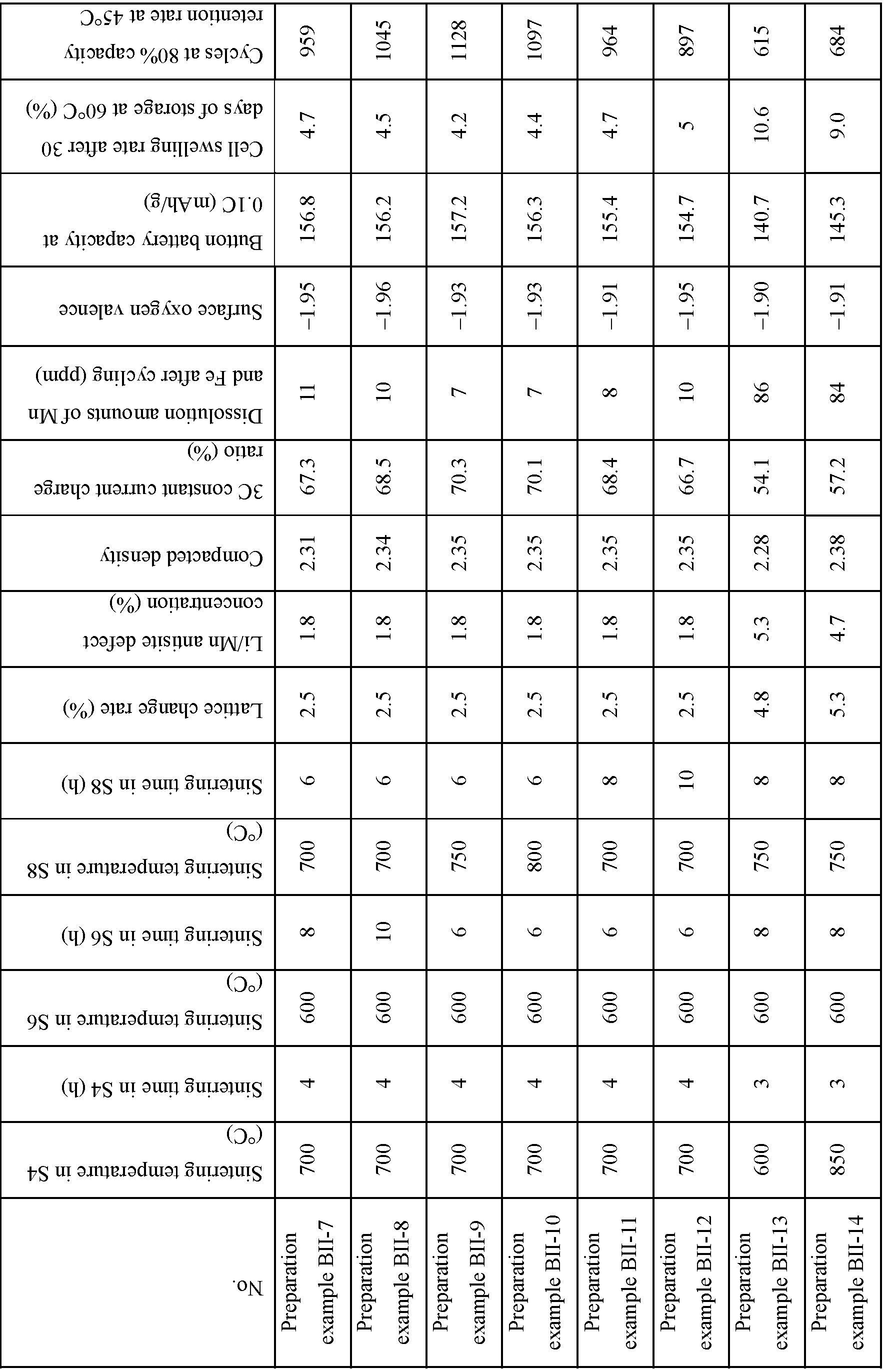

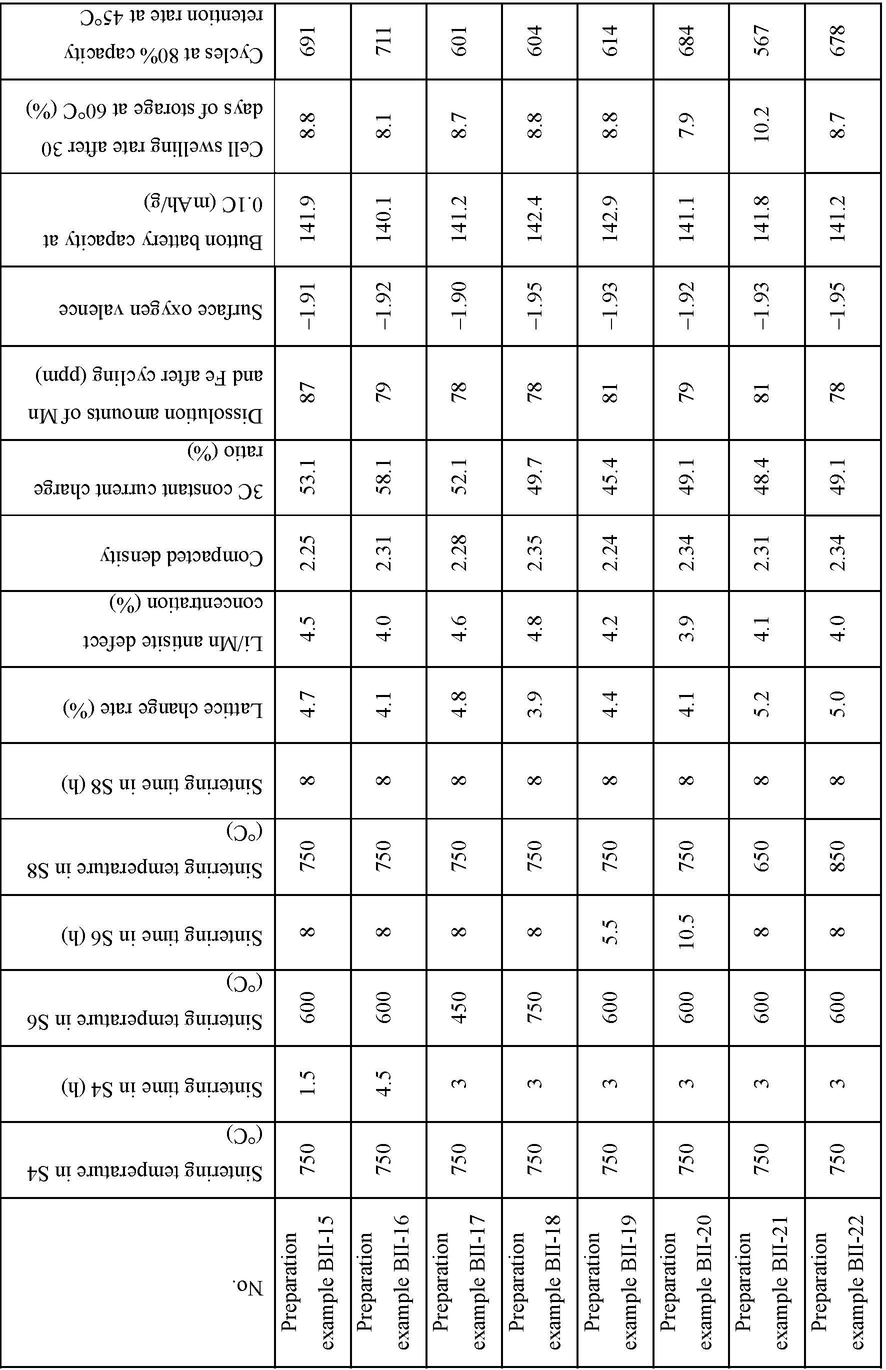

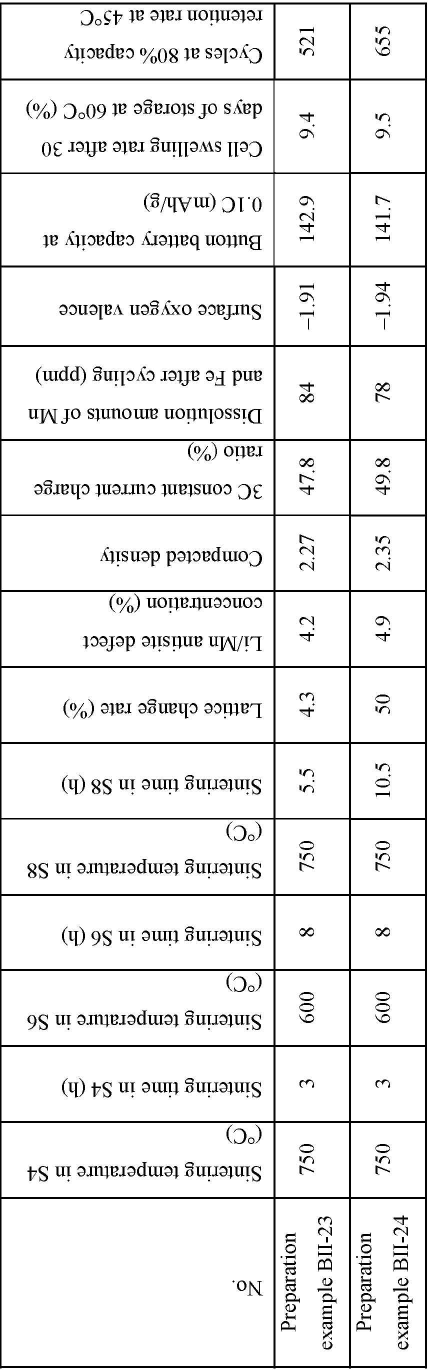

As can be seen from the above, when the sintering temperature is in the range of 650°C to 800°C and the sintering time is 2 hours to 6 hours in step S4, when the sintering temperature is in the range of 500°C to 700°C and the sintering time is 6 hours to 10 hours in step S6, and when the sintering temperature is in the range of 700°C to 800°C and the sintering time is 6 hours to 10 hours in step S8, smaller lattice change rate, smaller Li/Mn antisite defect concentration, less amount of dissolved elements manganese and iron, better 3C constant current charge ratio, larger battery capacity, better battery cycling performance, and better high-temperature storage stability can be achieved.

In addition, compared with comparative preparation example BII-4 (the sintering temperature was 750°C and sintering time was 4.5 h in step S4), preparation example BII-1 (the sintering temperature was 750°C and the sintering time was 4 h in step S4) has achieved better performance of positive electrode active material and battery performance, which indicates that when the sintering temperature is 750°C or greater than 750°C in step S4, the sintering time needs to be controlled to be less than 4.5 hours.

### Examination of influence of reaction temperature and reaction time during preparation of core on performance of second positive electrode active material

The second positive electrode active materials and battery preparation in the preparation examples and comparative preparation examples in the following table are the same as those in preparation example B1 except for the differences in the preparation of the second positive electrode active materials with reference to the method parameters in the following table. The results are also given in the following table.

**Table 17 Influence of reaction temperature and reaction time during preparation of core on performance of positive electrode active material**

| No. | Step S1 | | Step S2 | | Lattic e chang e rate (%) | Li/Mn antisite defect concentrati on (%) | Compact ed density (g/cm³) | 3C consta nt curren t charge ratio (%) | Dissoluti on amounts of Mn and Fe after cycling (ppm) | Surfac e oxyge n valenc e | Button cell capaci ty at 0.1C (mAh/ g) | Cell swellin g rate after 30 days of storage at 60°C (%) | Cycles at 80% capacit y retentio n rate at 45°C |
|---|---|---|---|---|---|---|---|---|---|---|---|---|---|
| | Reaction temperat ure (°C) | Reactin g time (h) | Reaction temperat ure (°C) | Reactin g time (h) | | | | | | | | | |
| Preparation example B1 | 80 | 6 | 80 | 10 | 2.5 | 1.8 | 2.35 | 70.3 | 7 | -1.93 | 157.2 | 4.2 | 1128 |
| Preparation example BIII-1 | 70 | 6 | 80 | 10 | 2.8 | 3.4 | 2.30 | 60.1 | 34 | -1.93 | 155.4 | 5.8 | 876 |
| Preparation example BIII-2 | 60 | 6 | 80 | 10 | 3.1 | 3.1 | 2.33 | 64.2 | 18 | -1.92 | 156.2 | 5.1 | 997 |
| Preparation example BIII-4 | 100 | 6 | 80 | 10 | 2.3 | 2.4 | 2.37 | 71.3 | 7 | -1.94 | 156.8 | 4.1 | 1137 |
| Preparation example BIII-5 | 120 | 6 | 80 | 10 | 2.1 | 2.2 | 2.38 | 72.1 | 5 | -1.92 | 155.4 | 4.0 | 1158 |
| Preparation example BIII-6 | 80 | 2 | 80 | 10 | 2.8 | 3.2 | 2.27 | 68.4 | 24 | -1.90 | 154.9 | 5.1 | 895 |
| Preparation example BIII-7 | 80 | 3 | 80 | 10 | 2.6 | 2.7 | 2.29 | 69.7 | 17 | -1.92 | 156.1 | 4.7 | 967 |
| Preparation example BIII-8 | 80 | 5 | 80 | 10 | 2.4 | 1.9 | 2.34 | 70.6 | 8 | -1.94 | 156.8 | 4.3 | 1137 |
| Preparation example BIII-9 | 80 | 7 | 80 | 10 | 2.5 | 1.8 | 2.35 | 68.3 | 11 | -1.94 | 156.4 | 4.8 | 987 |
| Preparation example BIII-10 | 80 | 9 | 80 | 10 | 2.6 | 1.8 | 2.36 | 67.2 | 15 | -1.93 | 155.9 | 5.2 | 921 |
| Preparation example BIII-11 | 80 | 6 | 40 | 10 | 3.2 | 3.4 | 2.28 | 67.8 | 35 | -1.94 | 156.8 | 5.4 | 894 |
| Preparation example BIII-12 | 80 | 6 | 60 | 10 | 2.8 | 2.9 | 2.31 | 68.7 | 18 | -1.95 | 157.0 | 4.9 | 927 |
| Preparation example BIII-13 | 80 | 6 | 80 | 10 | 2.5 | 2.7 | 2.35 | 70.3 | 7 | -1.93 | 157.2 | 4.2 | 1128 |
| Preparation example BIII-14 | 80 | 6 | 100 | 10 | 2.7 | 2.8 | 2.33 | 69.4 | 15 | -1.93 | 156.7 | 4.6 | 957 |
| Preparation example BIII-15 | 80 | 6 | 120 | 10 | 2.8 | 3.1 | 2.32 | 68.1 | 24 | -1.94 | 156.2 | 4.8 | 914 |
| Preparation example BIII-16 | 80 | 6 | 90 | 1 | 3.7 | 3.8 | 2.26 | 67.9 | 38 | -1.93 | 155.8 | 5.2 | 885 |
| Preparation example BIII-17 | 80 | 6 | 90 | 3 | 3.4 | 3.4 | 2.31 | 68.2 | 32 | -1.94 | 156.1 | 4.8 | 915 |
| Preparation example BIII-18 | 80 | 6 | 90 | 5 | 3.1 | 3.1 | 2.33 | 69.1 | 27 | -1.92 | 156.4 | 4.6 | 934 |
| Preparation example BIII-19 | 80 | 6 | 90 | 7 | 2.8 | 2.9 | 2.34 | 69.4 | 15 | -1.93 | 156.8 | 4.5 | 971 |
| Preparation example BIII-20 | 80 | 6 | 90 | 9 | 2.5 | 2.7 | 2.35 | 70.3 | 7 | -1.93 | 157.2 | 4.2 | 1128 |

As can be seen from Table 17, when the reaction temperature is in the range of 60°C to 120°C and the reaction time is 2 hours to 9 hours in step S1 and the reaction temperature is in the range of 40°C to 120°C and the reaction time was 1 hour to 10 hours in step S2, the second positive electrode active material powder has excellent performance (lattice change rate, Li/Mn antisite defect concentration, surface oxygen valence, and compacted density) and the prepared battery also has excellent performance (electric capacity, high-temperature cycling performance, and high-temperature storage performance).

**Table 18 Test result of mixed positive electrode active material**

| No. | First positive electrode active material | Second positive electrode active material | Cycles at 80% capacity retention rate at 45°C | Hot box test |
|---|---|---|---|---|
| Example 1 | Preparation example Al | Preparation example B25 | 1202 | 16 min @183°C |
| Example 2 | Preparation example A2 | Preparation example B25 | 1224 | 2 min @181°C |
| Example 3 | Preparation example A3 | Preparation example B25 | 1236 | 15 min @185°C |
| Example 4 | Preparation example A4 | Preparation example B25 | 1121 | 2 min @191°C |
| Example 5 | Preparation example A5 | Preparation example B25 | 1264 | 23 min @181°C |
| Example 6 | Preparation example A6 | Preparation example B25 | 739 | 28 min @182°C |
| Example 7 | Preparation example A7 | Preparation example B25 | 1384 | 13 min @185°C |
| Example 8 | Preparation example A8 | Preparation example B25 | 697 | 19 min @173°C |
| Example 9 | Preparation example A9 | Preparation example B25 | 680 | 17 min @190°C |
| Example 10 | Preparation example A10 | Preparation example B25 | 884 | 8 min @143°C |
| Example 11 | Preparation example All | Preparation example B25 | 717 | 3 min @140°C |
| Example 12 | Preparation example A12 | Preparation example B25 | 811 | 9min @190°C |
| Example 13 | Preparation example A13 | Preparation example B25 | 916 | 25min @182°C |
| Example 14 | Preparation example A14 | Preparation example B25 | 1419 | 26 min @170°C |
| Example 15 | Preparation example A15 | Preparation example B25 | 1677 | 11 min @175°C |
| Example 16 | Preparation example A16 | Preparation example B25 | 1321 | 17 min @145°C |
| Example 17 | Preparation example A17 | Preparation example B25 | 1044 | 21 min @142°C |
| Example 18 | Preparation example A18 | Preparation example B25 | 950 | 15 min @141°C |
| Example 19 | Preparation example A19 | Preparation example B25 | 1384 | 15 min @144°C |
| Example 20 | Preparation example A20 | Preparation example B25 | 900 | 13 min @145°C |
| Example 21 | Preparation example A21 | Preparation example B25 | 704 | 19 min @142°C |
| Example 22 | Preparation example A22 | Preparation example B25 | 861 | 22min @145°C |
| Example 23 | Preparation example A16 | Preparation example B25 | 1276 | 30 min @200°C |
| Example 24 | Preparation example A16 | Preparation example B25 | 1291 | 30 min @200°C |
| Example 25 | Preparation example A16 | Preparation example B25 | 1305 | 15 min @180°C |
| Example 26 | Preparation example A16 | Preparation example B25 | 1319 | 8 min @162°C |
| Example 27 | Preparation example A16 | Preparation example B25 | 1334 | 27 min @138°C |
| Example 28 | Preparation example A16 | Preparation example B25 | 1263 | 30 min @200°C |
| Example 29 | Preparation example A16 | Preparation example B25 | 1269 | 17 min @133°C |
| Example 30 | Preparation example A15 | Preparation example B26 | 1369 | 27 min @175°C |
| Example 31 | Preparation example A15 | Preparation example B27 | 1434 | 24 min @175°C |
| Example 32 | Preparation example A15 | Preparation example B28 | 1351 | 24 min @173°C |
| Example 33 | Preparation example A15 | Preparation example B15 | 1424 | 19 min @175°C |
| Example 34 | Preparation example A15 | Preparation example B34 | 1362 | 25 min @175°C |
| Example 35 | Preparation example A15 | Preparation example B4 | 1599 | 27 min @173°C |
| Example 36 | Preparation example A15 | Preparation example B7 | 1741 | 27 min @175°C |
| Example 37 | Preparation example A15 | Preparation example B8 | 1393 | 22 min @172°C |
| Example 38 | Preparation example A15 | Preparation example B31 | 1411 | 25 min @172°C |
| Example 39 | Preparation example A15 | Preparation example B40 | 1354 | 28 min @172°C |
| Example 40 | Preparation example A15 | Preparation example B42 | 1450 | 21 min @174°C |
| Example 41 | Preparation example A15 | Preparation example BIII-13 | 1435 | 25 min @176°C |
| Example 42 | Preparation example A15 | Preparation example BIII-16 | 1152 | 15 min @177°C |
| Example 43 | Preparation example A15 | Preparation example B43 | 1399 | 28 min @171°C |
| Example 44 | Preparation example A15 | Preparation example B44 | 971 | 23 min @172°C |
| Example 45 | Preparation example A15 | Preparation example B45 | 833 | 25 min @174°C |
| Example 46 | Preparation example A15 | Preparation example B46 | 1733 | 21 min @174°C |
| Example 47 | Preparation example A15 | Preparation example B47 | 1422 | 22 min @173°C |
| Example 48 | Preparation example A15 | Preparation example B48 | 1767 | 25 min @175°C |
| Example 49 | Preparation example A15 | Preparation example B52 | 1636 | 21 min @177°C |
| Comparative Example 1 | Comparative preparation example Al | Preparation example B25 | 625 | 23 min @182°C |

Based on Table 18:
it can be learned from comparison between examples 1 to 49 and comparative example 1 that compared with the secondary battery prepared by mixing the first positive electrode active material and second positive electrode active material not doped with element M in comparative example 1, the second battery prepared using the mixed positive electrode active material of this application has higher cycling capacity retention rate and longer cycle life.

It can be learned from comparison between example 16 and examples 23 to 29 that when the first positive electrode active material and second positive electrode active material of this application meet the mass relation that m₁/(m₁+m₂) is 3% to 50%, the secondary battery prepared has further increased cycling capacity retention rate and further prolonged cycle life.

When g×m₁/(m₁+m₂) of the first positive electrode active material and second positive electrode active material of this application is less than or equal to 0.457, the secondary battery prepared has a high cycling capacity retention rate, long cycle life, and high safety. It can be learned from comparison between example 16 and examples 23 to 29 that when the first positive electrode active material and second positive electrode active material of this application meet the mass relation that g×m₁/(m₁+m₂) is in the range of 0.025 to 0.415, the secondary battery prepared has further increased cycling capacity retention rate and further prolonged cycle life.

It can be learned from comparison between examples 1 to 10 and 22 that when the first positive electrode active material is single crystal like, the secondary battery prepared using the first positive electrode active material with a particle size Dᵥ50 less than or equal to 5.8 µm exhibits a high cycling capacity retention rate, long cycle life, and high safety; and that when the particle size Dᵥ50 of the first positive electrode active material is less than or equal to 4.3 µm, the secondary battery prepared exhibits higher cycling capacity retention rate and longer cycle life.

It can be learned from comparison between examples 12 to 20 that when the first positive electrode active material is polycrystal, if the first positive electrode active material has a particle size Dᵥ50 of 3.5 µm to 13.5 µm, a BET specific surface area less than or equal to 1.32 m²/g, and a compacted density under a pressure of 3T greater than or equal to 2.92 g/cm³, the secondary battery prepared exhibits higher cycling capacity retention rate and longer cycle life.

It can be learned from comparison between examples 1 to 8, 10, 11, and 22 that when the first positive electrode active material is single crystal like, if d in the first positive electrode active material LiNi_{b}Co_{d}MnₑM_{f}O₂ is selected from 0.047 to 0.235, the secondary battery prepared exhibits higher cycling capacity retention rate and longer cycle life.

If b in the first positive electrode active material LiNi_{b}Co_{d}MnₑM_{f}O₂ of this application is selected from the range of 0.314 to 0.970, the secondary battery prepared exhibits high cycling capacity retention rate, long cycle life, and high safety. It can be learned from comparison between examples 1 to 7, 9 to 11, and 22 that when the first positive electrode active material is a single crystal or quasi-single crystal material, if b is greater than 0.314 and less than 0.97 (excluding the values of 0.314 and 0.97), the secondary battery prepared exhibits higher cycling capacity retention rate and longer cycle life.

It can be learned from comparison between examples 10 and 22 that the secondary battery prepared using the first positive electrode active material with a lithium carbonate mass percentage of less than or equal to 1% and a lithium hydroxide mass percentage of less than or equal to 1% exhibits higher cycling capacity retention rate and longer cycle life.

It can be learned from comparison between Table 11 and Table 18 that
compared with the secondary battery prepared using the first positive electrode active material, the secondary battery prepared using the mixed positive electrode active material containing the corresponding first positive electrode active material in this application exhibits higher safety; and that compared with the secondary batteries prepared using the first positive electrode active materials in preparation examples A5, A14 to A17, and A19 to A21, the secondary battery prepared using the mixed positive electrode active material containing the corresponding first positive electrode active material in this application exhibits higher cycling capacity retention rate and longer cycle life.

It can be learned from comparison between Tables 12 to 17 and Table 18 that
compared with the secondary batteries prepared using the second positive electrode active materials in preparation examples B26 to B28, B15, B34, B4, B7, B8, B31, B40, B42, BIII-13, and B43, preparation examples B46 to B48, and preparation example B52, the secondary battery prepared using the mixed positive electrode active material containing the corresponding second positive electrode active material in this application exhibits higher cycling capacity retention rate and longer cycle life.

It should be noted that this application is not limited to the foregoing embodiments. The foregoing embodiments are merely examples, and embodiments having substantially the same constructions and the same effects as the technical idea within the scope of the technical solutions of this application are all included in the technical scope of this application. In addition, without departing from the essence of this application, various modifications made to the embodiments that can be conceived by persons skilled in the art, and other manners constructed by combining some of the constituent elements in the embodiments are also included in the scope of this application.

## Claims

1. A positive electrode active material, containing a first positive electrode active material and a second positive electrode active material; wherein
the first positive electrode active material contains a compound LiNi_{g}Co_{d}MnₑM'_{f}O₂, wherein g is selected from a range of 0.314 to 0.970, d is selected from a range of 0 to 0.320, optionally from a range of 0.047 to 0.320, e is selected from a range of 0.006 to 0.390, a sum of g, d, e, and f is 1 and f is greater than 0, and M' is one or more elements selected from Mn, Al, Mg, Ca, Na, Ti, W, Zr, Sr, Cr, Zn, Ba, B, S, and Y, and optionally, M' is Mg and/or Al; and
the second positive electrode active material comprises a core and a shell enveloping the core, the shell comprising a first coating layer enveloping the core, a second coating layer enveloping the first coating layer, and a third coating layer enveloping the second coating layer; wherein the core contains a compound Li₁₊ₓMn_{1-y}A_{y}P_{1-z}R_{z}O₄, the first coating layer contains a crystalline pyrophosphate LiₐMP₂O₇ and/or Mₑ(P₂O₇)_{c}, the second coating layer contains a crystalline phosphate XₙPO₄, and the third coating layer contains carbon, wherein x is selected from a range of -0.100 to 0.100, y is selected from a range of 0.001 to 0.909, optionally from a range of 0.001 to 0.600, z is selected from a range of 0.001 to 0.100, a is greater than 0 and less than or equal to 2, b is greater than 0 and less than or equal to 4, c is greater than 0 and less than or equal to 3, n is greater than 0 and less than or equal to 3, A is one or more elements selected from Zn, Al, Na, K, Mg, Mo, W, Ti, V, Zr, Fe, Ni, Co, Ga, Sn, Sb, Nb, and Ge, optionally one or more elements from Fe, V, Ni, and Co, R is one or more elements selected from B, Si, N, and S, optionally one or more elements selected from Si, N, and S, each M in the crystalline pyrophosphates LiₐMP₂O₇ and M_{b}(P₂O₇)_{c} is independently one or more elements selected from Fe, Ni, Mg, Co, Cu, Zn, Ti, Ag, Zr, Nb, and Al, optionally one or more elements selected from Fe, Co, Ti, and Al, and X is one or more elements selected from Li, Fe, Ni, Mg, Co, Cu, Zn, Ti, Ag, Zr, Nb, and Al, optionally one or more elements selected from Li, Fe, Ag, and Al.

2. The positive electrode active material according to claim 1, wherein mass of the first positive electrode active material is m₁, mass of the second positive electrode active material is m₂, and a value of m₁/(m₁+m₂) is 2% to 55%, optionally 3% to 50%.

3. The positive electrode active material according to claim 1 or 2, wherein a value of g×m₁/(m₁+m₂) is 0.017 to 0.457, optionally 0.025 to 0.415.

4. The positive electrode active material according to any one of claims 1 to 3, wherein the first positive electrode active material is a single crystal or quasi-single crystal material, and a particle size Dᵥ50 of the first positive electrode active material is less than or equal to 5.8 µm, optionally from 2.3 µm to 5.8 µm, and more optionally from 2.3 µm to 4.3 µm.

5. The positive electrode active material according to any one of claims 1 to 4, wherein when the first positive electrode active material is a single crystal or quasi-single crystal material,
d is selected from a range of 0.047 to 0.320, optionally from a range of 0.05 to 0.235; and/or
b is greater than 0.314 and less than 0.97, optionally selected from a range of 0.55 to 0.869.

6. The positive electrode active material according to any one of claims 1 to 5, wherein when the first positive electrode active material is a polycrystal material, and a particle size Dᵥ50 of the first positive electrode active material is 3.0 µm to 13.5 µm, optionally 3.5 µm to 13.5 µm;
a BET specific surface area of the first positive electrode active material is less than or equal to 1.73 m²/g, optionally less than or equal to 1.32 m²/g, and more optionally from 0.28 m²/g to 1.32 m²/g; and/or
a compacted density under pressure of 3T of the first positive electrode active material is greater than or equal to 2.90 g/cm³, optionally greater than or equal to 2.92 g/cm³, and more optionally from 2.92 g/cm³ to 3.31 g/cm³.

7. The positive electrode active material according to any one of claims 1 to 6, wherein the first positive electrode active material further contains lithium carbonate and/or lithium hydroxide; and
optionally, based on mass of the first positive electrode active material, a mass percentage of the lithium carbonate is less than or equal to 1.05%, optionally less than or equal to 1%, and/or a mass percentage of the lithium hydroxide is less than or equal to 1.02%, optionally less than or equal to 1%.

8. The positive electrode active material according to any one of claims 1 to 7, wherein a ratio of y to 1-y in the core is 1:10 to 10:1, optionally 1:4 to 1:1.

9. The positive electrode active material according to any one of claims 1 to 8, wherein a ratio of z to 1-z in the core is 1:999 to 1:9, optionally 1:499 to 1:249.

10. The positive electrode active material according to any one of claims 1 to 9, wherein carbon in the third coating layer is a mixture of SP2 carbon and SP3 carbon; and
optionally, a molar ratio of SP2 carbon to SP3 carbon is 0.1 to 10, and more optionally 2.0 to 3.0.

11. The positive electrode active material according to any one of claims 1 to 10, wherein based on weight of the core, an application amount of the first coating layer is greater than 0 and less than or equal to 6wt%, optionally greater than 0 and less than or equal to 5.5wt%, and more optionally greater than 0 and less than or equal to 2wt%;
based on the weight of the core, an application amount of the second coating layer is greater than 0 and less than or equal to 6wt%, optionally greater than 0 and less than or equal to 5.5wt%, and more optionally from 2wt% to 4wt%; and/or
based on the weight of the core, an application amount of the third coating layer is greater than 0 and less than or equal to 6wt%, optionally greater than 0 and less than or equal to 5.5wt%, and more optionally greater than 0 and less than or equal to 2wt%.

12. The positive electrode active material according to any one of claims 1 to 11, wherein thickness of the first coating layer is 2 nm to 10 nm; and/or
thickness of the second coating layer is 2 nm to 15 nm, optionally 2.5 nm to 7.5 nm; and/or
thickness of the third coating layer is 5 nm to 25 nm.

13. The positive electrode active material according to any one of claims 1 to 12, wherein in the second positive electrode active material, the crystalline pyrophosphate in the first coating layer has an interplanar spacing in a range of 0.293 nm to 0.470 nm, optionally 0.303 nm to 0.462 nm, and an included angle in a range of 18.00° to 32.00°, optionally 19.211° to 30.846°, in the [111] crystal orientation; and/or
the crystalline phosphate in the second coating layer has an interplanar spacing in a range of 0.244 nm to 0.425 nm and an included angle in a range of 20.00° to 37.00°, optionally 20.885° to 36.808°, in the [111] crystal orientation.

14. The positive electrode active material according to any one of claims 1 to 13, wherein based on weight of the second positive electrode active material, a percentage of element manganese is in a range of 10wt% to 35wt%, optionally in a range of 15wt% to 30wt%, and more optionally in a range of 17wt% to 20wt%;
a percentage of element phosphorus is in a range of 12wt% to 25wt%, optionally in a range of 15wt% to 20wt%; and/or
a weight ratio of element manganese to element phosphorus is in a range of 0.90 to 1.25, optionally 0.95 to 1.20.

15. The positive electrode active material according to any one of claims 1 to 14, wherein a lattice change rate of the second positive electrode active material before and after complete deintercalation or intercalation of lithium is below 4%, optionally below 3.8%, and more optionally from 2.0% to 3.8%.

16. The positive electrode active material according to any one of claims 1 to 15, wherein
a Li/Mn antisite defect concentration of the second positive electrode active material is below 4%, optionally below 2.2%, and more optionally from 1.5% to 2.2%.

17. The positive electrode active material according to any one of claims 1 to 16, wherein
a compacted density under 3T of the second positive electrode active material is above 2.2 g/cm³, optionally above 2.2 g/cm³ and below 2.8 g/cm³.

18. The positive electrode active material according to any one of claims 1 to 17, wherein
a surface oxygen valence of the second positive electrode active material is below -1.90, optionally from -1.90 to -1.98.

19. A preparation method of positive electrode active material, comprising the following steps:
providing a first positive electrode active material and a second positive electrode active material; and
mixing the first positive electrode active material and the second positive electrode active material; wherein
the first positive electrode active material contains a compound LiNi_{g}Co_{d}MnₑM'_{f}O₂, and the second positive electrode active material comprises a core and a shell enveloping the core, the shell comprising a first coating layer enveloping the core, a second coating layer enveloping the first coating layer, and a third coating layer enveloping the second coating layer; wherein the core contains a compound Li₁₊ₓMn_{1-y}A_{y}P_{1-z}R_{z}O₄, the first coating layer contains a crystalline pyrophosphate LiₐMP₂O₇ and/or M_{b}(P₂O₇)_{c}, the second coating layer contains a crystalline phosphate XₙPO₄, and the third coating layer contains carbon; and g, d, e, f, x, y, z, a, b, c, n, A, R, M, X, and M' are defined as in any one of claims 1 to 18; and
optionally, the first positive electrode active material further contains lithium carbonate and/or lithium hydroxide.

20. A positive electrode plate, comprising a positive electrode current collector and a positive electrode film layer provided on at least one surface of the positive electrode current collector, wherein the positive electrode film layer comprises the positive electrode active material according to any one of claims 1 to 18 or a positive electrode active material prepared in the method according to claim 19; and optionally, based on total weight of the positive electrode film layer, a percentage of the positive electrode active material in the positive electrode film layer is above 10wt%, more optionally from 95wt% to 99.5wt%.

21. A secondary battery, comprising the positive electrode active material according to any one of claims 1 to 18 or a positive electrode active material prepared in the method according to claim 19 or the positive electrode plate according to claim 20.

22. A battery module, comprising the secondary battery according to claim 21.

23. A battery pack, comprising the battery module according to claim 22.

24. An electric apparatus, comprising at least one of the secondary battery according to claim 21, the battery module according to claim 22, and the battery pack according to claim 23.
